# EUROPEAN PATENT APPLICATION

(11) **EP 4 852 000 A1**
(43) Date of publication of application: **09.12.2026**
(21) Application number: 26179844.1
(22) Date of filing: 20.05.2026
(51) Int. Cl.: G11C 11/4091, G11C 7/06, G11C 7/12, G11C 11/4094

(54) **MEMORY DEVICE AND METHOD OF OPERATING THE SAME**

(30) Priority: 02.06.2025 KR 20250072467; 02.06.2025 KR 20250072468
(71) Applicant: Samsung Electronics Co., Ltd., Suwon-si, Gyeonggi-do 16677 (KR)
(72) Inventor: LEE, Changyoung, Suwon-si (KR); YOO, Changsik, Suwon-si (KR); PARK, Young Seok, Suwon-si (KR); SEO, Younghun, Suwon-si (KR)
(74) Representative: Marks & Clerk LLP

(57) **Abstract**

A memory device includes a first sub-memory array and a bit line sense amplifier. The first sub-memory array includes a first memory cell connected to a first bit line and a first word line and configured to store data. The bit line sense amplifier includes a sense amplifier circuit electrically connected through the first bit line and the sensing node and configured to sense the data based on a voltage at the sensing node. The bit line sense amplifier also includes a first charge pump circuit configured to charge a first charge through charge sharing between the first bit line and the first memory cell and pump a voltage at the sensing node based on the first charge.

## Description

### BACKGROUND

### (a) Field

The present disclosure relates to a memory device and a method of operating the memory device.

### (b) Description of the Related Art

Memory devices are used to store data. In particular, RAM (Random Access Memory) is a volatile memory device that is mainly used as the main memory device of a computer, and DRAM (Dynamic Random Access Memory) is a type of RAM that is volatile and contains memory cells.

With the recent development of the electronics industry, the demand for miniaturization, high functionality, and high speed of electronic components is increasing. Accordingly, in order to improve the integration of memory devices, the trend is to reduce the area of the memory cell area and the peripheral circuit area for driving the memory cell, and to scale the circuit elements of the memory device.

In order to efficiently sense data stored in memory cells, the bit line is precharged with a precharge voltage, and then a charge sharing operation is performed on the memory cell, and a voltage fluctuation occurs in the bit line through the charge sharing.

The sense amplifier senses data stored in memory cells by performing an amplification operation based on voltage fluctuations in the bit line. However, as the circuit elements are scaled, various noise components in the operation of the memory device, such as offsets due to the process dispersion of the elements, are strengthened, which reduces the sensing margin for voltage fluctuations of the bit line in the sensing operation and deteriorates the reliability of the sensing operation.

### SUMMARY

Some embodiments provide an integrated memory device and a method of operating the memory device while ensuring a sensing margin and improving the reliability of the sensing operation.

Some embodiments provide a memory device and a method of operating the memory device including a bit line sense amplifier with improved area efficiency.

Some embodiments provide a memory device and a method of operating the memory device including a bit line sense amplifier that is robust to interconnection coupling in a dense wiring environment.

According to a disclosed embodiment, a memory device including a first sub-memory array including a first memory cell connected to a first bit line and a first word line and configured to store data, and a bit line sense amplifier including a sense amplifier circuit electrically connected to the first bit line through a sensing node and configured to sense the data based on a voltage at the sensing node, and a first charge pump circuit configured to charge a first charge through charge sharing between the first bit line and the first memory cell and pump a voltage at the sensing node based on the first charge, may be provided.

According to a disclosed embodiment, a memory device including a first sub-memory array including a first memory cell connected to a first bit line and a first word line and configured to store data and a bit line sense amplifier including a sense amplifier circuit electrically connected through the first bit line and the sensing node and configured to sense the data based on the voltage at the sensing node, and a pump capacitor including a first electrode electrically connected to the sensing node and a second electrode electrically connected to the first bit line through a first node different from the sensing node may be provided.

According to a disclosed embodiment, a method of operating a memory device including activating a word line included in a sub-memory array to perform a charge sharing operation between a bit line of the sub-memory array and a memory cell, providing a charge sharing voltage to a sensing node of a sense amplifier circuit based on the above charge sharing operation, charging a charge based on the charge sharing operation, pumping the charge sharing voltage to a sensing voltage based on the charge, and sensing data of the memory cell based on the sensing voltage may be provided.

According to a disclosed embodiment, a memory device including a memory cell region including first and second sub-memory arrays arranged sequentially in a first direction, and a local sense amplifier circuit region, which is disposed between the first sub-memory array and the second sub-memory array and at least a portion of which overlaps in a plane with the first and second sub-memory arrays, including a sense amplifier circuit connected to a first bit line of the first sub-memory array through a sensing node and a pump capacitor including a first electrode electrically connected to the sensing node and a second electrode electrically connected to the first bit line through a first node different from the sensing node may be provided.

According to a disclosed embodiment, a memory device including a first sub-memory array including a first memory cell connected to a first bit line and a first word line and configured to store data, a second sub-memory array including a second memory cell connected to a second bit line and a second word line, and a bit line sense amplifier including a sense amplifier circuit connected to the first bit line through the sensing node, connected to the second bit line through a complementary sensing node different from the sensing node, and configured to sense the data based on voltages at the sensing node and the complementary sensing node, and a first charge pump circuit configured to charge a first charge through a first charge sharing operation between the first bit line and the first memory cell and pump a voltage at the sensing node based on the first charge may be provided.

According to a disclosed embodiment, a memory device including a first sub-memory array including a first memory cell connected to a first bit line and a first word line and configured to store data, a second sub-memory array including a second memory cell connected to a second bit line and a second word line, and a bit line sense amplifier including a sense amplifier circuit connected to the first bit line through the sensing node, connected to the second bit line through a complementary sensing node different from the sensing node, and configured to sense the data based on voltages at the sensing node and the complementary sensing node, and a first pump capacitor including a first electrode electrically connected to the sensing node and a second electrode electrically connected to the first bit line through a first node different from the sensing node and the complementary sensing node may be provided.

According to a disclosed embodiment, a method of operating a memory device including providing a precharge voltage to a first bit line included in a first sub-memory array and a second bit line included in a second sub-memory array, activating a word line included in the first sub-memory array to perform a charge sharing operation between the first bit line and a memory cell connected to the word line, providing a charge sharing voltage to a sensing node of a sense amplifier circuit based on the charge sharing operation, charging a charge based on the charge sharing operation, pumping the charge sharing voltage to a sensing voltage based on the charge, and sensing data of the memory cell based on the sensing voltage and the precharge voltage may be provided.

At least some of the above and other features of the invention are set out in the claims.

### BRIEF DESCRIPTION OF THE DRAWINGS

FIG. 1 is a block diagram illustrating a memory system according to some embodiments.
FIG. 2 is a block diagram illustrating a memory device according to some embodiments.
FIG. 3 is a perspective view illustrating a memory device according to some embodiments.
FIG. 4 is a plan view illustrating a bank array according to some embodiments.
FIG. 5 is a plan view illustrating a sub-memory array and peripheral circuitry for driving the sub-memory array according to some embodiments.
FIG. 6 is a block diagram illustrating configurations arranged in a sub-word line driver region and a local sense amplifier circuit region according to some embodiments.
FIG. 7 is a block diagram illustrating a bit line sense amplifier according to some embodiments.
FIG. 8 is a circuit diagram illustrating a bit line sense amplifier according to some embodiments.
FIG. 9 is a cross-sectional view taken along lines C to C' of an example memory device of FIG. 3.
FIG. 10 is an enlarged view of the AA area of FIG. 9.
FIG. 11 is a flowchart illustrating a method of operating a memory device according to some embodiments.
FIG. 12 is a timing diagram illustrating a method of operating a memory device according to some embodiments.
FIGS. 13 to 17 are drawings for explaining an operation method of a memory device according to some embodiments.
FIG. 18 is a circuit diagram illustrating a bit line sense amplifier according to some embodiments.
FIG. 19 is a timing diagram illustrating a method of operating a memory device according to some embodiments.
FIGS. 20 to 24 are drawings for explaining a method of operating a memory device according to some embodiments.
FIG. 25 is a circuit diagram illustrating a bit line sense amplifier according to some embodiments.
FIG. 26 is a timing diagram illustrating a method of operating a memory device according to some embodiments.
FIGS. 27 to 32 are drawings for explaining a method of operating a memory device according to some embodiments.
FIG. 33 is a block diagram illustrating a bit line sense amplifier according to some embodiments.
FIG. 34 is a circuit diagram illustrating a bit line sense amplifier according to some embodiments.
FIG. 35 is a flowchart illustrating a method of operating a memory device according to some embodiments.
FIG. 36 is a timing diagram illustrating a method of operating a memory device according to some embodiments.
FIGS. 37 to 41 are drawings for explaining a method of operating a memory device according to some embodiments.
FIG. 42 is a circuit diagram illustrating a bit line sense amplifier according to some embodiments.
FIG. 43 is a timing diagram illustrating a method of operating a memory device according to some embodiments.
FIGS. 44 to 49 are drawings for explaining a method of operating a memory device according to some embodiments.
FIG. 50 is a cross-sectional view taken along line C-C' of an example of the memory device of FIG. 3.
FIG. 51 is a block diagram illustrating a computer device according to some embodiments.

### DETAILED DESCRIPTION OF THE EMBODIMENTS

Hereinafter, various embodiments of the present invention will be described in detail with reference to the attached drawings so that a person having ordinary skill in the art to which the present invention pertains may easily practice the invention. The present invention may be implemented in many different forms and is not limited to the embodiments described herein.

In order to clearly explain the present invention, parts that are not related to the description are omitted, and the same or similar reference numerals are used for the same or similar components throughout the specification.

Additionally, throughout the specification, whenever a part is said to "include" a component, this does not mean that it excludes other components, but rather that it may include other components, unless otherwise specifically stated.

Additionally, a specific number set forth in a claim, even if explicitly recited within the claim, should not be construed as a limitation to that specific number in claims where such recitation does not exist. For example, subsequent dependent claims may include the phrases "at least one" and "one or more" to aid understanding. However, the use of such a construction should not be understood as being limited by the ambiguous article 'one', which is described for the sake of one example.

Moreover, when a convention such as 'at least one of A, B, or C' is used, such a phrase will be well understood by a person skilled in the art (i.e., 'a system comprising at least one of A, B, or C' includes, but is not limited to, A alone, B alone, C alone, A and B, A and C, B and C, and/or A, B, and C together). Alternatively, words and/or phrases in the detailed description, claims or drawings that have two or more separate, optional terms should be considered as potentially including one, either, or both terms. For example, the phrase 'A or B' should be understood to include the possibilities of 'A', or 'B', or 'A and B'.

The terms "module," "unit," "part," etc., used in this document are terms intended to refer to components that perform at least one function or operation, and such components may be implemented as hardware or software, or a combination of hardware and software.

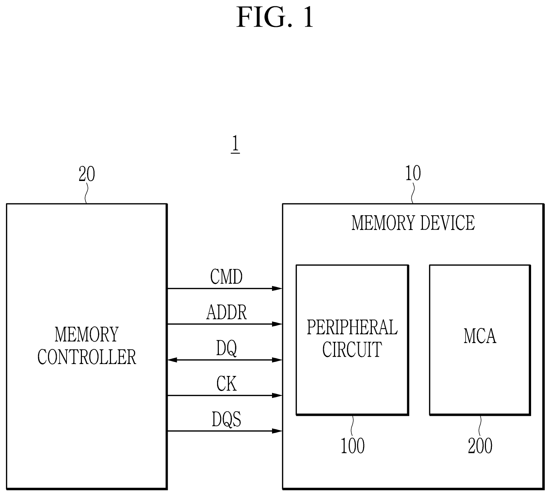

FIG. 1 is a block diagram illustrating a memory system according to some embodiments.

Referring to FIG. 1, a memory system 1 may include a memory device 10 and a memory controller 20.

The memory controller 20 may control the overall operation of the memory system 1 and controls the overall data exchange between the external host and the memory device 10. For example, the memory controller 20 may control the memory device 10 to write data or read data according to the host's request. The memory controller 20 may be at least one of a memory controller for controlling a memory device 10, a system on a chip(SoC) such as an application processor(AP), a central processing unit(CPU), a digital signal processor(DSP), and a graphics processing unit(GPU).

The memory controller 20 may perform an access operation to write data to the memory device 10 or read data stored in the memory device 10. For example, the memory controller 20 may generate a command CMD and an address ADDR to write data to the memory device 10 or read data stored in the memory device 10.

According to some embodiments, the memory controller 20 may control the overall operation of the memory device 10 by providing various signals to the memory device 10. For example, the memory controller 20 may control memory access operations of the memory device 10, such as read and write. According to an embodiment, the memory device 10 may be a DRAM, a DDR5(double data rate 5) SDRAM(synchronous DRAM), or a DDR6 SDRAM including volatile memory cells.

Additionally, the memory controller 20 may control the operation of the memory device 10 by applying operation commands for controlling the memory device 10.

The memory controller 20 may transmit a clock signal (CK, or command clock signal), a command CMD, and an address ADDR to the memory device 10. When the memory controller 20 transmits a data signal DQ to the memory device 10 or receives a data signal DQ from the memory device 10, it may exchange a data strobe signal DQS with the memory device 10. An address ADDR may be accompanied by a command CMD, and in the present disclosure, the address ADDR may be referred to as an access address.

A memory device 10 may include a peripheral circuit 100 and a memory cell array 200 that stores data. The peripheral circuit 100 may control the operation of the memory cell array 200. The memory cell array 200 may include a plurality of bank arrays, and each bank array may include a plurality of sub-memory arrays including a plurality of volatile memory cells.

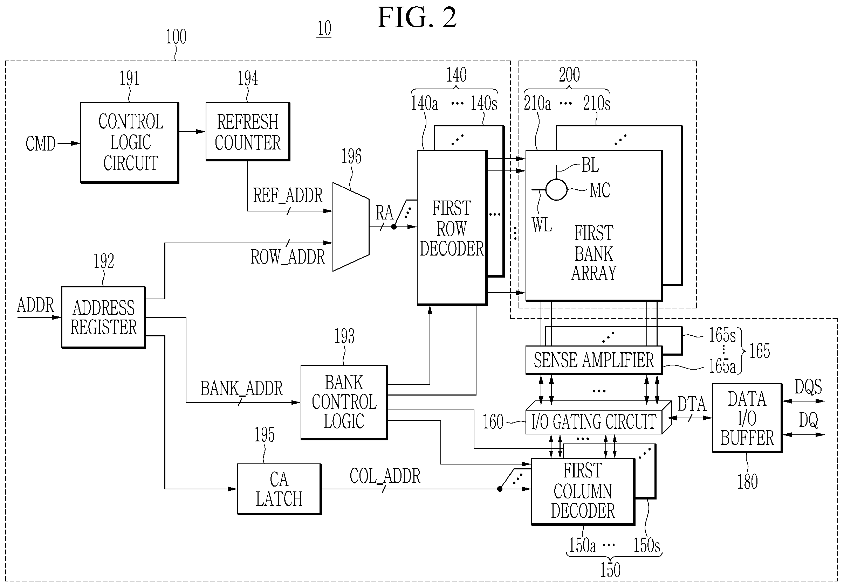

FIG. 2 is a block diagram illustrating a memory device according to some embodiments.

Referring to FIGS. 1 and 2, a memory device 10 may include a peripheral circuit 100 and a memory cell array 200. The peripheral circuit 100 may include a control logic circuit 191, an address register 192, a bank control logic 193, a refresh counter 194, a column address latch 195, a row address multiplexer 196, a row decoder 140, a column decoder 150, a sense amplifier 165, an input/output gating circuit 160, and a data input/output buffer 180.

The memory cell array 200 may include first to sixteenth bank arrays 210a to 210s. The row decoder 140 may include first to sixteenth row decoders 140a to 140s connected to the first to sixteenth bank arrays 210a to 210s, respectively, the column decoder 150 may include first to sixteenth column decoders 150a to 150s connected to the first to sixteenth bank arrays 210a to 210s, respectively, and the sense amplifier 165 may include first to sixteenth sense amplifiers 165a to 165s connected to the first to sixteenth bank arrays 210a to 210s, respectively.

The first to sixteenth bank arrays 210a to 210s, the first to sixteenth sense amplifiers 165a to 165s, the first to sixteenth column decoders 150a to 150s, and the first to sixteenth row decoders 140a to 140s may operate as the first to sixteenth banks. Each of the first to sixteenth bank arrays 210a to 210s may include a plurality of word lines WL, a plurality of bit lines BL, and a plurality of memory cells MC arranged at points where the word lines WL and the bit lines BL intersect. Although the memory device 10 in FIG. 2 is illustrated as including 16 banks, the present disclosure is not limited to the example of the number of banks.

Each of the first to sixteenth bank arrays 210a to 210s may include a plurality of memory cells MC, which are a plurality of volatile memory cells that store data. Additionally, each of the first to sixteenth bank arrays 210a to 210s may include the plurality of sub-memory arrays. According to some embodiments, the plurality of sub-memory arrays may be divided into a plurality of row blocks by row block identification bits, which are some bits of the row address. The row block may include a plurality of sub-memory arrays arranged in one direction.

The control logic circuit 191 may control the operation of the memory device 10. For example, the control logic circuit 191 may generate control signals to cause the memory device 10 to perform a write operation or a read operation. Although not illustrated, the control logic circuit 191 may include a command decoder for decoding a received command CMD and a mode register for setting the operating mode of the memory device 10. For example, the command decoder may decode a chip select signal and a command/address signal, etc., to generate the control signals corresponding to the command CMD. In particular, the command decoder may decode a command CMD and generate a control signal for controlling an input/output gating circuit 160, etc.

The address register 192 may receive an address ADDR including a bank address BANK_ADDR, a row address ROW_ADDR, and a column address COL_ADDR from the memory controller 20. The address register 192 may provide the received bank address BANK_ADDR to the bank control logic 193, the received row address ROW_ADDR to the row address multiplexer 196, and the received column address COL_ADDR to the column address latch 195.

The bank control logic 193 may generate a bank control signal in response to a bank address BANK_ADDR. In response to the above bank control signal, a row decoder corresponding to the bank address BANK_ADDR among the first to sixteenth row decoders 140a to 140s may be activated, and a column decoder corresponding to the bank address BANK_ADDR among the first to sixteenth column decoders 150a to 150s may be activated.

The row address multiplexer 196 may receive a row address ROW_ADDR from the address register 192 and a refresh row address REF_ADDR from the refresh counter 194. The row address multiplexer 196 may selectively output a row address ROW_ADDR or a refresh row address REF_ADDR as a row address RA. The row address RA output from the row address multiplexer 196 may be applied to the first to sixteenth row decoders 140a to 140s, respectively.

Among the first to sixteenth row decoders 140a to 140s, the row decoder activated by the bank control logic 193 may decode the row address RA output from the row address multiplexer 196 and activate the word line corresponding to the row address RA.

Although not illustrated, each of the first to sixteenth row decoders 140a to 140s may be electrically connected to a plurality of sub-word line driving drivers or may include a plurality of sub-word line driving drivers. For example, a row decoder may activate a sub-word line drive driver corresponding to a row address RA to apply a word line drive voltage to a word line corresponding to the row address.

The column address latch 195 may receive a column address COL_ADDR from the address register 192 and temporarily store the received column address COL_ADDR. Additionally, the column address latch 195 may incrementally increase the received column address COL_ADDR in burst mode. The column address latch 195 may apply a temporarily stored or gradually increased column address COL_ADDR to the first to sixteenth column decoders 150a to 150s, respectively.

Among the first to sixteenth column decoders 150a to 150s, the column decoder activated by the bank control logic 230 may activate the sense amplifier corresponding to the bank address BANK_ADDR and the column address COL_ADDR through the corresponding input/output gating circuit 160. For example, a column decoder activated by the bank control logic 230 may activate a bit line sense amplifier corresponding to a column address COL_ADDR through an input/output gating circuit 160.

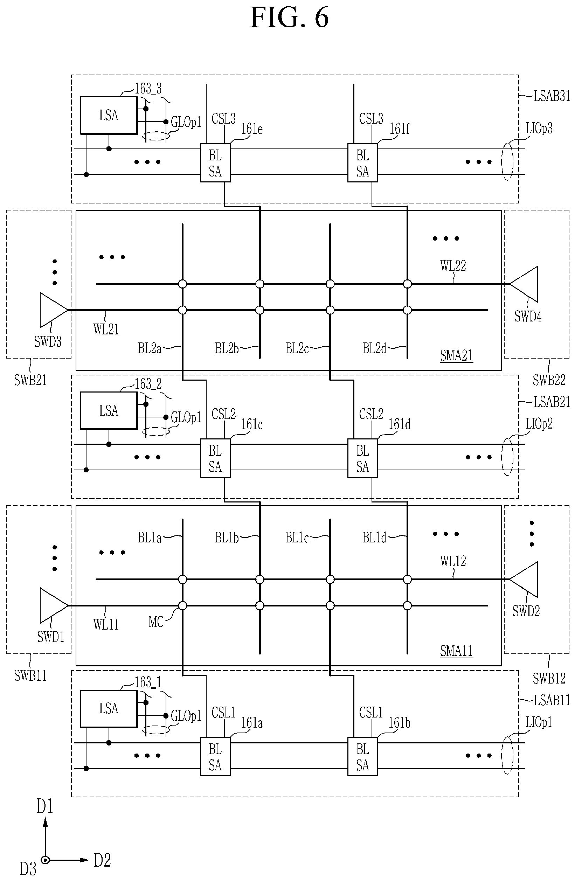

Although not illustrated, the bit line sense amplifier may include a charge pump circuit that charges through a charge sharing operation between the bit line and the memory cell, and pumps the charge sharing voltage to a sensing voltage based on the charged charge. The bit line sense amplifier may perform a sensing operation on data based on the pumped sensing voltage, thereby improving the reliability of the sensing operation. A detailed description of the bit line sense amplifier and charge pump circuit is provided later in the description of FIGS. 6 to 8.

The input/output gating circuit 160 may include circuits for gating input/output data, input data mask logic, a read data latch for storing data DTA output from the first to sixteenth bank arrays 210a to 210s, and write drivers for writing data to the first to sixteenth bank arrays 210a to 210s.

Data DTA read from one of the first to sixteenth bank arrays 210a to 210s may be sensed by a sense amplifier corresponding to the one bank array and stored in the read data latch. The data DTA stored in the above read data latch may be provided to a data input/output buffer 180, and the data input/output buffer 180 may convert the data DTA into a data signal DQ based on the data DTA and provide the data signal DQ to the memory controller 20 together with a data strobe signal DQS.

A data signal DQ to be written to one of the first to sixteenth bank arrays 210a to 210s may be received by a data input/output buffer 180 together with a data strobe signal DQS. The data input/output buffer 180 may convert a data signal DQ into data DTA and provide it to the input/output gating circuit 160. The input/output gating circuit 160 may write data DTA to a target page of the one bank array through the write drivers.

Although not illustrated, in some embodiments, the memory device 10 may further include an ECC engine. The ECC engine may receive data DTA from a data input/output buffer 180 in a write operation, perform ECC encoding, generate a codeword including data DTA and parity data (or parity bit) for the data DTA, and provide the codeword to the input/output gating circuit 160. The ECC engine may receive a codeword provided from the input/output gating circuit 160 in a read operation, perform ECC decoding, and provide data DTA to the data input/output buffer 180.

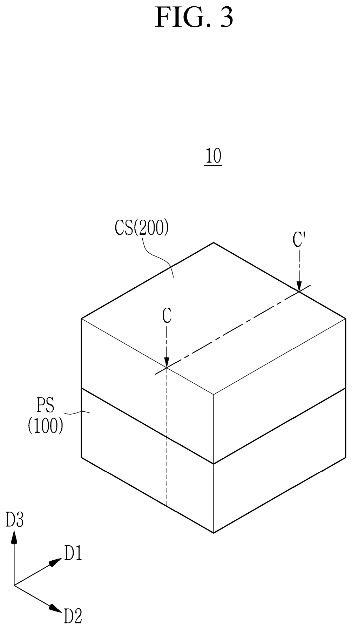

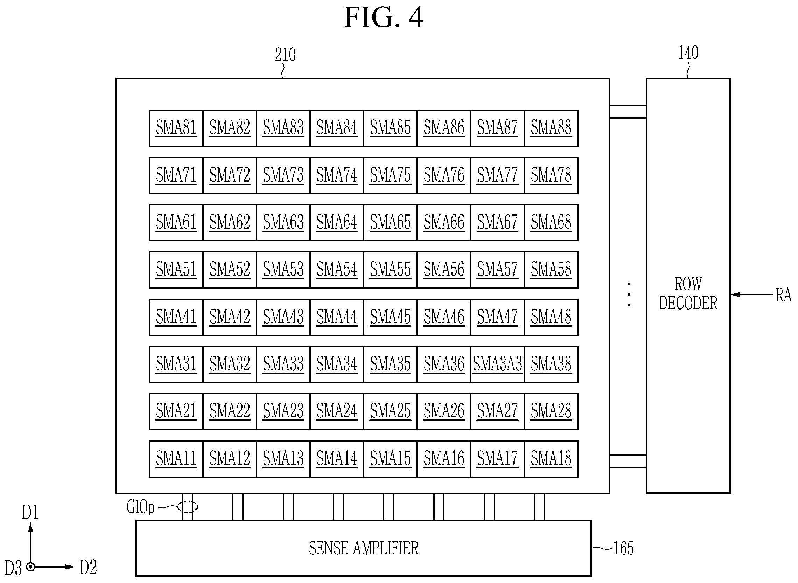

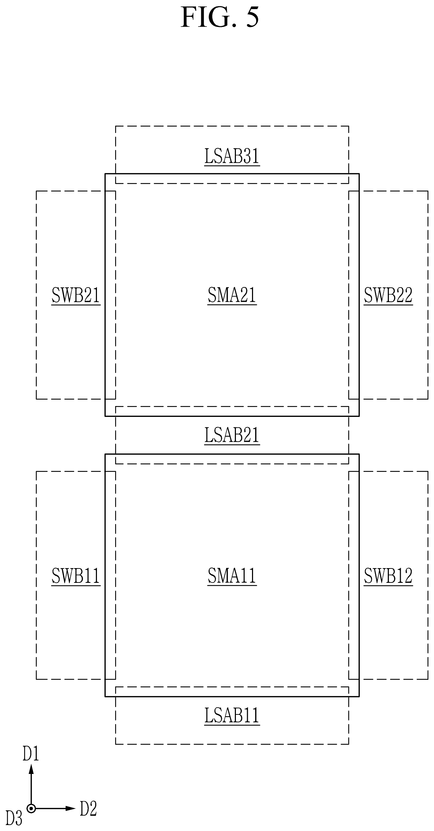

FIG. 3 is a perspective view illustrating a memory device according to some embodiments. FIG. 4 is a plan view illustrating a bank array according to some embodiments. FIG. 5 is a plan view illustrating a sub-memory array and peripheral circuitry for driving the sub-memory array according to some embodiments.

Specifically, FIG. 5 illustrates a plan view of a sub-word line driver region and a local sense amplifier circuit region in which peripheral circuits for driving the 1_1 sub-memory array SMA11 and the 1_2 sub-memory array SMA12 of FIG. 4 and the 1_1 sub-memory array SMA11 and the 1_2 sub-memory array SMA12 are arranged.

Referring to FIGS. 2 to 5, the memory device 10 may include a peripheral circuit area PS and a memory cell area CS. According to some embodiments, the memory device 10 has a COP(Cell Over Peri) structure or a POC(Peri Over Cell) structure, and the peripheral circuit area PS and the memory cell area CS may be three-dimensionally stacked in a third direction D3. The third direction D3 may be perpendicular to the substrate of the peripheral circuit area PS and the memory cell area CS. The memory cell area CS may be an area where a memory cell array 200 is disposed, and the peripheral circuit area PS may be an area where a peripheral circuit 100 that controls the operation of the memory cell array 200 is disposed.

At least a portion of the peripheral circuit area PS may overlap in a plane with the memory cell area CS along the third direction D3. According to some embodiments, the peripheral circuit area PS may include a portion of an external pad (not illustrated) or wiring(not illustrated) disposed on the memory cell area CS.

The memory cell area CS may include a memory cell array 200, and the memory cell array 200 may include first to sixteenth bank arrays 210a to 210s. The first to sixteenth bank arrays 210a to 210s may be arranged so as to be non-overlapping each other in a plane along the third direction D3. According to some embodiments, the first to sixteenth bank arrays 210a to 210s may be arranged on the same substrate. The bank array 210 of FIG. 4 is one of the first to sixteenth bank arrays 210a to 210s, and for ease of explanation, the components and arrangement of the components within the memory device 10 are described below based on the bank array 210. It is obvious that the description of the bank array 210 may be applied in the same or similar manner to the first to sixteenth bank arrays 210a to 210s.

The bank array 210 may include a plurality of sub-memory arrays SMA11 to SMA88. Multiple sub-memory arrays SMA11 to SMA88 may be connected to a row decoder 140 and a sense amplifier 165. The row decoder 140 of FIG. 4 may correspond to one of the first to sixteenth row decoders 140a to 140s, and the sense amplifier 165 of FIG. 4 may correspond to one of the first to sixteenth sense amplifiers 165a to 165s.

The sense amplifier 165 may be connected to the plurality of sub-memory arrays SMA11 to SMA88 through a global input/output line pair GIOp. According to some embodiment, any one of the global input/output line pairs GIOp may be connected to local sense amplifiers arranged in a first direction D1. For example, among the local sense amplifiers connected to the 1_1 to 8_1 sub-memory arrays SMA11 to SMA81, some of the local sense amplifiers arranged in the first direction D1 may be connected to the sense amplifier 165 through a global input/output line pair GIOp.

The row decoder 140 may be electrically connected to a plurality of sub-word line drivers, and the row decoder 140 may activate a sub-word line driver corresponding to a row address RA among the plurality of sub-word line drivers. An activated sub-word line driver may provide a driving voltage to the word line corresponding to the row address RA.

In FIG. 4, the sense amplifier 165 and the row decoder 140 are illustrated as being arranged so as not to overlap the bank array 210 in a plane. However, the arrangement of the sense amplifier 165 and the row decoder 140 illustrated in FIG. 4 is for explaining the connection relationship with the components. According to some embodiments, at least a portion of the sense amplifier 165 and at least a portion of the row decoder 140 may overlap the bank array 210 in the third direction D3.

Multiple sub-memory arrays SMA11 to SMA88 may be divided into eight row blocks arranged in the first direction D1 by some bits of the row address RA. For example, a plurality of sub-memory arrays SMA11 to SMA88 may be divided into first to eighth row blocks arranged in the first direction D1 by a plurality of upper bits of the row address RA, and the 1_1 to 1_8 sub-memory arrays SMA11 to SMA18 may be divided into one row block.

Although the bank array 210 of FIG. 4 includes a plurality of sub-memory arrays arranged in eight row blocks and eight column blocks, the present disclosure is not limited thereto, and the number of row blocks and column blocks included in the bank array may vary according to the embodiment. In the present disclosure, a 'row block' means a set of a plurality of sub-memory arrays arranged in a second direction D2 in which a word line extends, and a 'column block' means a set of a plurality of sub-memory arrays arranged in a first direction D1 in which a bit line extends.

Each of the 1_1 to 8_8 sub-memory arrays SMA11 to SMA88 may include a plurality of word lines extending in the second direction D2, a plurality of bit lines extending in the first direction D1, and a plurality of memory cells connected to the plurality of word lines and the plurality of bit lines. According to some embodiments, each of the 1_1 to 8_8 sub-memory arrays SMA11 to SMA88 may include a first predetermined number of word lines and a second predetermined number of bit lines extending intersecting the word lines. According to some embodiments, each word line of the sub-memory array may be connected to an adjacently arranged sub-word line driver, and each bit line of the sub-memory array may be connected to an adjacently arranged local sense amplifier circuit.

Referring to FIG. 5, the 1_1 sub-memory array SMA11 may be planarly overlapped in a third direction D3 with at least a portion of the 1_1 sub-word line driver region SWB11 and at least a portion of the 1_1 sub-word line driver region SWB12, and the 2_1 sub-memory array SMA21 may be planarly overlapped in a third direction D3 with at least a portion of the 2_1 sub-word line driver region SWB21 and at least a portion of the 2_2 sub-word line driver region SWB22. The 1_1 sub-word line driver region SWB11 and the 1_2 sub-word line driver region SWB12 may be arranged in the second direction D2, and the 2_1 sub-word line driver region SWB21 and the 2_2 sub-word line driver region SWB22 may be arranged in the second direction D2.

At least some of the sub-word line drivers arranged in the 1_1 sub-word line driver region SWB11 may be connected to the word lines of the 1_1 sub-memory array SMA11. At least some of the sub-word line drivers arranged in the 1_2 sub-word line driver region SWB12 are connected to the word lines of the 1_1 sub-memory array SMA11, and although not illustrated, at least some of the sub-word line drivers arranged in the 1_2 sub-word line driver region SWB12 may be connected to the word lines of the 1_2 sub-memory array SMA12 of FIG. 4. At least some of the sub-word line drivers arranged in the 2_1 sub-word line driver area SWB21 may be connected to the word lines of the 2_1 sub-memory array SMA21. At least some of the sub-word line drivers arranged in the 2_2 sub-word line driver region SWB22 may be connected to the word lines of the 2_1 sub-memory array SMA21, and although not illustrated, at least some of the sub-word line drivers arranged in the 2_2 sub-word line driver region SWB22 may be connected to the word lines of the 2_2 sub-memory array SMA22 of FIG. 4.

As in the arrangement of the 1_1 and 1_2 sub-word line driver regions SWB11, SWB12 and the 2_1 and 2_2 sub-word line driver regions SWB21, SWB22, the sub-word line driver regions may be arranged on one side of each of the 1_1 to 8_8 sub-memory arrays SMA11 to SMA88, and the sub-word line driver regions may be arranged adjacent to the sub-memory arrays in the second direction D2.

Taking FIG. 5 as an example, at least a portion of the 1_1 sub-memory array SMA11 may be overlapped in a plane with the 1_1 local sense amplifier circuit region LSAB11 and the 2_1 local sense amplifier circuit region LSAB21 in the third direction D3, and at least a portion of the 2_1 sub-memory array SMA21 may be overlapped in a plane with the 2_1 local sense amplifier circuit region LSAB21 and the 3_1 local sense amplifier circuit region LSAB31 in the third direction D3. The 2nd_1 local sense amplifier circuit region LSAB21 is arranged between the 1st_1 sub-memory array SMA11 and the 2_1 sub-memory array SMA21, and the 1_1 to 3_1 local sense amplifier circuit regions LSAB11 to LSB31 may be arranged in the first direction D1.

A local sense amplifier circuit disposed in the 1_1 local sense amplifier circuit region LSAB11 may be connected to a bit line of the 1_1 sub-memory array SMA11, and a local sense amplifier circuit disposed in the 2_1 local sense amplifier circuit region LSAB21 may be connected to a bit line of the 1_1 sub-memory array SMA11 and a bit line of the 2_1 sub-memory array SMA21. The local sense amplifier circuit region arranged in the 3_1 local sense amplifier circuit region LSAB31 may be connected to the bit line of the 2_1 sub-memory array SMA21, and although not illustrated, the local sense amplifier circuit region arranged in the 3_1 local sense amplifier circuit region LSAB31 may be connected to the bit line of the 3_1 sub-memory array SMA31 of FIG. 4.

According to some embodiments, the local sense amplifier circuitry disposed in the 1_1 local sense amplifier circuit region LSAB11 may be electrically connected to a predetermined third number of bit lines, and the local sense amplifier circuitry disposed in each of the 2_1 and 3_1 local sense amplifier circuit regions LSAB21, LSAB31 may be electrically connected to a predetermined fourth number of bit lines. The circuits arranged in each of the 1_1 and 1_2 local sense amplifier circuit regions LSAB11, LSAB21 may operate as one local sense amplifier circuit region.

In the present disclosure, a 'local sense amplifier circuit region' may mean a region in which a local sense amplifier circuitry may be disposed between a plurality of bit lines and a global input/output line pair, and which may perform a pumping operation on a voltage in a bit line or a bit line pair and perform a sensing operation and a transmission operation based on the pumped voltage. In some embodiments, the local sense amplifier circuitry may perform a sensing operation based on the pumped voltage to widen the sensing margin and improve the reliability of the sensing operation. In some embodiments, the local sense amplifier circuitry may improve the operating speed of the sensing operation by widening the sensing margin and not requiring separate offset removal to perform the sensing operation.

As in the arrangement of the 1_1 to 3_1 local sense amplifier circuit regions LSAB11 to LSAB31 described above, a local sense amplifier circuit region is arranged on one side of each of the 1_1 to 8_8 sub-memory arrays SMA11 to SMA88, and the local sense amplifier circuit region may be arranged adjacent to the sub-memory array in the first direction D1.

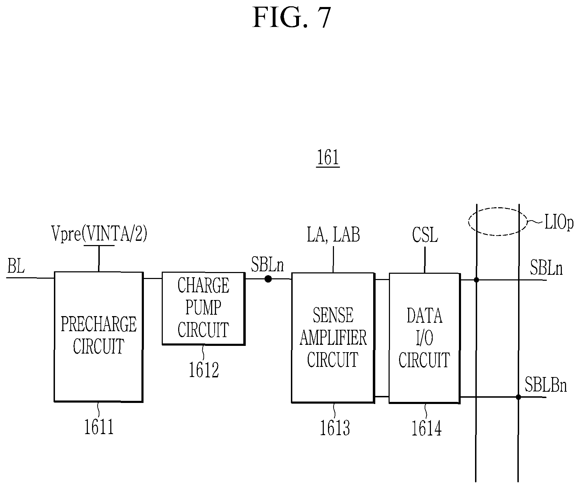

FIG. 6 is a block diagram illustrating configurations arranged in a sub-word line driver region and a local sense amplifier circuit region according to some embodiments. FIG. 7 is a block diagram illustrating a bit line sense amplifier according to some embodiments.

Specifically, FIG. 6 illustrates a circuit connection relationship between components LSAB11 to LSAB31, SWB11 to SWB12, SWB21 to SWB22 within the peripheral circuit area for driving the 1_1 and 2_1 sub-memory arrays SMA11, SMA21 and the 1_1 and 2_1 sub-memory arrays SMA11, SMA21 of FIG. 5.

Referring to FIGS. 5 to 7, the 1_1 sub-memory array SMA11 may include 1_1 and 1_2 word lines WL11, WL12 extending in the second direction D2, the 1_a to f1_d bit lines BL1a to BL1d extending in the first direction D1, and a plurality of memory cells MC arranged at points where the 1_1 and 1_2 word lines WL11, WL12 and the 1_a to 1_d bit lines BL1a to BL1d intersect. The 1_1 and 1_2 word lines WL11, WL12 may be spaced apart from each other in the first direction D1, and the 1_a to 1_d bit lines BL1a to BL1d may be spaced apart from each other in the second direction D2.

The 2_1 sub-memory array SMA21 may include 2_1 and 2_2 word lines WL21, WL22 extending in the second direction D2, 2_a to 2_d bit lines BL2a to BL2d extending in the first direction D1, and a plurality of memory cells MC arranged at points where the 2_1 and 2_2 word lines WL21, WL22 and the 2_a to 2_d bit lines BL2a to BL2d intersect. The 2_1 and 2_2 word lines WL21, WL22 may be spaced apart from each other in the first direction D1, and the 2_a to 2_d bit lines BL2a to BL2d may be spaced apart from each other in the second direction D2.

In FIG. 6, each of the 1_1 and 2_1 sub-memory arrays SMA11, SMA21 is illustrated as including two word lines and four bit lines, but the number of word lines and the number of bit lines illustrated are merely examples and the present disclosure is not limited thereto.

The 1_1 sub-word line driver region SWB11 may include a first sub-word line driver SWD1 that may provide a driving voltage to the 1_1 word line WL11, and the 1_2 sub-word line driver region SWB12 may include a first sub-word line driver SWD2 that may provide a driving voltage to the 1_2 word line WL12. By providing driving voltages of the first and second sub-word line drivers SWD1, SWD2, the 1_1 and 1_2 word lines WL11, WL12 may be activated and charge sharing between the memory cell MC and the 1_a to 1_d bit lines BL1a to BL1d may be performed. A charge sharing voltage may be applied to the first_a to first_d bit lines BL1a to BL1d based on data stored in a memory cell MC through a charge sharing operation.

The 2_1 sub-word line driver region SWB21 may include a third sub-word line driver SWD3 that may apply a driving voltage to the 2_1 word line WL21, and the 2_2 sub-word line driver region SWB22 may include a fourth sub-word line driver SWD4 that may apply a driving voltage to the 2_2 word line WL22. By providing driving voltages of the third and fourth sub-word line drivers SWD3, SWD4, the second_1st and second_2nd word lines WL21, WL22 may be activated and charge sharing between the memory cell MC and the 2_a to 2_d bit lines BL2a to BL2d may be performed. A charge sharing voltage may be applied to the 2_a to 2_d bit lines BL2a to BL2d based on data stored in a memory cell MC through a charge sharing operation.

The local sense amplifier circuitry arranged in the 1_1 local sense amplifier circuit region LSAB11 may include an a-th bit line sense amplifier 161a, a b-th bit line sense amplifier 161b, and a first local sense amplifier 163_1.

The a-th bit line sense amplifier 161a may be electrically connected to the 1_a bit line BL1a. According to some embodiments, the a-th bit line sense amplifier 161a may include a single-ended sense amplifier circuit to sense data stored in a memory cell MC based on the voltage level of the 1_a bit line BL1a. The a-th bit line sense amplifier 161a may pump the voltage level of the 1_a bit line BL1a and amplify the pumped voltage to sense data stored in the memory cell MC. The first bit line sense amplifier 161a may transmit sensed data to the first local data input/output line pair LIOp1 in response to the first column select signal CSL1.

The b-th bit line sense amplifier 161b may be electrically connected to the 1_c bit line BL1c. According to some embodiments, the b-th bit line sense amplifier 161b may include a single-ended sense amplifier circuit to sense data stored in a memory cell MC based on the voltage level of the 1_c bit line BL1c. The b-th bit line sense amplifier 161b may pump the voltage level of the 1_c bit line BL1c and amplify the pumped voltage to sense data stored in the memory cell MC. The b-th bit line sense amplifier 161b may transmit sensed data to the first local data input/output line pair LIOp1 in response to the first column select signal CSL1.

The first local sense amplifier 163_1 may be connected to the a-th and b-th bit line sense amplifiers 161a, 161b via the first local input/output line pair LIOp1.

The first local sense amplifier 163_1 may be activated in response to a control signal, and when the first local sense amplifier 163_1 is activated, the voltage difference of the first local input/output line pair LIOp1 may be amplified and provided to the first global input/output line pair GIOp1.

The local sense amplifier circuitry arranged in the 2_1 local sense amplifier circuit region LSAB21 may include a c-th bit line sense amplifier 161c, a d-th bit line sense amplifier 161d, and a second local sense amplifier 163_2.

The c-th bit line sense amplifier 161c may be electrically connected to the 1_b bit line BL1b and the 2_a bit line BL2a. According to some embodiments, the c-th bit line sense amplifier 161c may include a single-ended sense amplifier circuit to sense data stored in a memory cell MC based on a voltage level of the 1_b bit line BL1b or the 2_a bit line BL2a. According to some embodiments, the c-th bit line sense amplifier 161c may include a differential sense amplifier circuit to amplify a voltage difference occurring between the 1_b bit line BL1b and the 2_a bit line BL2a to sense data stored in the memory cell MC.

The c-th bit line sense amplifier 161c may pump the voltage level of the 1_b bit line BL1b or the 2_a bit line BL2a and perform an amplification operation based on the pumped voltage to sense data stored in the memory cell MC. The c-th bit line sense amplifier 161c may transmit the sensed data to the second local data input/output line pair LIOp2 in response to the second column select signal CSL2.

The d-th bit line sense amplifier 161d may be electrically connected to the 1_d bit line BL1d and the 2_c bit line BL2c. According to some embodiments, the d-th bit line sense amplifier 161d may include a single-ended sense amplifier circuit to sense data stored in a memory cell MC based on a voltage level of a 1_d bit line BL1d or a 2_c bit line BL2c. According to some embodiments, the d-th bit line sense amplifier 161d may include a differential sense amplifier circuit to amplify a voltage difference occurring between the 1_d bit line BL1d and the 2_c bit line BL2c to sense data stored in the memory cell MC.

The d-th bit line sense amplifier 161d may pump the voltage level of the 1_d bit line BL1d or the 2_c bit line BL2c and perform an amplification operation based on the pumped voltage to sense data stored in the memory cell MC. The d-th bit line sense amplifier 161d may transmit the sensed data to the second local data input/output line pair LIOp2 in response to the second column select signal CSL2.

The second local sense amplifier 163_2 may be connected to the c-th and d-th bit line sense amplifiers 161c, 161d through the second local input/output line pair LlOp2.

The second local sense amplifier 163_2 may be activated in response to a control signal, and when the second local sense amplifier 163_2 is activated, the voltage difference of the second local input/output line pair LIOp2 may be amplified and provided to the first global input/output line pair GIOp1.

The local sense amplifier circuitry arranged in the 3_1 local sense amplifier circuit region LSAB31 may include a e-th bit line sense amplifier 161e, a f-th line sense amplifier 161f, and a third local sense amplifier 163_3.

The e-th bit line sense amplifier 161e may be electrically connected to the 2_b bit line BL2b and one bit line in the 3_1 sub-memory array SMA31 of FIG. 4. According to some embodiments, the e-bit line sense amplifier 161e may include a single-ended sense amplifier circuit to sense data stored in a memory cell MC based on a voltage level of a bit line within the 2_b bit line BL2b or the 3_1 sub-memory array SMA31. According to some embodiments, the e-bit line sense amplifier 161e may include a differential sense amplifier circuit to amplify a voltage difference between the 2_b bit line BL2b and a bit line within the 3_1 sub-memory array SMA31 to sense data stored in the memory cell MC.

The e-th bit line sense amplifier 161e may pump the voltage level of one bit line in the 2_b bit line BL2b or the 3_1 sub-memory array SMA31 and perform an amplification operation based on the pumped voltage to sense data stored in the memory cell MC. The e-th bit line sense amplifier 161e may transmit sensed data to the third local data input/output line pair LIOp3 in response to the third column select signal CSL3.

The f-th bit line sense amplifier 161f may be electrically connected to the 2_d bit line BL2d and one bit line in the 3_1 sub-memory array SMA31. According to some embodiments, the f-th bit line sense amplifier 161f may include a single-ended sense amplifier circuit to sense data stored in a memory cell MC based on a voltage level of a bit line within the 2_d bit line BL2d or the 3_1 sub-memory array SMA31. According to some embodiments, the f-th bit line sense amplifier 161f may include a differential sense amplifier circuit to amplify a voltage difference occurring between the 2_d bit line BL2d and a bit line within the 3_1 sub-memory array SMA31 to sense data stored in the memory cell MC.

The f-th bit line sense amplifier 161f may pump the voltage level of one bit line in the 2_d bit line BL2d or the 3_1 sub-memory array SMA31 and perform an amplification operation based on the pumped voltage to sense data stored in the memory cell MC. The f-th bit line sense amplifier 161f may transmit sensed data to the third local data input/output line pair LIOp3 in response to the third column select signal CSL3.

The third local sense amplifier 163_3 may be connected to the e-th and f-th bit line sense amplifiers 161e, 161f via the third local input/output line pair LIOp3.

The third local sense amplifier 163_3 may be activated in response to a control signal, and when the third local sense amplifier 163_3 is activated, the voltage difference of the third local input/output line pair LIOp3 may be amplified and provided to the first global input/output line pair GIOp1.

Below, the description of the bit line sense amplifier 161 of FIG. 7 applies to one or more or all of the a-th to f-th bit line sense amplifiers 161a to 161f.

Referring additionally to FIG. 7, the bit line sense amplifier 161 may include a precharge circuit 1611, a charge pump circuit 1612, a sense amplifier circuit 1613, and a data input/output circuit 1614. The bit line sense amplifier 161 may include a sense amplifier circuit 1613 which is a single-ended sense amplifier circuit.

The precharge circuit 1611 may precharge the bit line BL to a precharge voltage Vpre in response to a precharge control signal. According to some embodiments, the voltage level of the precharge voltage Vpre may be half the voltage level of the internal power supply voltage VINTA. The bit line BL may be one of the bit lines connected to the bit line sense amplifier 161.

According to an embodiment, the precharge circuit 1611 may include a precharge voltage source and a switch transistor. The above switch transistor is connected in series between a bit line BL and a precharge voltage source, and may provide a precharge voltage Vpre to the bit line BL based on a precharge control signal. In some embodiments, the switch transistors may be NMOS transistors, and the number of the switch transistors may vary depending on the number of bit lines BL connected to the bit line sense amplifier 161.

A charge pump circuit 1612 is connected between a bit line BL and a sense amplifier circuit 1613, and the bit line BL may be connected to a sensing node SBLn, which is an input node of the sense amplifier circuit 1613, through the charge pump circuit 1612.

The charge pump circuit 1612 may store a certain amount of charge through a charge sharing operation between a bit line BL and a memory cell MC, and pump the voltage of the sensing node SBLn in a charge pump manner based on the stored charge.

The charge pump circuit 1612 may include a pump capacitor that stores a certain amount of charge and a plurality of switch transistors. A pump capacitor may store a certain amount of charge through charge sharing between a bit line BL and a memory cell MC.

The amount of charge stored in the pump capacitor or the polarity of the electrode within the pump capacitor may be changed based on the charge sharing voltage applied to the bit line BL through the charge sharing operation. In some embodiments, the magnitude of the charge stored in the pump capacitor or the polarity of the electrodes within the pump capacitor may vary depending on the data stored in the memory cell MC. For example, when the data stored in the memory cell MC is '1', the polarity direction of the electrodes inside the pump capacitor charged through charge sharing may be opposite to each other, and when the data stored in the memory cell MC is '0', the polarity direction of the electrodes inside the pump capacitor charged through charge sharing may be opposite to each other.

A plurality of switch transistors may control the connection relationship between the bit line BL, the sense amplifier circuit 1613, and the pump capacitor. To illustrate, in an operation of pumping the voltage of the sensing node SBLn, the charge pump circuit 1612 may connect a charged pump capacitor in series between the bit line BL and the sensing node SBLn of the sense amplifier circuit 1613 through a plurality of switch transistors.

The number of pump capacitors may vary depending on the embodiment. In some embodiments, in a read operation of the bit line sense amplifier 161, the charge pump circuit 1612 may determine the number of pumping operations based on the number of pump capacitors. For example, if the charge pump circuit 1612 includes two pump capacitors, the voltage of the sensing node SBLn may be pumped twice before the sensing operation of the sense amplifier circuit 1613.

The sense amplifier circuit 1613 is a single-ended sense amplifier circuit and may be electrically connected to a bit line BL through a sensing node SBLn. The sense amplifier circuit 1613 may sense data by sensing and amplifying a pumped voltage at the sensing node SBLn based on a pair of sensing control signals LA, LAB. According to some embodiments, the sense amplifier circuit 1613 may include a first sense amplifier circuit and a second sense amplifier circuit, each connected to a sensing node SBLn and a complementary sensing node SBLBn, respectively. The above first sense amplifier circuit may be connected in series between the sensing node SBLn and the complementary sensing node SBLBn, and sense "low" level data from the sensing node SBLn based on the sensing control signal LA and amplify the complementary sensing node SBLBn to the level of the internal power supply voltage VINTA. The above second sense amplifier circuit may be connected in series between the sensing node SBLn and the complementary sensing node SBLBn, and senses "high" level data at the complementary sensing node SBLBn based on the inverted sensing control signal LAB and amplify the sensing node SBLn to the level of the ground voltage.

In the sensing and amplification operation of the sense amplifier circuit 1613, the sensing control signal LA may be changed from the precharge voltage Vpre, which is an OFF voltage, to the internal power supply voltage VINTA, which is an operating voltage, and the inverted sensing control signal LAB may be changed from the precharge voltage Vpre, which is an OFF voltage, to the ground voltage, which is an operating voltage.

The data input/output circuit 1614 may transmit data sensed at the sensing node SBLn and the complementary sensing node SBLBn to the local data input/output line pair LIOp in response to a column select signal CSL, or transmit data of the local data input/output line pair LIOp to the sensing node SBLn and the complementary sensing node SBLBn. According to some embodiments, the data input/output circuit 1614 may include a plurality of switch transistors. The above-described one switch transistor electrically connects between a sensing node SBLn and a local data input/output line based on a column select signal CSL, and the above-described one transistor may electrically connect between a complementary sensing node SBLBn and a local data input/output line based on the column select signal CSL.

According to some embodiments, the sense amplifier circuit 1613 performs a sensing operation based on the voltage pumped by the charge pump circuit 1612, so that the bit line sense amplifier 161 may widen the sensing margin and improve the reliability of the sensing operation.

In some embodiments, the charge pump circuit 1612 may pump the voltage at the sensing node SBLn in a charge pump manner using a pump capacitor, thereby pumping the voltage at the sensing node SBLn without using a transistor or the like. Through voltage pumping using the charge pump method as described above, the charge pump circuit 1612 may pump the voltage at the sensing node SBLn without being affected by the offset due to process dispersion or the size of the common mode voltage.

In some embodiments, the bit line sense amplifier 161 may improve the operating speed of the sensing operation by widening the sensing margin so that no separate offset removal is required to perform the sensing operation.

In FIGS. 6 and 7, the local sense amplifier circuits arranged in the 1_1 to 3_1 local sense amplifier circuit regions LSAB11 to LSAB31 for driving the 1_1 and 2_1 sub-memory arrays SMA11, SMA21 and the 1_1 and 2_1 sub-memory arrays SMA11, SMA21 are described, but the description of FIGS. 6 and 7 may be applied to one sub-memory array and one local sense amplifier circuit for driving the one sub-memory array.

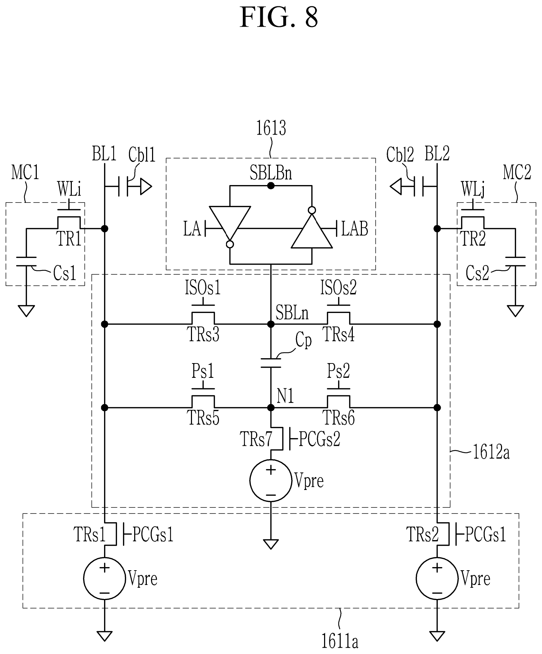

FIG. 8 is a circuit diagram illustrating a bit line sense amplifier according to some embodiments. Specifically, FIG. 8 illustrates a part of an example circuit of the bit line sense amplifier 161 of FIG. 7, and the precharge circuit 1611a and the charge pump circuit 1612a of FIG. 8 are examples of the precharge circuit 1611 and the charge pump circuit 1612 of FIG. 7.

Referring to FIGS. 7 and 8, a first memory cell MC1 may be connected to a first bit line BL1 and an i-th word line WLi, and a second memory cell MC2 may be connected to a second bit line BL2 and a j-th word line WLj. In some embodiments, the first memory cell MC1 and the second memory cell MC2 may be included in different and adjacently arranged sub-memory arrays, but are not limited thereto, and in some embodiments, the first memory cell MC1 and the second memory cell MC2 may be included in the same sub-memory array. The above i and j are different natural numbers.

The first memory cell MC1 is a volatile memory cell, has a 1T1C structure, and may include a first transistor TR1 and a first storage capacitor Cs1. A first transistor TR1 is connected between a first bit line BL1 and a first storage capacitor Cs1 and may be controlled by an i-th word line WLi.

The second memory cell MC2 is a volatile memory cell, has a 1T1C structure, and may include a second transistor TR2 and a second storage capacitor Cs2. The second transistor TR2 is connected between the second bit line BL2 and the second storage capacitor Cs2 and may be controlled by the j-th word line WLj.

A first bit line capacitor Cbl1 is placed between the first bit line BL1 and the ground terminal, and the voltage of the first bit line BL1 may be held by the first bit line capacitor Cbl1. A second bit line capacitor Cbl2 is placed between the second bit line BL2 and the ground terminal, and the voltage of the second bit line BL2 may be held by the second bit line capacitor Cbl2. In some embodiments, the first bit line capacitor Cbl1 and the second bit line capacitor Cbl2 may be parasitic capacitors formed by the bit line and surrounding wiring or circuit elements.

The precharge circuit 1611a may provide a precharge voltage Vpre to the first bit line BL1 and the second bit line BL2 based on the first precharge control signal PCGs1. The precharge circuit 1611a may include first and second switch transistors TRs1, TRs2 and a precharge power source.

The first switch transistor TRs1 may connect the first bit line BL1 and the precharge power source based on the first precharge control signal PCGs1. The second switch transistor TRs2 may connect the second bit line BL2 and the precharge power source based on the first precharge control signal PCGs1. In some embodiments, the first and second switch transistors TRs1, TRs2 may be NMOS transistors.

The charge pump circuit 1612a has a shared structure for the first and second bit lines BL1, BL2, and may store a certain amount of charge through a charge sharing operation between the first bit line BL1 and the first memory cell MC1 or a charge sharing operation between the second bit line BL2 and the second memory cell MC2. The charge pump circuit 1612a may pump the voltage of the sensing node SBLn based on the stored charge.

The charge pump circuit 1612a may include a pump capacitor Cp, third to seventh switch transistors TRs3 to TRs7, and a precharge power source. The pump capacitor Cp of the charge pump circuit 1612a has a shared structure for the first bit line BL1 and the second bit line BL2, and may be electrically connected to the first bit line BL1 or the second bit line BL2 through the third to seventh switch transistors TRs3 to TRs7.

The pump capacitor Cp may include a first electrode electrically connected to a sensing node SBLn, which is an input node of the sense amplifier circuit 1613, and a second electrode electrically connected to a first node N1 different from the sensing node SBLn. According to some embodiments, the pump capacitor Cp may include conductive wiring or circuit elements disposed in the peripheral circuit area PS of FIG. 3. The pump capacitor Cp may include a MIM (Metal-Insulator-Metal) capacitor, a MOS capacitor, etc.

The third switch transistor TRs3 may connect the sensing node SBLn and the first bit line BL1 based on the first isolation control signal ISOs1. The fourth switch transistor TRs4 may connect the sensing node SBLn and the second bit line BL2 based on the second isolation control signal ISOs2. The fifth switch transistor TRs5 may connect the first node N1 and the first bit line BL1 based on the first pumping control signal Ps1. The sixth switch transistor TRs6 may connect the first node N1 and the second bit line BL2 based on the second pumping control signal Ps2. The seventh switch transistor TRs7 may connect the first node N1 and the precharge power source based on the second precharge control signal PCGs2, and may provide the precharge voltage Vpre to the first node N1 based on the second precharge control signal PCGs2.

In some embodiments, the third to seventh switch transistors TRs3 to TRs7 may be NMOS transistors.

The sense amplifier circuit 1613 may sense data stored in the first memory cell MC1 or data stored in the second memory cell MC2 by performing a sensing and amplification operation based on the voltage pumped from the sensing node SBLn. In some embodiments, the sense amplifier circuit 1613 is a cross-coupled latch circuit and may include two inverters connected to each other in a feedback structure.

The sense amplifier circuit 1613 performs a sensing operation based on the voltage pumped by the charge pump circuit 1612a, so that the bit line sense amplifier 161 may widen the sensing margin and improve the reliability of the sensing operation. In some embodiments, the bit line sense amplifier 161 may improve the operating speed of the sensing operation by widening the sensing margin so that no separate offset removal is required to perform the sensing operation.

The bit line sense amplifier 161 may improve area efficiency and improve the reliability of the sensing operation by performing a voltage pumping operation on the sensing node SBLn connected to the first and second bit lines BL1, BL2 through a charge pump circuit 1612a of a shared structure.

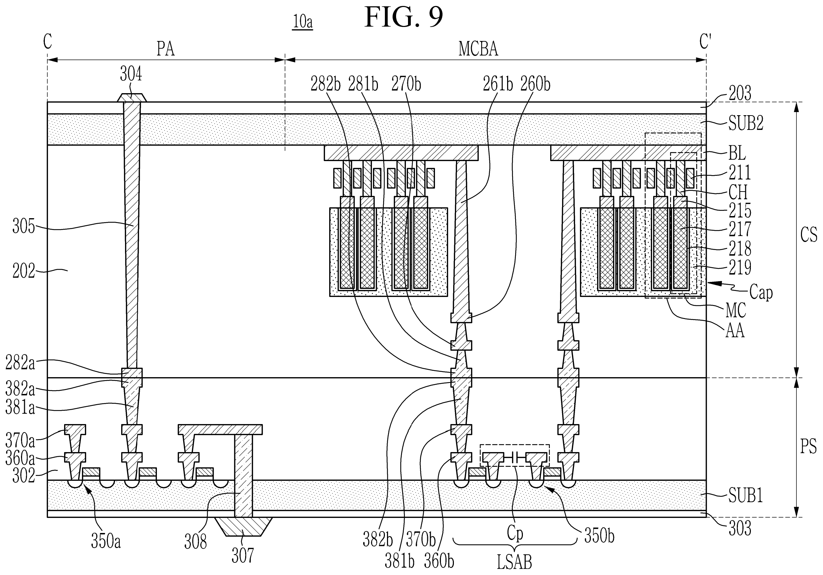

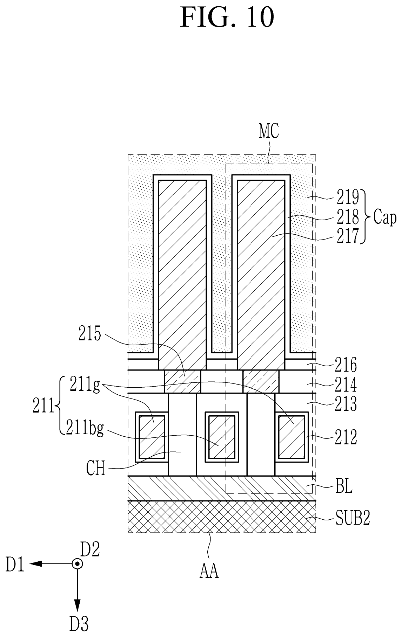

FIG. 9 is a cross-sectional view taken along lines C to C' of an example memory device of FIG. 3. FIG. 10 is an enlarged view of the AA area of FIG. 9.

Referring to FIGS. 3 to 10, a memory device 10a according to some embodiments may have a C2C (chip to chip) structure, which is a COP structure. The C2C structure may mean fabricating an upper chip including a memory cell area CS on a first wafer, fabricating a lower chip including a peripheral circuit area PS on a second wafer different from the first wafer, and then connecting the upper chip and the lower chip to each other by a bonding method. For example, the above bonding method may mean a method of electrically connecting a bonding metal disposed on the top metal layer of an upper chip and a bonding metal disposed on the top metal layer of a lower chip. For example, if the bonding metal is arranged as copper(Cu), the bonding method may be a Cu-Cu bonding method, but is not limited thereto, and according to the embodiment, the bonding metal may be aluminum or tungsten.

According to some embodiments, each of the peripheral circuit area PS and the memory cell area CS of the memory device 10a may include an external pad bonding area PA and a memory cell bonding area MCBA.

The peripheral circuit area PS may include a first substrate SUB1, a first interlayer insulating layer 302, a plurality of circuit elements 350a, 350b arranged on the first substrate SUB1, a first metal layer 360a, 360b connected to each of the plurality of circuit elements 350a, 350b, and a second metal layer 370a, 370b arranged on the first metal layer 360a, 360b. In some embodiments, the first metal layer 360a, 360b may be formed of relatively high resistivity tungsten, and the second metal layer 370a, 370b may be formed of relatively low resistivity copper.

In the present disclosure, only the first metal layer 360a, 360b and the second metal layer 370a, 370b are illustrated, but this is not limited to the first metal layer, and at least one more metal layer may be disposed on the second metal layer 370a, 370b. At least some of the one or more metal layers disposed on top of the second metal layer 370a, 370b may be aluminum having a lower resistance than the copper on which the second metal layer 370a, 370b is disposed.

The first interlayer insulating layer 302 is disposed on the first substrate SUB1 to cover a plurality of circuit elements 350a, 350b, the first metal layer 360a, 360b, and the second metal layer 370a, 370b, and may include an insulating material such as silicon oxide, silicon nitride, or the like.

A memory cell area CS may provide the plurality of memory cells MC. The memory cell area CS may include a second substrate SUB2, a bit line BL, and a first metal layer 260b connected to each of the bit lines BL through a bit line contact 261b, and a second metal layer 270b disposed on the first metal layer 260b. In an embodiment, the first metal layer 260b may be tungsten, which has a relatively high resistance, and the second metal layer 270b may be copper, which has a relatively low resistance. Each of the plurality of memory cells MC and bit lines BL may correspond to the memory cells MC and bit lines BL in FIGS. 2 to 8.

In an embodiment illustrated in FIG. 9, an area where a plurality of memory cells MC and bit lines BL are arranged may be defined as a memory cell bonding area MCBA. Referring to FIGS. 9 and 10, a memory cell area CS in a memory cell bonding area MCBA may include a bit line BL, a memory vertical channel layer CH, a plurality of first gate electrodes 211, a first gate insulating layer 212, and a capacitor structure Cap.

In some embodiments, the plurality of memory cells MC may include vertical channel transistors VCT. The above vertical channel transistor may refer to a structure in which a memory vertical channel layer CH extends along a third direction D3 that is vertical from a second substrate SUB2. The third direction D3 is a direction that proceeds perpendicular to the first direction D1 in which the bit line BL extends and the second direction D2 in which the first gate electrode 211 extends.

The bit line BL may be arranged to extend parallel to the lower surface of the second substrate SUB2. Within a memory cell area CS, a plurality of bit lines BL may be arranged spaced apart from each other in a first direction D1, and an insulating pattern may be arranged in spaces between the plurality of bit lines BL. The above insulating pattern may extend in the first direction D1, and the upper surface of the insulating pattern may be arranged at the same height as the upper surface of the bit line BL.

For example, the bit line BL may include doped polysilicon, a metal, a conductive metal nitride, a conductive metal silicide, a conductive metal oxide, or a combination thereof. For example, the bit line BL may be formed of, but is not limited to, doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOx, RuOx, or combinations thereof. The bit line BL may comprise a single layer or the plurality of layers of the aforementioned materials.

The memory vertical channel layers CH may be arranged spaced apart from each other in a first direction D1 on the bit line BL. Although not illustrated, the memory vertical channel layers CH may be arranged in a matrix form spaced apart from each other in a first direction D1 and a second direction D2 on a plurality of bit lines. The bottom portion of the memory vertical channel layer CH functions as a first source/drain region (not illustrated), the upper portion of the memory vertical channel layer CH functions as a second source/drain region (not illustrated), and a portion of the memory vertical channel layer CH between the first and second source/drain regions may function as a channel region (not illustrated).

For example, the memory vertical channel layer CH may include silicon, an oxide semiconductor, or a combination thereof, and for example, the oxide semiconductor may include InxGayZnzO IGZO, InxGaySizO, InxSnyZnzO, InxZnyO, ZnxO, ZnxSnyO, ZnxOyN, ZrxZnySnzO, SnxO, HfxlnyZnzO, GaxZnySnzO, AlxZnySnzO, YbxGayZnzO, InxGayO, or a combination thereof. The memory vertical channel layer CH may include a single layer or the plurality of layers of the oxide semiconductor. In some examples, the memory vertical channel layer CH may have a bandgap energy greater than the bandgap energy of silicon. For example, the memory vertical channel layer CH may have a bandgap energy of about 1.5 eV to 5.6 eV. For example, a memory vertical channel layer CH may have optimal channel performance when it has a bandgap energy of about 2.0 eV to 4.0 eV. For example, the memory vertical channel layer CH may be, but is not limited to, polycrystalline or amorphous. In example embodiments, the memory vertical channel layer CH may include a two-dimensional semiconductor material, for example, the two-dimensional semiconductor material may include graphene, carbon nanotubes, or a combination thereof.

The first gate electrode 211 may extend in the second direction D2 on both sidewalls of the memory vertical channel layer CH. The first gate electrode 211 may include a first sub-gate electrode 211g facing a first sidewall of the memory vertical channel layer CH and a first back gate electrode 211bg facing a second sidewall opposite to the first sidewall of the memory vertical channel layer CH. The first sub-gate electrode 211g may function as any one of the plurality of word lines WL of FIGS. 2 to 8, and the first back gate electrode 211bg may perform the function of forming a ground potential of a vertical channel transistor including a memory vertical channel layer CH.

The first gate electrode 211 may include doped polysilicon, a metal, a conductive metal nitride, a conductive metal silicide, a conductive metal oxide, or a combination thereof. For example, the first gate electrode 211 may be formed of, but is not limited to, doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOx, RuOx, or a combination thereof.

The first gate insulating layer 212 may be arranged to surround the first gate electrode 211, and at least a portion of the first gate insulating layer 212 may be arranged between the first gate electrode 211 and the memory vertical channel layer CH. In FIG. 10, the first gate insulating layer 212 is arranged in a form that surrounds the first gate electrode 211, but according to an embodiment, the first gate insulating layer 212 may have a form that is arranged along at least a portion of the sidewall of the first gate insulating layer 212.

In example embodiments, the first gate insulating layer 212 may be formed of a silicon oxide film, a silicon oxynitride film, a high-k film having a higher dielectric constant than the silicon oxide film, or a combination thereof. The above high-k dielectric film may be made of a metal oxide or a metal oxynitride. For example, a high-k dielectric film usable as the first gate insulating layer 212 may be formed of, but is not limited to, HfO2, HfSiO, HfSiON, HfTaO, HfTiO, HfZrO, ZrO2, Al2O3, or a combination thereof.

A first interlayer insulating film 213 may be placed in the space between the first gate electrode 211 on the bit line BL and the memory vertical channel layer CH. In FIG. 10, the first interlayer insulating film 213 is illustrated as one continuous material layer, but according to the embodiment, the first interlayer insulating film 213 may be arranged in a plurality of insulating patterns.

A capacitor contact 215 may be placed on the memory vertical channel layer CH. The capacitor contact 215 may be arranged to vertically overlap the memory vertical channel layer CH in the third direction D3. The capacitor contact 215 may be formed of, but is not limited to, doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOx, RuOx, or a combination thereof. The first upper insulating layer 214 may surround the sidewall of the capacitor contact 215 on the first interlayer insulating film 213.

A first etching stop film 216 may be placed on the first upper insulating layer 214, and a capacitor structure Cap may be placed on the first etching stop film 216. The capacitor structure Cap may include a lower electrode 217, a capacitor dielectric layer 218, and an upper electrode 219.

The lower electrode 217 may be electrically connected to the upper surface of the capacitor contact 215 by penetrating the first etching stop film 216. The lower electrode 217 may be arranged in a pillar type extending in the third direction D3, but is not limited thereto. In example embodiments, the lower electrode 217 may be arranged to overlap the capacitor contact 215 in a plane along the third direction D3. Alternatively, a landing pad (not illustrated) may be further arranged between the capacitor contact 215 and the lower electrode 217, so that the lower electrode 217 may be arranged in a hexagonal shape.

The first gate electrode 211, the memory vertical channel layer CH, and the capacitor structure Cap may function as one memory cell MC. The first gate electrode 211 and the memory vertical channel layer CH may function as a transistor, and the capacitor structure Cap may function as a capacitor. The memory cell MC may correspond to any one of the plurality of memory cells MC of FIGS. 2 to 8.

In the memory cell bonding area MCBA, a plurality of memory cells MC may be electrically connected to the first metal layer 260b and the second metal layer 270b through bit line contacts 261b extending in the third direction D3.

A lower bonding metal 381b, 382b may be placed on the second metal layer 370b of the memory cell bonding area MCBA. In the memory cell bonding area MCBA, the lower bonding metal 381b, 382b of the peripheral circuit area PS may be electrically connected to the upper bonding metal 281b, 282b of the memory cell area CS by a bonding method, and the lower bonding metal 381b, 382b and the upper bonding metal 281b, 282b may be aluminum, copper, or tungsten.

In the memory cell bonding area MCBA, the bit line BL may be electrically connected to circuit elements 350b that provide components arranged in the local sense amplifier circuit region LSAB of the peripheral circuit area PS. For example, a bit line BL is connected to an upper bonding metal 281b, 282b through a bit line contact 261b in a memory cell area CS, and the upper bonding metal 281b, 282b may be connected to a lower bonding metal 381b, 382b that is connected to circuit elements 350b arranged in a local sense amplifier circuit region LSAB. Components arranged in the local sense amplifier circuit region LSAB may be overlapped with a plurality of memory cells MC and bit lines BL along a third direction D3. The local sense amplifier circuit region LSAB may correspond to the 1_1 to 3_1 local sense amplifier circuit regions LSAB11 to LSAB31 of FIGS. 5 and 6.

In the memory cell bonding area MCBA, a portion of the first metal layer 360b connected to the circuit elements 350b and a portion of the first interlayer insulating layer 302 form a MIM capacitor, and the MIM capacitor may function as a pump capacitor Cp. Although not illustrated, at least some of the circuit elements 350b form MOS capacitors, which may function as pump capacitors Cp. The pump capacitor Cp may correspond to the pump capacitor Cp of FIG. 8.

Meanwhile, the external pad bonding area PA may include a first external pad 307 positioned on a peripheral circuit area PS and a second external pad 304 positioned on a memory cell area CS. Referring to FIG. 9, a lower insulating film 303 covering the lower surface of the first substrate SUB1 may be placed on the lower portion of the first substrate SUB1, and a first external pad 307 may be placed on the lower insulating film 303. The first external pad 307 may be electrically connected to at least one of a plurality of circuit elements 350a, 350b arranged in the peripheral circuit area PS via the first external contact plug 308, and may be separated from the first substrate SUB1 by the lower insulating film 303. Although not illustrated, a side insulating film may be disposed between the first external contact plug 308 and the first substrate SUB1 to electrically isolate the first external contact plug 308 and the first substrate SUB1.

An upper insulating film 203 covering the upper surface of the second substrate SUB2 may be placed on the upper portion of the second substrate SUB2, and a second external pad 304 may be placed on the upper insulating film 203. The second external pad 304 may be electrically connected to at least one of a plurality of circuit elements 350a, 350b arranged in the peripheral circuit area PS through a second external contact plug 305 extending in the third direction D3 and penetrating the second interlayer insulating layer 202 of the memory cell area CS. The second external pad 304 may be separated from the second substrate SUB2 by the upper insulating film 203. The second external contact plug 305 is connected to the upper bonding metal 282a, and the upper bonding metal 282a may be connected in a bonding manner to the lower bonding metal 381a, 382a connected to the circuit elements 350a of the peripheral circuit area PS. The lower bonding metal 381a, 382a and the upper bonding metal 282a may be made of aluminum, copper, or tungsten.

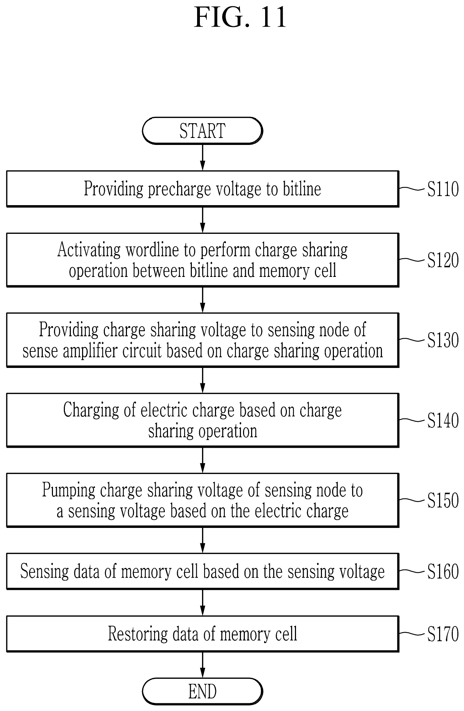

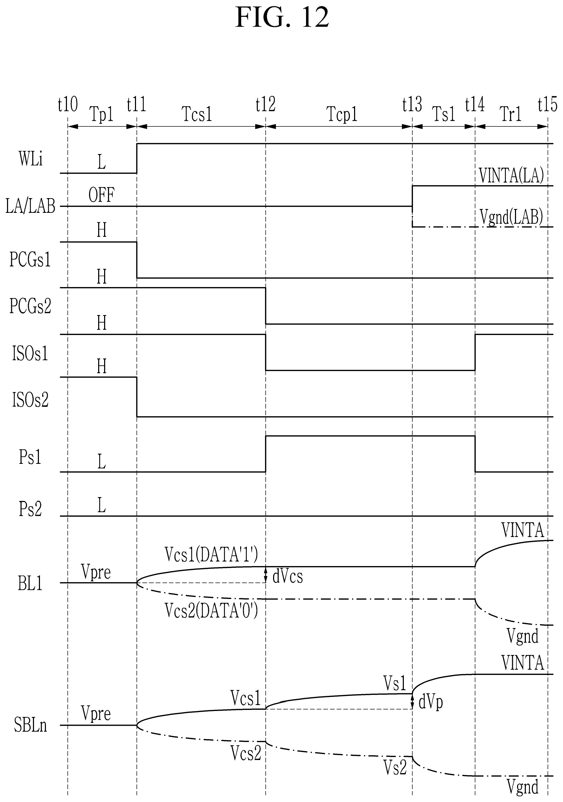

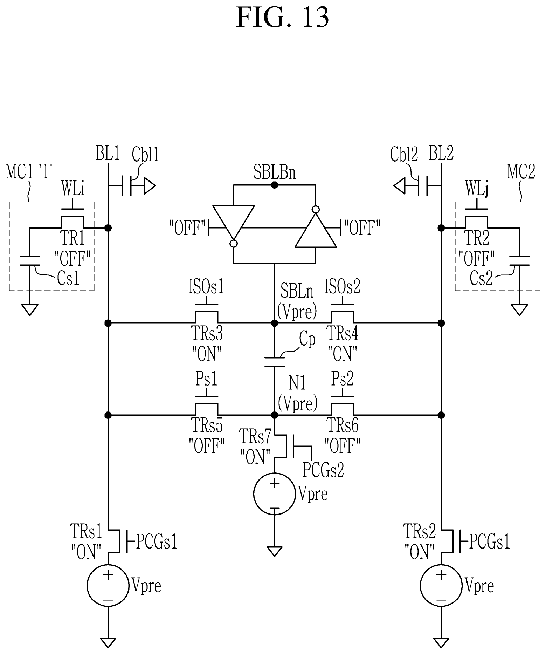

FIG. 11 is a flowchart illustrating a method of operating a memory device according to some embodiments. FIG. 12 is a timing diagram illustrating a method of operating a memory device according to some embodiments. FIGS. 13 to 17 are drawings for explaining an operation method of a memory device according to some embodiments.

Specifically, FIGS. 12 to 17 illustrate an operation method of a memory device centered on a process of reading data stored in the first memory cell MC1 of FIG. 8, and for ease of explanation, FIGS. 12 to 17 are used as examples to explain the operation method of the memory device below.

Referring to FIGS. 7, 8, 11, and 12, the precharge circuit 1611 provides a precharge voltage Vpre to the bit line BL(S110).

The precharge circuit 1611 may provide a precharge voltage Vpre to the bit line BL during the precharge period.

At time t10, the i-th word line WLi receives a signal at logic low L level and may be disabled. The sensing control signal pair LA, LAB may be an off voltage, the first precharge control signal PCGs1 may be at a logic high H level, the second precharge control signal PCGs2 may be at a logic high H level, the first isolation control signal ISOs1 may be at a logic high H level, the second isolation control signal ISOs2 may be at a logic high H level, the first pumping control signal Ps1 may be at a logic low L level, and the second pumping control signal Ps2 may be at a logic low L level.

Taking FIG. 13 as an example, the first transistor TR1 may be turned off, and the sense amplifier circuit 1613 may be turned off. The first to fourth switch transistors TRs1 to TRs4 may be turned on, the fifth and sixth switch transistors TRs5, TRs6 may be turned off, and the seventh switch transistor TRs7 may be turned on. A precharge voltage Vpre may be applied to the first bit line BL1 and the second bit line BL2, a precharge voltage Vpre may be applied to the sensing node SBLn, and a precharge voltage Vpre may be applied to the first node N1.

During the first precharge period Tp1 after time point t10, a precharge voltage Vpre may be provided to the first bit line BL1 and the second bit line BL2, and a precharge voltage Vpre may be provided to the first node N1. During the first precharge period Tp1, a precharge voltage Vpre may be applied to the sensing node SBLn, and a precharge voltage Vpre may be applied to the first node N1.

The sub-word line driver activates the word line to perform a charge sharing operation between the bit line BL and the memory cell(S120).

The sub-word line driver activates the word line by applying a word line driving voltage to the word line, and a charge sharing operation between the memory cell and the bit line may be performed. During charge sharing operation, charge is shared between the storage capacitor and the bit line within the memory cell, and the voltage of the bit line may change from the precharge voltage Vpre to the charge sharing voltage.

At time t11, the i-th word line WLi receives a signal at a logic high H level and may be activated. The first precharge control signal PCGs1 may transition from a logic high H level to a logic low L level, and the second isolation control signal ISOs2 may transition from a logic high H level to a logic low L level.

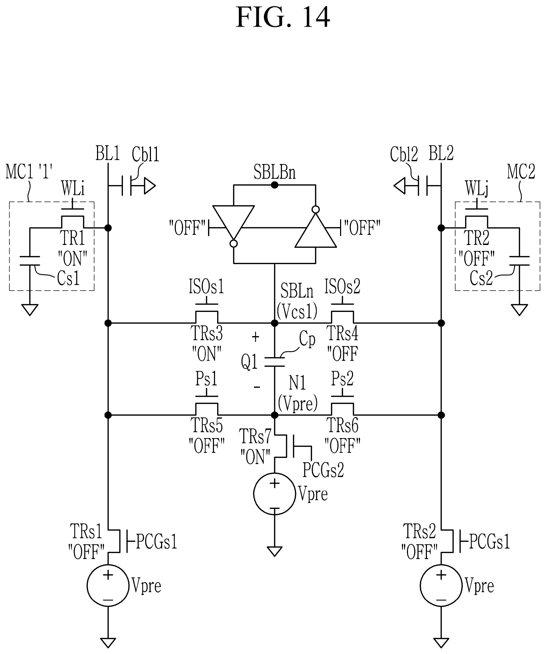

Taking FIG. 14 as an example, the first transistor TR1 is turned on, the first and second switch transistors TRs1, TRs2 and the fourth switch transistor TRs4 are turned off, and a charge sharing operation between the first memory cell MC1 and the first bit line BL1 may be performed. Through the turn-on operation of the first transistor TR1, charge may be shared between the first storage capacitor Cs1, the first bit line capacitor Cbl1, and the pump capacitor Cp. Since the first memory cell MC1 stores '1', which is a "high" level data, charge may be shared from the first storage capacitor Cs1 toward the first bit line capacitor Cbl1 and the pump capacitor Cp. Through the above charge sharing, the voltage of the first bit line BL may be changed to a first charge sharing voltage Vcs1 greater than the precharge voltage Vpre.

During the first charge sharing period Tcs1 after time point t11, a charge sharing operation is performed between the first memory cell MC1 and the first bit line BL1, and the voltage of the first bit line BL1 may vary by a charge sharing voltage difference (dVcs) from the precharge voltage Vpre. The charge sharing voltage difference (dVcs) may be determined by the capacitance of the first storage capacitor Cs1, the capacitance of the first bit line capacitor Cbl1, and the capacitance of the pump capacitor Cp, and according to an embodiment, the lower the capacitance of the first bit line capacitor Cbl1, the larger the charge sharing voltage difference (dVcs). When the first memory cell MC1 stores '1', which is a "high" level data, the voltage of the first bit line BL1 may change from the precharge voltage Vpre to the first charge sharing voltage Vcs1 which is greater than the precharge voltage Vpre. When the first memory cell MC1 stores '0', which is a "low" level data, the voltage of the first bit line BL1 may change from the precharge voltage Vpre to the second charge sharing voltage Vcs2 which is lower than the precharge voltage Vpre.

The charge pump circuit 1612 provides the charge sharing voltage of the bit line BL to the sensing node SBLn of the sense amplifier circuit 1613 based on the charge sharing operation(S130).

The charge pump circuit 1612 may provide the voltage of the bit line BL to the sensing node SBLn of the sense amplifier circuit 1613 during the charge sharing period. The charge sharing voltage applied to the bit line BL through the charge sharing operation may be provided to the sensing node SBLn through the charge pump circuit 1612.

Taking FIG. 14 as an example, the first bit line BL1 and the sensing node SBLn are electrically connected to each other through the turn-on operation of the third switch transistor TRs3, and a charge sharing voltage may be applied to the sensing node SBLn. Since the first memory cell MC1 stores '1', which is a "high" level data, the first charge sharing voltage Vcs1 may be provided to the sensing node SBLn.

During the first charge sharing period Tcs1 after time point t11, the charge pump circuit 1612 provides the voltage of the first bit line BL1 to the sensing node SBLn, and the voltage of the sensing node SBLn may vary depending on the voltage of the first bit line BL1. When the first memory cell MC1 stores '1', which is a "high" level data, the voltage of the sensing node SBLn may change from the precharge voltage Vpre to the first charge sharing voltage Vcs1 together with the voltage of the first bit line BL1. When the first memory cell MC1 stores '0', which is a "low" level data, the voltage of the sensing node SBLn may change from the precharge voltage Vpre to the second charge sharing voltage Vcs2 together with the voltage of the first bit line BL1.

The charge pump circuit 1612 charges the charge based on charge sharing operation(S140).

The charge pump circuit 1612 may provide a charge sharing voltage and a precharge voltage Vpre to both electrodes of the pump capacitor Cp during the charge sharing period. By providing a charge sharing voltage and a precharge voltage Vpre, the pump capacitor Cp may charge during the charge sharing period.

Taking FIG. 14 as an example, a charge sharing voltage is applied to the sensing node SBLn, a precharge voltage Vpre is provided to the first node N1, and the pump capacitor Cp may store the first charge Q1. Since the first memory cell MC1 stores '1', which is a "high" level data, the first electrode of the pump capacitor Cp that receives the first charge sharing voltage Vcs1 greater than the precharge voltage Vpre may become the positive electrode, and the second electrode of the pump capacitor Cp that receives the precharge voltage Vpre may become the negative electrode.

During the first charge sharing period Tcs1 after time point t11, the voltage of the sensing node SBLn fluctuates, and the charge of the pump capacitor Cp may be charged based on the charge sharing voltage of the sensing node SBLn. Therefore, the amount of charge stored in the pump capacitor Cp and the polarity direction of the electrodes within the pump capacitor may be determined by the charge sharing voltage. The amount of charge stored in the pump capacitor Cp may be determined by the size of the charge sharing voltage difference (dVcs). When the first memory cell MC1 stores '1', which is a "high" level data, the voltage of the sensing node SBLn changes to the first charge sharing voltage Vcs1, and the first electrode of the pump capacitor Cp connected to the sensing node SBLn becomes the positive electrode, and the second electrode of the pump capacitor Cp that receives the precharge voltage Vpre becomes the negative electrode. When the first memory cell MC1 stores '0', which is a "low" level data, the voltage of the sensing node SBLn changes to the second charge sharing voltage Vcs2, and the first electrode of the pump capacitor Cp connected to the sensing node SBLn becomes a negative electrode, and the second electrode of the pump capacitor Cp that receives the precharge voltage Vpre becomes a positive electrode.

The charge pump circuit 1612 pumps the charge sharing voltage of the sensing node SBLn to a sensing voltage based on the charged charge(S150).

The charge pump circuit 1612 may pump the charge sharing voltage of the sensing node SBLn to a sensing voltage based on the charge pumped from the pump capacitor Cp during the charge sharing period. The charge pump circuit 1612 may pump the voltage of the sensing node SBLn in a charge pumping manner by controlling the electrical connection to the pump capacitor Cp through a switch transistor within the charge pump circuit 1612.

At time t12, the second precharge control signal PCGs2 may transition from a logic high H level to a logic low L level, the first isolation control signal ISOs1 may transition from a logic high H level to a logic low L level, and the first pumping control signal Ps1 may transition from a logic low L level to a logic high H level.

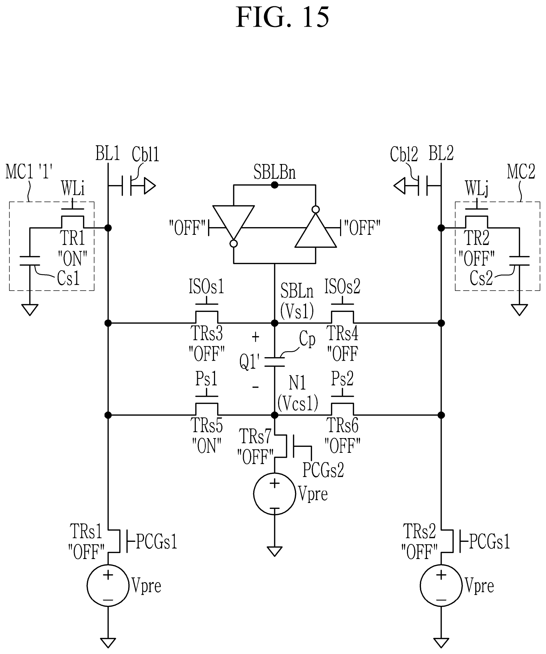

Taking FIG. 15 as an example, the third switch transistor TRs3 and the seventh switch transistor TRs7 are turned off, the fifth switch transistor TRs5 is turned on, and a voltage pumping operation by the pump capacitor Cp may be performed. Through the turn-off operation of the third and seventh switch transistors TRs3, TRs7 and the turn-on operation of the fifth switch transistor TRs5, the charged pump capacitor Cp is connected in series between the first bit line BL1 and the sensing node SBLn, the first charge sharing voltage Vcs1 of the first bit line BL1 is applied to the first node N1, and the voltage at the sensing node SBLn may be pumped from the first charge sharing voltage Vcs1 to the first sensing voltage Vs1. Through the above pumping operation, the charge charged in the pump capacitor Cp may be changed from the first charge Q1 to the first changed charge Q1'.

During the first charge pump period Tcp1 after time point t12, voltage pumping at the sensing node SBLn may be performed using a pump capacitor Cp in a charge pump manner, and the voltage at the sensing node SBLn may vary by a pumping voltage difference (dVp) from the charge sharing voltage. The pumping voltage difference (dVp) may be determined by the charge charged in the pump capacitor Cp, and according to an embodiment, the pumping voltage difference (dVp) may increase as the amount of charge charged in the pump capacitor Cp increases. When the first memory cell MC1 stores '1', which is a "high" level data, the voltage of the sensing node SBLn may change from the first charge sharing voltage Vcs1 to the first sensing voltage Vs1. When the first memory cell MC1 stores '0', which is a "low" level data, the voltage of the sensing node SBLn may change from the second charge sharing voltage Vcs2 to the second sensing voltage Vs2.

The sense amplifier circuit 1613 senses data of the memory cell based on the pumped sensing voltage(S160).

The sense amplifier circuit 1613 may sense data of a memory cell based on the sensing voltage at the sensing node SBLn pumped by the charge pump circuit 1612.

At time t13, the sensing control signal LA may change from the off voltage to the internal power supply voltage VINTA, and the inverted sensing control signal LAB may change from the off voltage to the ground voltage Vgnd.

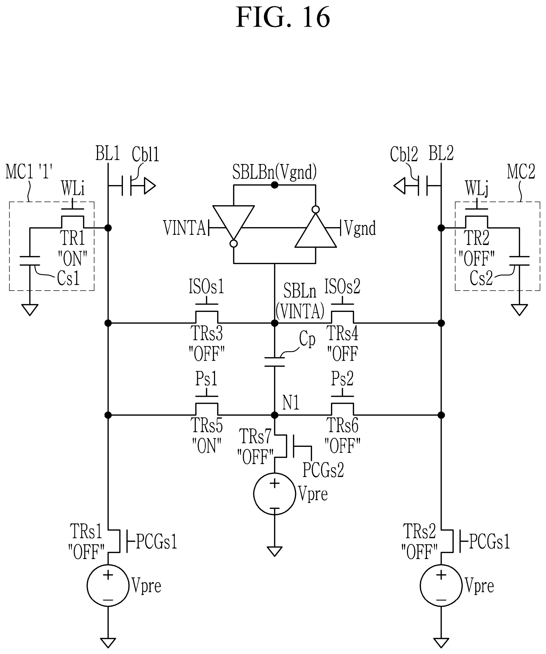

Taking FIG. 16 as an example, the sense amplifier circuit 1613 may be turned on. The sense amplifier circuit 1613 may sense '1', which is a "high" level data, based on the first sensing voltage Vs1 at the sensing node SBLn, amplify the complementary sensing node SBLBn to the level of the ground voltage Vgnd, and amplify the voltage at the sensing node SBLn to the internal power supply voltage VINTA based on the ground voltage Vgnd at the complementary sensing node SBLBn.

During the first sensing period Ts1 after time point t13, the sense amplifier circuit 1613 may perform sensing and amplification operations based on the sensing voltage at the sensing node SBLn. The sense amplifier circuit 1613 may improve the reliability of the sensing operation by performing a sensing operation based on a sensing voltage whose sensing margin is wider than the charge sharing voltage by the pumping voltage difference (dVp). When the first memory cell MC1 stores '1', which is a "high" level data, the sense amplifier circuit 1613 may sense the first sensing voltage Vs1 and amplify the voltage at the sensing node SBLn to the internal power supply voltage VINTA. When the first memory cell MC1 stores '0', which is a "low" level data, the sense amplifier circuit 1613 may sense the second sensing voltage Vs2 and amplify the voltage at the sensing node SBLn to the ground voltage Vgnd.

The sense amplifier circuit 1613 restores the data of the memory cell(S170).

The sense amplifier circuit 1613 may restore data by providing an amplified voltage to the memory cell.

At time t14, the first isolation control signal ISOs1 may transition from a logic low L level to a logic high H level, and the first pumping control signal Ps1 may transition from a logic high H level to a logic low L level.

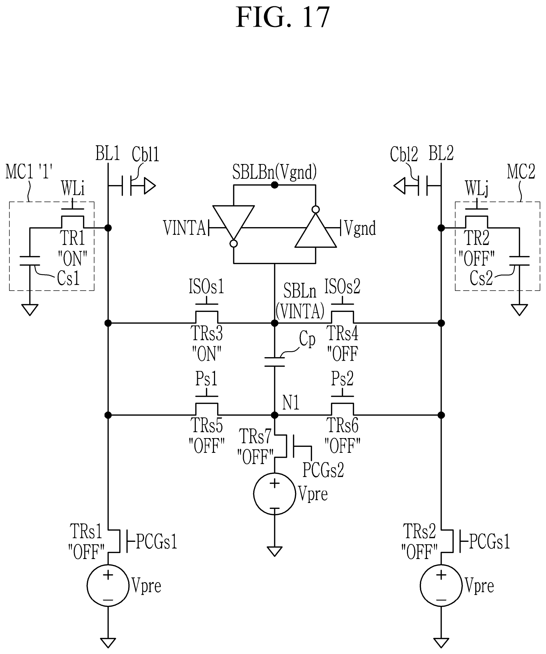

Taking FIG. 17 as an example, the first bit line BL1 and the sensing node SBLn are electrically connected to each other through the turn-on operation of the third switch transistor TRs3, and the sense amplifier circuit 1613 may provide an internal power supply voltage VINTA to the first memory cell MC1 through the first bit line BL1. The first memory cell MC1 may restore '1', which is a high level data, based on the provided internal power supply voltage VINTA.

During the first restorage period Tr1 between time points t14 and t15, the sense amplifier circuit 1613 may provide the amplified voltage at the sensing node SBLn to the first bit line BL1 through the charge pump circuit 1612a. When the first memory cell MC1 stores '1', which is a "high" level data, an internal power supply voltage VINTA is supplied to the first memory cell MC1 through the first bit line BL1, so that the first memory cell MC1 may re-store '1', which is a "high" level data. When the first memory cell MC1 stores '0', which is a "low" level data, a ground voltage Vgnd is provided to the first memory cell MC1 through the first bit line BL1, so that the first memory cell MC1 may re-store '0', which is a "low" level data.

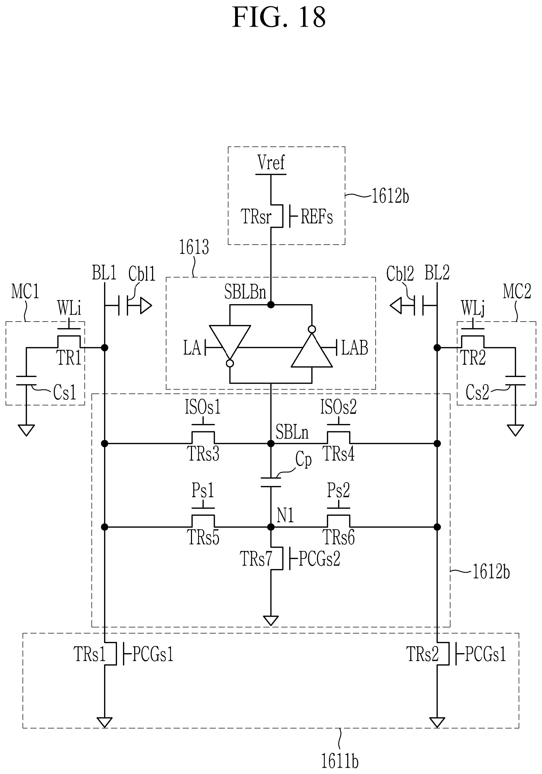

FIG. 18 is a circuit diagram illustrating a bit line sense amplifier according to some embodiments. Specifically, FIG. 18 illustrates a part of an example circuit of the bit line sense amplifier 161 of FIG. 7, and the precharge circuit 1611b and the charge pump circuit 1612b of FIG. 18 are examples of the precharge circuit 1611 and the charge pump circuit 1612 of FIG. 7.

For ease of explanation below or to avoid redundancy, the precharge circuit 1611b and the charge pump circuit 1612b will be described focusing on the differences from the precharge circuit 1611a and the charge pump circuit 1612a of FIG. 8.

Referring to FIG. 7 and FIG. 18, the precharge circuit 1611b may provide a ground voltage as a precharge voltage to the first bit line BL1 and the second bit line BL2 based on the first precharge control signal PCGs1. The precharge circuit 1611b may include first and second switch transistors TRs1, TRs2 and a ground terminal.

The first switch transistor TRs1 may connect the first bit line BL1 and the ground terminal based on the first precharge control signal PCGs1. The second switch transistor TRs2 may connect the second bit line BL2 and the ground terminal based on the first precharge control signal PCGs1.

The charge pump circuit 1612b may further include a ground terminal, a reference voltage switch transistor TRsr, and a reference voltage power source, as compared to the charge pump circuit 1612a of FIG. 8.

The seventh switch transistor TRs7 may connect the first node N1 and the ground terminal based on the second precharge control signal PCGs2, and may provide a ground voltage to the first node N1 based on the second precharge control signal PCGs2.

The reference voltage switch transistor TRsr may connect the complementary sensing node SBLBn of the sense amplifier circuit 1613 and the reference voltage power source based on the reference voltage signal REFs, and provide the reference voltage Vref to the complementary sensing node SBLBn based on the reference voltage signal REFs.

The sense amplifier circuit 1613 may sense data stored in the first memory cell MC1 or data stored in the second memory cell MC2 by performing a sensing and amplification operation based on a comparison between the voltage pumped from the sensing node SBLn and the reference voltage Vref.

The sense amplifier circuit 1613 performs a sensing operation based on the voltage pumped by the charge pump circuit 1612b, so that the bit line sense amplifier 161 may widen the sensing margin and improve the reliability of the sensing operation. In some embodiments, the bit line sense amplifier 161 may improve the operating speed of the sensing operation by widening the sensing margin so that no separate offset removal is required to perform the sensing operation.

The bit line sense amplifier 161 may improve area efficiency and improve the reliability of the sensing operation by performing a voltage pumping operation on the sensing node SBLn connected to the first and second bit lines BL1, BL2 through a charge pump circuit 1612b of a shared structure.

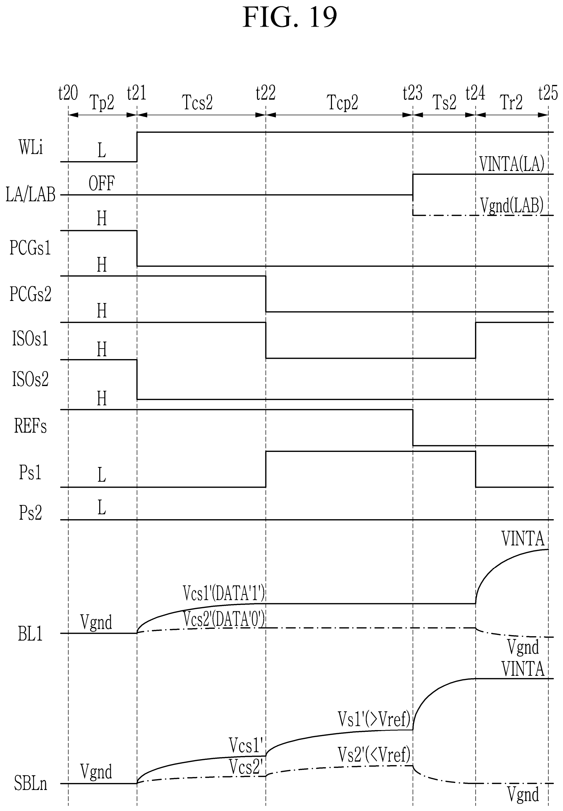

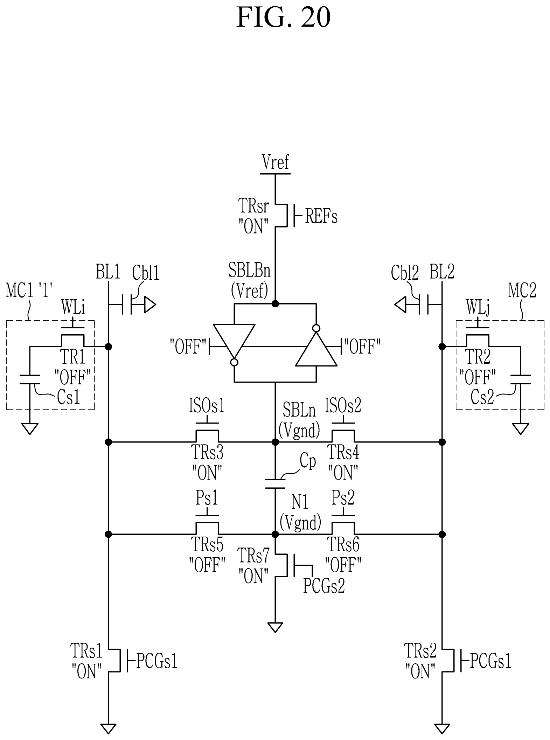

FIG. 19 is a timing diagram illustrating a method of operating a memory device according to some embodiments. FIGS. 20 to 24 are drawings for explaining a method of operating a memory device according to some embodiments.

Specifically, FIGS. 19 to 24 illustrate an operation method of a memory device centered on a process of reading data stored in the first memory cell MC1 of FIG. 18, and for ease of explanation, FIGS. 19 to 24 are used as examples to explain the operation method of the memory device below.

Referring to FIGS. 7, 18, and 19, at time t20, the i-th word line WLi may receive a signal at a logic low L level and be disabled. The sensing control signal pair LA, LAB may be an off voltage, the first precharge control signal PCGs1 may be at a logic high H level, the second precharge control signal PCGs2 may be at a logic high H level, the first isolation control signal ISOs1 may be at a logic high H level, the second isolation control signal ISOs2 may be at a logic high H level, the reference voltage signal REFs may be at a logic high H level, the first pumping control signal Ps1 may be at a logic low L level, and the second pumping control signal Ps2 may be at a logic low L level.

Taking FIG. 20 as an example, the first transistor TR1 may be turned off and the sense amplifier circuit 1613 may be turned off. The first to fourth switch transistors TRs1 to TRs4 may be turned on, the fifth and sixth switch transistors TRs5, TRs6 may be turned off, and the seventh switch transistor TRs7 may be turned on.

During the second precharge period Tp2 after time point t20, a ground voltage Vgnd may be provided to the first bit line BL1 and the second bit line BL2, and a ground voltage Vgnd may be provided to the first node N1. During the second precharge period Tp2, a ground voltage Vgnd may be applied to the sensing node SBLn, and a ground voltage Vgnd may be applied to the first node N1. The second precharge period Tp2 may correspond to step S110 of FIG. 11.

At time t21, the i-th word line WLi may receive a signal at a logic high H level and be activated. The first precharge control signal PCGs1 may transition from a logic high H level to a logic low L level, and the second isolation control signal ISOs2 may transition from a logic high H level to a logic low L level.

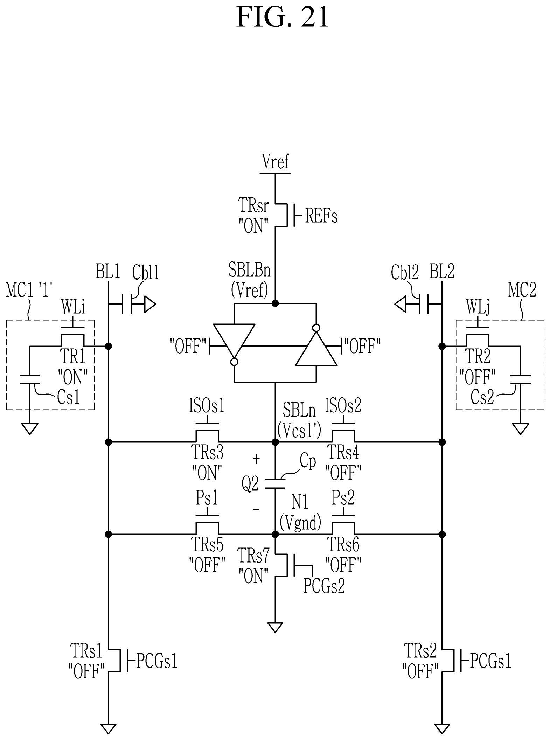

Taking FIG. 21 as an example, the first transistor TR1 is turned on, the first and second switch transistors TRs1, TRs2 and the fourth switch transistor TRs4 are turned off, and a charge sharing operation between the first memory cell MC1 and the first bit line BL1 may be performed. Through the turn-on operation of the first transistor TR1 and the third switch transistor TRs3, charge may be shared between the first storage capacitor Cs1, the first bit line capacitor Cbl1, and the pump capacitor Cp. Since the first memory cell MC1 stores '1', which is a "high" level data, charge may be shared from the first storage capacitor Cs1 toward the first bit line capacitor Cbl1 and the pump capacitor Cp. Through the above charge sharing, the voltage of the first bit line BL and the sensing node SBLn may be changed to the first charge sharing voltage Vcs1'. Since the first charge sharing voltage Vcs1' is applied to the sensing node SBLn and the ground voltage Vgnd is provided to the first node N1, the pump capacitor Cp may store the second charge Q2. Since the first memory cell MC1 stores '1', which is a "high" level data, the first electrode of the pump capacitor Cp that receives the first charge sharing voltage Vcs1' greater than the ground voltage Vgnd may become the positive electrode, and the second electrode of the pump capacitor Cp that receives the ground voltage Vgnd may become the negative electrode.

During the second charge sharing period Tcs2 after time point t21, a charge sharing operation between the first memory cell MC1 and the first bit line BL1 is performed, and the voltage of the first bit line BL1 may change from the ground voltage Vgnd to the charge sharing voltage. The charge sharing voltage may be determined by the data of the first memory cell MC1, the capacitance of the first storage capacitor Cs1, the capacitance of the first bit line capacitor Cbl1, and the capacitance of the pump capacitor Cp. According to an embodiment, even if the data of the first memory cell MC1 is the same, the charge sharing voltage may increase as the capacitance of the first bit line capacitor Cbl1 decreases.

When the first memory cell MC1 stores '1', which is a "high" level data, during the second charge sharing period Tcs2, the voltage of the first bit line BL1 may change from the ground voltage Vgnd to the first charge sharing voltage Vcs1' that is greater than the ground voltage Vgnd. A first charge sharing voltage Vcs1' is provided to the sensing node SBLn, and the charge of the pump capacitor Cp may be charged based on the first charge sharing voltage Vcs1'. When the first memory cell MC1 stores '0', which is a "low" level data, during the second charge sharing period Tcs2, charge sharing may be insufficient, so that the voltage of the first bit line BL1 may fluctuate to a second charge sharing voltage Vcs2' that is substantially equal to the ground voltage Vgnd. A second charge sharing voltage Vcs2' is provided to the sensing node SBLn, and the charge of the pump capacitor Cp may be charged based on the second charge sharing voltage Vcs2'. The second charge sharing period Tcs2 may correspond to steps S120 to S140 of FIG. 11.

At time t22, the second precharge control signal PCGs2 may transition from a logic high H level to a logic low L level, the first isolation control signal ISOs1 may transition from a logic high H level to a logic low L level, and the first pumping control signal Ps1 may transition from a logic low L level to a logic high H level.

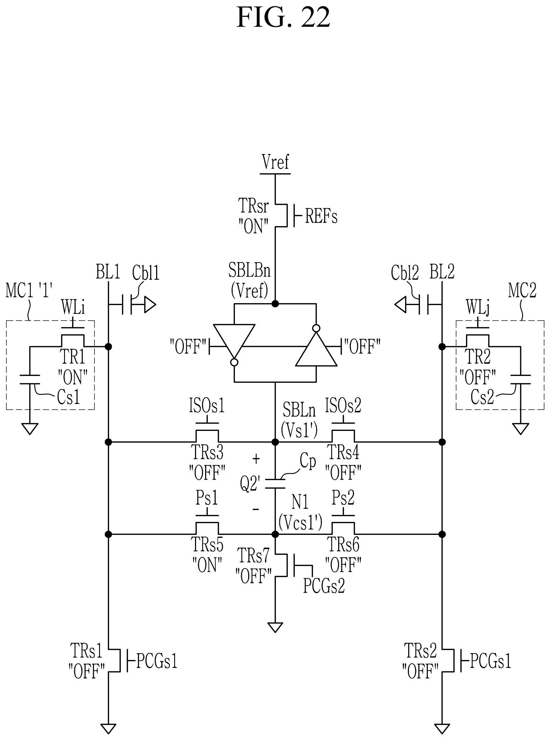

Taking FIG. 22 as an example, the third switch transistor TRs3 and the seventh switch transistor TRs7 are turned off, the fifth switch transistor TRs5 is turned on, and a voltage pumping operation by the pump capacitor Cp may be performed. Through the turn-off operation of the third and seventh switch transistors TRs3, TRs7 and the turn-on operation of the fifth switch transistor TRs5, the charged pump capacitor Cp is connected in series between the first bit line BL1 and the sensing node SBLn, the first charge sharing voltage Vcs1' of the first bit line BL1 is applied to the first node N1, and the voltage at the sensing node SBLn may be pumped from the first charge sharing voltage Vcs1' to the first sensing voltage Vs1'. Through the above pumping operation, the charge charged in the pump capacitor Cp may be changed from the second charge Q2 to the second changed charge Q2'.

During the second charge pump period Tcp2 after time point t22, voltage pumping at the sensing node SBLn may be performed using a pump capacitor Cp in a charge pump manner, and the voltage at the sensing node SBLn may be changed from a charge sharing voltage to a sensing voltage. The sensing voltage may be determined by the charge charged in the pump capacitor Cp, and according to an embodiment, the sensing voltage may increase as the amount of charge charged in the pump capacitor Cp increases. When the first memory cell MC1 stores '1', which is a "high" level data, the voltage of the sensing node SBLn may change from the first charge sharing voltage Vcs1' to the first sensing voltage Vs1'. When the first memory cell MC1 stores '0', which is a "low" level data, the voltage of the sensing node SBLn may change from the second charge sharing voltage Vcs2' to the second sensing voltage Vs2'. The second charge pump period Tcp2 may correspond to step S150 of FIG. 11.

In some embodiments, the voltage difference between the first sensing voltage Vs1' and the second sensing voltage Vs2' may be greater than the voltage difference between the first charge sharing voltage Vcs1' and the second charge sharing voltage Vcs2'. Through voltage pumping for the first and second charge sharing voltages Vcs1', Vcs2' as described above, the first and second sensing voltages Vs1', Vs2' with a wide sensing margin may be applied to the sensing node SBLn of the sense amplifier circuit 1613.

At time t23, the sensing control signal LA may change from the off voltage to the internal power supply voltage VINTA, the inverted sensing control signal LAB may change from the off voltage to the ground voltage Vgnd, and the reference voltage signal REFs may transition from a logic high H level to a logic low L level.

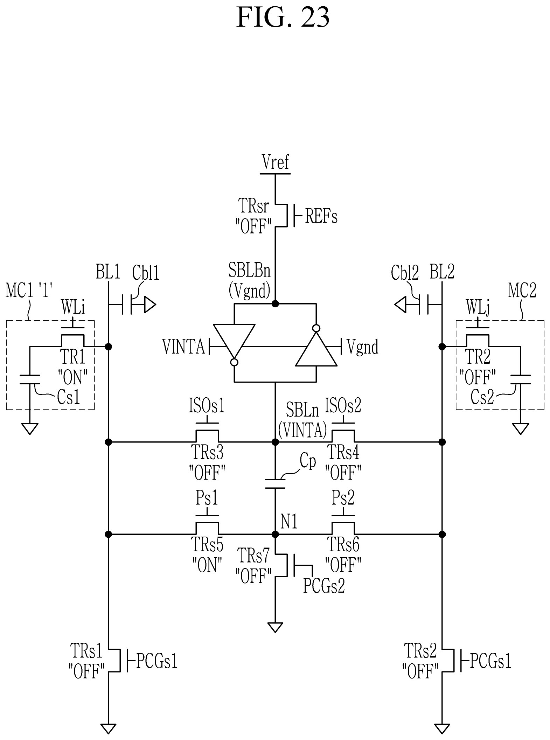

Taking FIG. 23 as an example, the sense amplifier circuit 1613 may be turned on and the reference voltage switch transistor TRsr may be turned off. In response to a first sensing voltage Vs1' greater than a reference voltage Vref, the sense amplifier circuit 1613 may sense '1', which is a "high" level data, and amplifies the complementary sensing node SBLBn to the level of the ground voltage Vgnd, and amplifies the voltage at the sensing node SBLn to the internal power supply voltage VINTA based on the ground voltage Vgnd at the complementary sensing node SBLBn.

During the second sensing period Ts2 after the time point t23, the sense amplifier circuit 1613 may perform sensing and amplification operations based on a comparison between the sensing voltage at the sensing node SBLn and the reference voltage Vref. The sense amplifier circuit 1613 may improve the reliability of the sensing operation by performing a sensing operation based on a sensing voltage with a wider sensing margin than the charge sharing voltage. When the first memory cell MC1 stores '1', which is a "high" level data, the sense amplifier circuit 1613 may sense a first sensing voltage Vs1' greater than the reference voltage Vref and amplify the voltage at the sensing node SBLn to an internal power supply voltage VINTA. When the first memory cell MC1 stores '0', which is a "low" level data, the sense amplifier circuit 1613 may sense a second sensing voltage Vs2' that is lower than the reference voltage Vref and amplify the voltage at the sensing node SBLn to the ground voltage Vgnd. The second sensing period Ts2 may correspond to step S160 of FIG. 11.

At time t24, the first isolation control signal ISOs1 may transition from a logic low L level to a logic high H level, and the first pumping control signal Ps1 may transition from a logic high H level to a logic low L level.

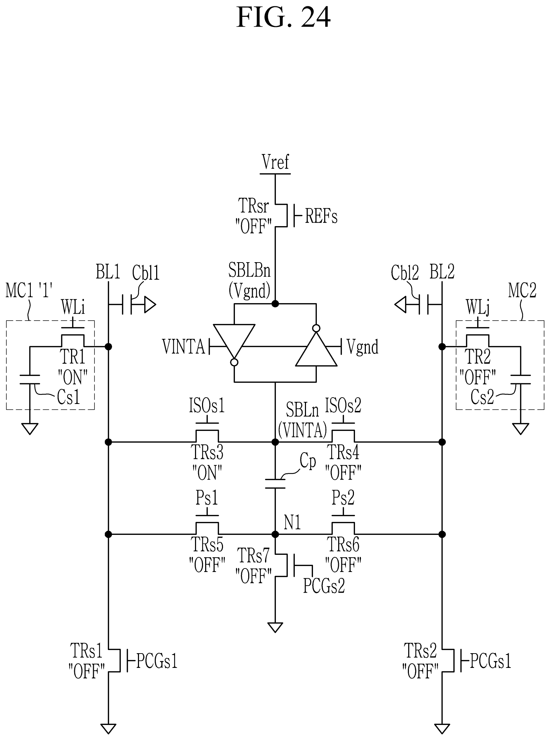

Taking FIG. 24 as an example, the first bit line BL1 and the sensing node SBLn are electrically connected to each other through the turn-on operation of the third switch transistor TRs3, and the sense amplifier circuit 1613 may provide an internal power supply voltage VINTA to the first memory cell MC1 through the first bit line BL1. The first memory cell MC1 may restore '1', which is a high level data, based on the provided internal power supply voltage VINTA.

During the second restorage period Tr2 between time points t24 and t25, the sense amplifier circuit 1613 may provide the amplified voltage at the sensing node SBLn to the first bit line BL1 through the charge pump circuit 1612b. When the first memory cell MC1 stores '1', which is a "high" level data, an internal power supply voltage VINTA is supplied to the first memory cell MC1 through the first bit line BL1, so that the first memory cell MC1 may re-store '1', which is a "high" level data. When the first memory cell MC1 stores '0', which is a "low" level data, a ground voltage Vgnd is provided to the first memory cell MC1 through the first bit line BL1, so that the first memory cell MC1 may re-store '0', which is a "low" level data. The second restorage period Tr2 may correspond to step S170 of FIG. 11.

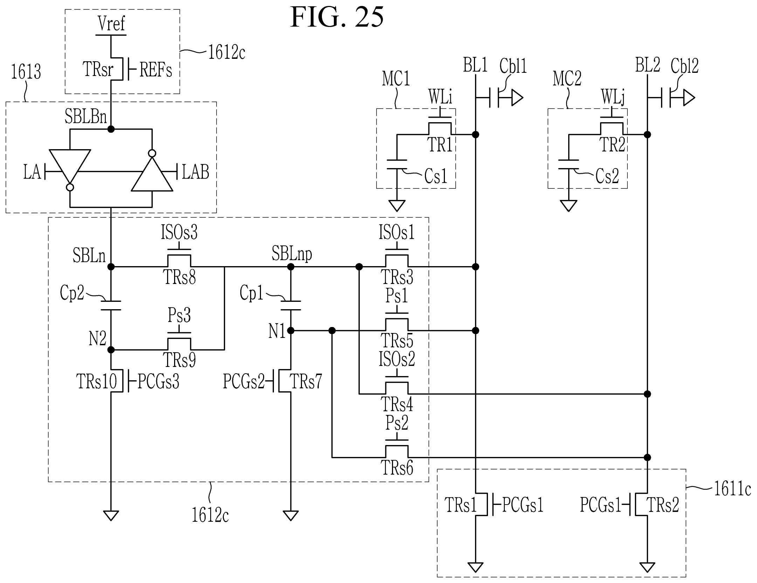

FIG. 25 is a circuit diagram illustrating a bit line sense amplifier according to some embodiments. Specifically, FIG. 25 illustrates a part of an example circuit of the bit line sense amplifier 161 of FIG. 7, and the precharge circuit 1611c and the charge pump circuit 1612c of FIG. 25 are examples of the precharge circuit 1611 and the charge pump circuit 1612 of FIG. 7.

For ease of explanation below or to avoid redundancy, the precharge circuit 1611c and the charge pump circuit 1612c will be described focusing on the differences from the precharge circuit 1611b and the charge pump circuit 1612b of FIG. 18.

Referring to FIG. 7 and FIG. 25, compared to the charge pump circuit 1612b of FIG. 18, the charge pump circuit 1612c includes two pump capacitors Cp1, Cp2 and may perform two voltage pumping operations in performing a lead operation. Additionally, the charge pump circuit 1612c may further include eighth to tenth switch transistors TRs8 to TRs10 compared to the charge pump circuit 1612b of FIG. 18.

The first pump capacitor Cp1 may include a first electrode electrically connected to the preliminary sensing node SBLnp and a second electrode electrically connected to a first node N1 different from the preliminary sensing node SBLnp. The second pump capacitor Cp2 may include a first electrode electrically connected to a sensing node SBLn, which is an input node of the sense amplifier circuit 1613, and a second electrode electrically connected to a second node N2 different from the sensing node SBLn. According to some embodiments, the first and second pump capacitors Cp1, Cp2 may comprise at least a portion of the conductive wiring or at least a portion of the circuit elements disposed in the peripheral circuit area PS of FIG. 3. The first and second pump capacitors Cp1, Cp2 may include a MIM capacitor, a MOS capacitor, etc.

The third switch transistor TRs3 may connect the preliminary sensing node SBLnp and the first bit line BL1 based on the first isolation control signal ISOs1. The fourth switch transistor TRs4 may connect the preliminary sensing node SBLnp and the second bit line BL2 based on the second isolation control signal ISOs2. The fifth switch transistor TRs5 may connect the first node N1 and the first bit line BL1 based on the first pumping control signal Ps1. The sixth switch transistor TRs6 may connect the first node N1 and the second bit line BL2 based on the second pumping control signal Ps2.

The eighth switch transistor TRs8 may connect the preliminary sensing node SBLnp and the sensing node SBLn based on the third isolation control signal ISOs3. The ninth switch transistor TRs9 may connect the preliminary sensing node SBLnp and the second node N2 based on the third pumping control signal Ps3. The tenth switch transistor TRs10 may connect the second node N2 and the ground terminal based on the third precharge control signal PCGs3, and may provide a ground voltage to the second node N2 based on the third precharge control signal PCGs3.

In some embodiments, the eighth to tenth switch transistors TRs8 to TRs10 may be NMOS transistors.

Although the charge pump circuit 1612c is illustrated as including two pump capacitors, the present disclosure is not limited thereto. In some embodiments, the charge pump circuit 1612c may further include three or more pump capacitors, and the charge pump circuit 1612c may perform the plurality of voltage pumping operations corresponding to the number of pump capacitors.

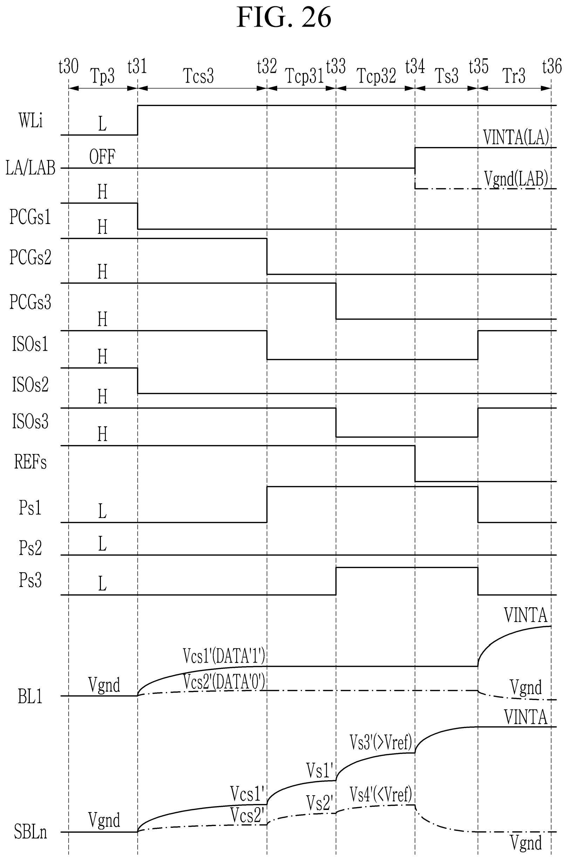

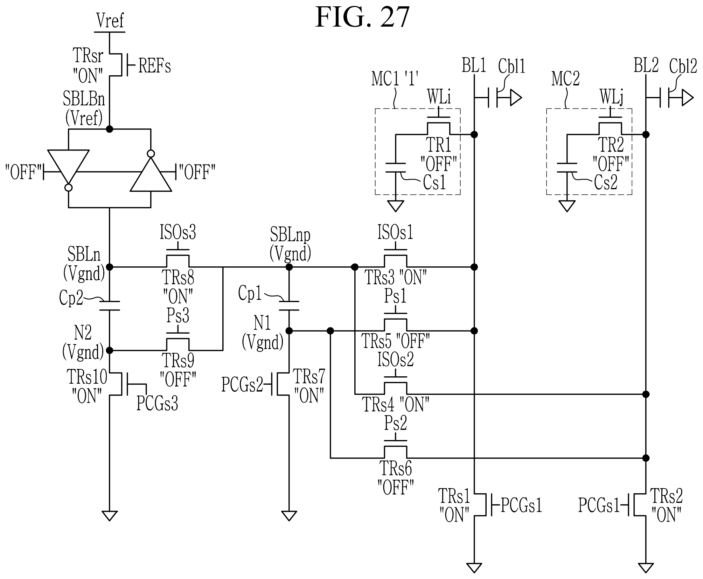

FIG. 26 is a timing diagram illustrating a method of operating a memory device according to some embodiments. FIGS. 27 to 32 are drawings for explaining a method of operating a memory device according to some embodiments.

Specifically, FIGS. 26 to 32 illustrate an operation method of a memory device centered on a process of reading data stored in the first memory cell MC1 of FIG. 25, and for ease of explanation, FIGS. 26 to 32 are used as examples to explain the operation method of the memory device below.

Referring to FIG. 7, FIG. 25, and FIG. 26, at time t30, the i-th word line WLi may receive a signal at a logic low L level and be disabled. The sensing control signal pair LA, LAB may be an off voltage, the first precharge control signal PCGs1 may be at a logic high H level, the second precharge control signal PCGs2 may be at a logic high H level, the third precharge control signal PCGs3 may be at a logic high H level, the first isolation control signal ISOs1 may be at a logic high H level, the second isolation control signal ISOs2 may be at a logic high H level, the third isolation control signal ISOs3 may be at a logic high H level, the reference voltage signal REFs may be at a logic high H level, the first pumping control signal Ps1 may be at a logic low L level, the second pumping control signal Ps2 may be at a logic low L level, and the third pumping control signal Ps3 may be at a logic low L level.

Taking FIG. 27 as an example, the first transistor TR1 may be turned off and the sense amplifier circuit 1613 may be turned off. The first to fourth switch transistors TRs1 to TRs4 may be turned on, the fifth and sixth switch transistors TRs5, TRs6 may be turned off, and the seventh switch transistor TRs7 may be turned on. The eighth switch transistor TRs8 and the tenth switch transistor TRs10 may be turned on, and the ninth switch transistor TRs9 may be turned off. A ground voltage Vgnd may be applied as a precharge voltage for a read operation to the first bit line BL1 and the second bit line BL2, a ground voltage Vgnd may be applied to the sensing node SBLn and the preliminary sensing node SBLnp, and a ground voltage Vgnd may be applied to the first node N1 and the second node N2.

During the third precharge period Tp3 after the time point t30, a ground voltage Vgnd may be provided to the first bit line BL1 and the second bit line BL2, and a ground voltage Vgnd may be provided to the first node N1 and the second node N2. During the third precharge period Tp3, a ground voltage Vgnd may be applied to the sensing node SBLn and the preliminary sensing node SBLnp, and a ground voltage Vgnd may be applied to the first node N1 and the second node N2. The third precharge period Tp3 may correspond to step S110 of FIG. 11.

At time t31, the i-th word line WLi may receive a signal of logic high H level and be activated. The first precharge control signal PCGs1 may transition from a logic high H level to a logic low L level, and the second isolation control signal ISOs2 may transition from a logic high H level to a logic low L level.

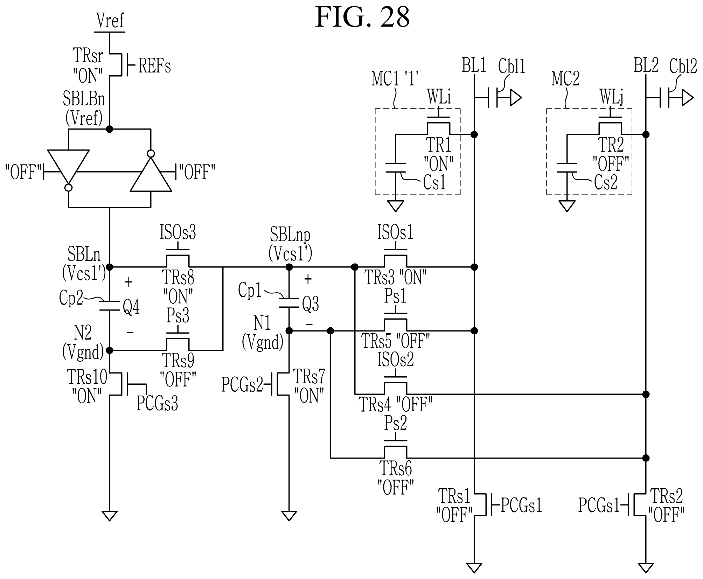

Taking FIG. 28 as an example, the first transistor TR1 is turned on, the first and second switch transistors TRs1, TRs2 and the fourth switch transistor TRs4 are turned off, and a charge sharing operation between the first memory cell MC1 and the first bit line BL1 may be performed. Through the turn-on operation of the first transistor TR1, the third switch transistor TRs3, and the eighth switch transistor TRs8, charge may be shared between the first storage capacitor Cs1, the first bit line capacitor Cbl1, and the first and second pump capacitors Cp1, Cp2. Since the first memory cell MC1 stores '1', which is a "high" level data, charge may be shared from the first storage capacitor Cs1 toward the first bit line capacitor Cbl1 and the first and second pump capacitors Cp1, Cp2. Through the above charge sharing, the voltages of the first bit line BL, the preliminary sensing node SBLnp, and the sensing node SBLn may be changed to the first charge sharing voltage Vcs1'. Since the first charge sharing voltage Vcs1' is applied to the preliminary sensing node SBLnp and the ground voltage Vgnd is provided to the first node N1, the first pump capacitor Cp1 may store the third charge Q3. Since the first charge sharing voltage Vcs1' is applied to the sensing node SBLn and the ground voltage Vgnd is provided to the second node N2, the second pump capacitor Cp2 may store the fourth charge Q4. Since the first memory cell MC1 stores '1', which is a "high" level data, the first electrode of the first and second pump capacitors Cp1, Cp2 that receive the first charge sharing voltage Vcs1' greater than the ground voltage Vgnd may become the positive electrode, and the second electrode of the first and second pump capacitors Cp1, Cp2 that receive the ground voltage Vgnd may become the negative electrode.

During the third charge sharing period Tcs3 after time point t31, a charge sharing operation between the first memory cell MC1 and the first bit line BL1 is performed, and the voltage of the first bit line BL1 may change from the ground voltage Vgnd to the charge sharing voltage. The charge sharing voltage may be determined by the data of the first memory cell MC1, the capacitance of the first storage capacitor Cs1, the capacitance of the first bit line capacitor Cbl1, and the capacitances of the first and second pump capacitors Cp1, Cp2. According to an embodiment, even if the data of the first memory cell MC1 is the same, the charge sharing voltage may increase as the capacitance of the first bit line capacitor Cbl1 decreases.

When the first memory cell MC1 stores '1', which is a "high" level data, during the third charge sharing period Tcs3, the voltage of the first bit line BL1 may change from the ground voltage Vgnd to the first charge sharing voltage Vcs1' that is greater than the ground voltage Vgnd. A first charge sharing voltage Vcs1' is provided to the sensing node SBLn and the auxiliary sensing node SBLnp, and the charges of the first and second pump capacitors Cp1, Cp2 may be charged based on the first charge sharing voltage Vcs1'. When the first memory cell MC1 stores '0', which is a "low" level data, during the third charge sharing period Tcs3, charge sharing may be insufficient, so that the voltage of the first bit line BL1 may fluctuate to a second charge sharing voltage Vcs2' that is substantially equal to the ground voltage Vgnd. A second charge sharing voltage Vcs2' is provided to the sensing node SBLn and the auxiliary sensing node SBLnp, and the charges of the first and second pump capacitors Cp1, Cp2 may be charged based on the second charge sharing voltage Vcs2'. The third charge sharing period Tcs3 may correspond to steps S120 to S140 of FIG. 11.

At time t32, the second precharge control signal PCGs2 may transition from a logic high H level to a logic low L level, the first isolation control signal ISOs1 may transition from a logic high H level to a logic low L level, and the first pumping control signal Ps1 may transition from a logic low L level to a logic high H level.

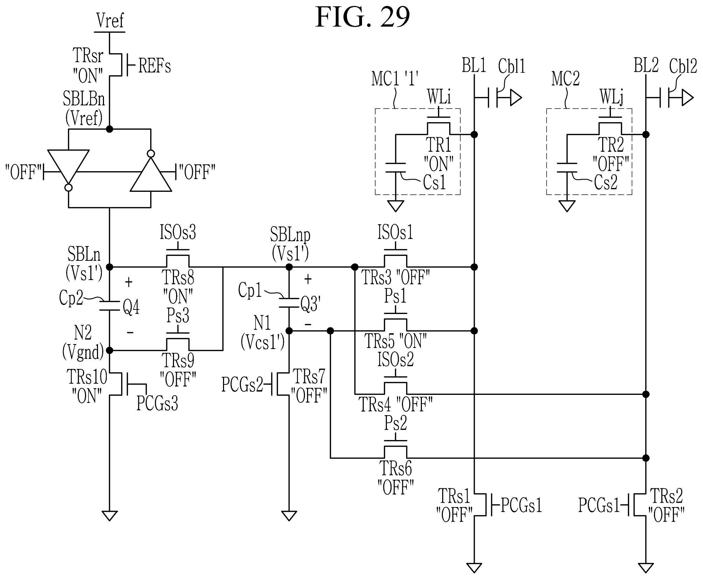

Taking FIG. 29 as an example, the third switch transistor TRs3 and the seventh switch transistor TRs7 are turned off, the fifth switch transistor TRs5 is turned on, and a voltage pumping operation by the first pump capacitor Cp1 may be performed. Through the turn-off operation of the third and seventh switch transistors TRs3, TRs7 and the turn-on operation of the fifth switch transistor TRs5, the charged first pump capacitor Cp1 is connected in series between the first bit line BL1 and the preliminary sensing node SBLnp, the first charge sharing voltage Vcs1' of the first bit line BL1 is applied to the first node N1, and the voltage at the preliminary sensing node SBLnp and the sensing node SBLn may be pumped from the first charge sharing voltage Vcs1' to the first sensing voltage Vs1'. Through the above pumping operation, the charge charged in the first pump capacitor Cp1 may be changed from the third charge Q3 to the third changed charge Q3'.

During the 3_1 charge pump period Tcp31 after time point t32, voltage pumping at the preliminary sensing node SBLnp and the sensing node SBLn may be performed using the first pump capacitor Cp1 in a charge pump manner, and the voltages at the preliminary sensing node SBLnp and the sensing node SBLn may be changed from the charge sharing voltage to the preliminary sensing voltage. The preliminary sensing voltage may be determined by the charge charged in the first pump capacitor Cp1, and according to an embodiment, the larger the charge charged in the first pump capacitor Cp1, the larger the preliminary sensing voltage may be. When the first memory cell MC1 stores '1', which is a "high" level data, the voltage of the preliminary sensing node SBLnp and the sensing node SBLn may change from the first charge sharing voltage Vcs1' to the first sensing voltage Vs1'. When the first memory cell MC1 stores '0', which is a "low" level data, the voltage of the preliminary sensing node SBLnp and the sensing node SBLn may change from the second charge sharing voltage Vcs2' to the second sensing voltage Vs2'. The 3_1 charge pump period Tcp31 may correspond to step S150 of FIG. 11.

At time t33, the third precharge control signal PCGs3 may transition from a logic high H level to a logic low L level, the third isolation control signal ISOs3 may transition from a logic high H level to a logic low L level, and the third pumping control signal Ps3 may transition from a logic low L level to a logic high H level.

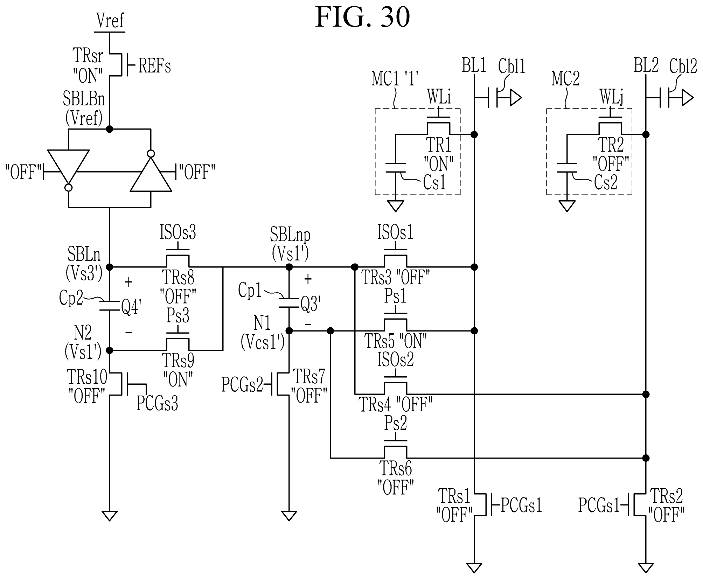

Taking FIG. 30 as an example, the eighth switch transistor TRs8 and the 10th switch transistor TRs10 are turned off, the ninth switch transistor TRs9 is turned on, and a voltage pumping operation by the second pump capacitor Cp2 may be performed. Through the turn-off operation of the eighth and tenth switch transistors TRs8, TRs10 and the turn-on operation of the ninth switch transistor TRs9, the charged second pump capacitor Cp2 is connected in series between the preliminary sensing node SBLnp and the sensing node SBLn, and the first sensing voltage Vs1' of the preliminary sensing node SBLnp is applied to the second node N2, and the voltage at the sensing node SBLn may be pumped from the first sensing voltage Vs1' to the third sensing voltage Vs3'. Through the above pumping operation, the charge charged in the second pump capacitor Cp2 may be changed from the fourth charge Q4 to the fourth changed charge Q4'.

During the 3_2 charge pump period Tcp32 after the t33 time point, voltage pumping at the sensing node SBLn may be performed using the second pump capacitor Cp2 in a charge pump manner, and the voltage of the sensing node SBLn may be changed from the preliminary sensing voltage to the sensing voltage. The sensing voltage may be determined by the charge charged in the first and second pump capacitors Cp1, Cp2, and according to an embodiment, the sensing voltage may increase as the amount of charge charged in the first and second pump capacitors Cp1, Cp2 increases. When the first memory cell MC1 stores '1', which is a "high" level data, the voltage of the sensing node SBLn may change from the first sensing voltage Vs1' to the third sensing voltage Vs3'. When the first memory cell MC1 stores '0', which is a "low" level data, the voltage of the sensing node SBLn may change from the second sensing voltage Vs2' to the fourth sensing voltage Vs4'. The 3_2 charge pump period Tcp32 may correspond to step S150 of FIG. 11.

In some embodiments, the voltage difference between the third sensing voltage Vs3' and the fourth sensing voltage Vs4' may be greater than the voltage difference between the first charge sharing voltage Vcs1' and the second charge sharing voltage Vcs2'. Through the plurality of voltage pumpings for the first and second charge sharing voltages Vcs1', Vcs2' as described above, third and fourth sensing voltages Vs3', Vs4' having a wide sensing margin may be applied to the sensing node SBLn of the sense amplifier circuit 1613.

At time t34, the sensing control signal LA may change from the off voltage to the internal power supply voltage VINTA, the inverted sensing control signal LAB may change from the off voltage to the ground voltage Vgnd, and the reference voltage signal REFs may transition from a logic high H level to a logic low L level.

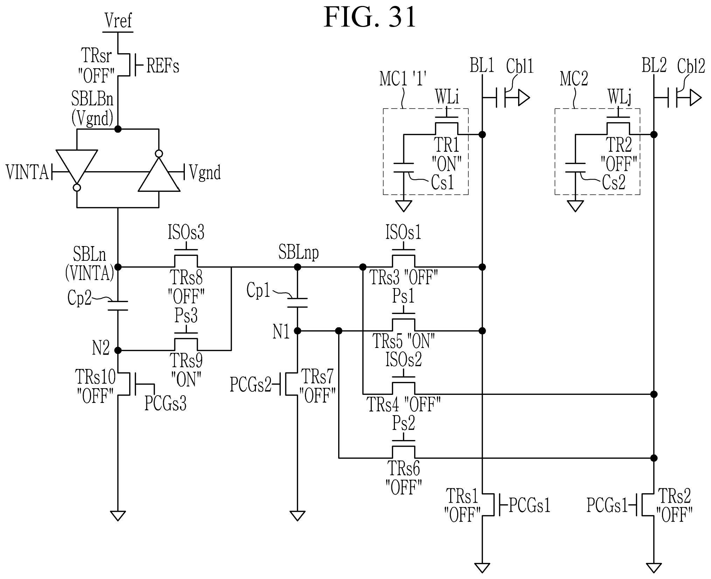

Taking FIG. 31 as an example, the sense amplifier circuit 1613 may be turned on and the reference voltage switch transistor TRsr may be turned off. In response to a third sensing voltage Vs3' greater than the reference voltage Vref, the sense amplifier circuit 1613 sense '1', which is a "high" level data, and amplifies the complementary sensing node SBLBn to the level of the ground voltage Vgnd, and amplifies the voltage at the sensing node SBLn to the internal power supply voltage VINTA based on the ground voltage Vgnd at the complementary sensing node SBLBn.

During the third sensing period Ts3 after the time point t34, the sense amplifier circuit 1613 may perform sensing and amplification operations based on a comparison between the sensing voltage at the sensing node SBLn and the reference voltage Vref. The sense amplifier circuit 1613 may improve the reliability of the sensing operation by performing a sensing operation based on a sensing voltage with a wider sensing margin than the charge sharing voltage. When the first memory cell MC1 stores '1', which is a "high" level data, the sense amplifier circuit 1613 may sense a third sensing voltage Vs3' greater than the reference voltage Vref and amplify the voltage at the sensing node SBLn to an internal power supply voltage VINTA. When the first memory cell MC1 stores '0', which is a "low" level data, the sense amplifier circuit 1613 may sense a fourth sensing voltage Vs4' that is lower than the reference voltage Vref and amplify the voltage at the sensing node SBLn to the ground voltage Vgnd. The third sensing period Ts3 may correspond to step S160 of FIG. 11.

At time t35, the first and third isolation control signals ISOs1, ISOs3 may transition from a logic low L level to a logic high H level, and the first and third pumping control signals Ps1, Ps3 may transition from a logic high H level to a logic low L level.

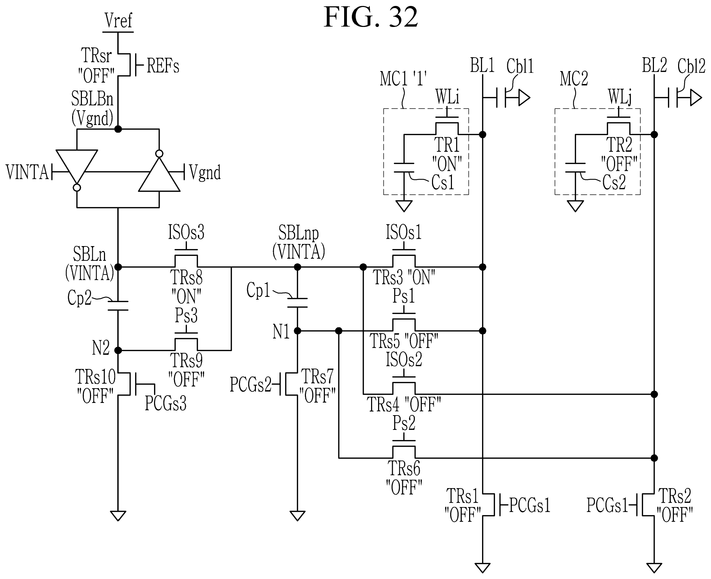

Taking FIG. 32 as an example, the first bit line BL1 and the sensing node SBLn are electrically connected to each other through the turn-on operation of the third switch transistor TRs3 and the eighth switch transistor TRs8, and the sense amplifier circuit 1613 may provide an internal power supply voltage VINTA to the first memory cell MC1 through the first bit line BL1. The first memory cell MC1 may restore '1', which is a high level data, based on the provided internal power supply voltage VINTA.

During the third restorage period Tr3 between time points t35 and t36, the sense amplifier circuit 1613 may provide the amplified voltage at the sensing node SBLn to the first bit line BL1 through the charge pump circuit 1612c. When the first memory cell MC1 stores '1', which is a "high" level data, an internal power supply voltage VINTA is supplied to the first memory cell MC1 through the first bit line BL1, so that the first memory cell MC1 may re-store '1', which is a "high" level data. When the first memory cell MC1 stores '0', which is a "low" level data, a ground voltage Vgnd is provided to the first memory cell MC1 through the first bit line BL1, so that the first memory cell MC1 may re-store '0', which is a "low" level data. The third restorage period Tr3 may correspond to step S170 of FIG. 11.

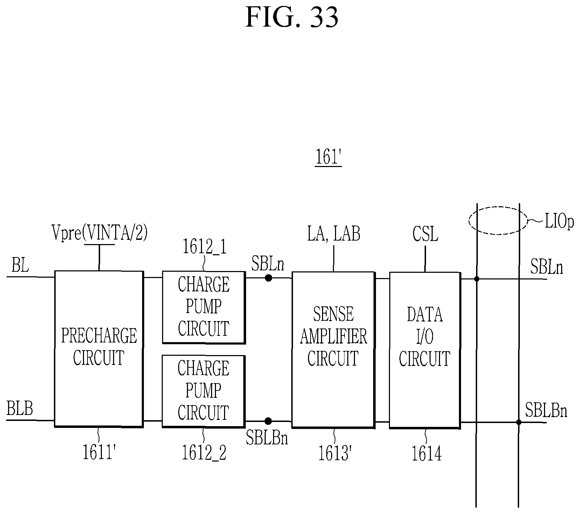

FIG. 33 is a block diagram illustrating a bit line sense amplifier according to some embodiments. Each of the bit line sense amplifier 161', precharge circuit 1611', first and second charge pump circuits 1612_1, 1612_2, sense amplifier circuit 1613', and data input/output circuit 1614 of FIG. 33 may correspond to each of the bit line sense amplifier 161, precharge circuit 1611, charge pump circuit 1612, sense amplifier circuit 1613, and data input/output circuit 1614 of FIG. 8. For ease of explanation below or to avoid redundancy, the bit line sense amplifier 161', precharge circuit 1611', first and second charge pump circuits 1612_1, 1612_2, sense amplifier circuit 1613', and data input/output circuit 1614 of FIG. 8 will be described with a focus on differences therebetween.

Referring to FIG. 33, the bit line sense amplifier 161' may include a precharge circuit 1611', first and second charge pump circuits 1612_1, 1612_2, a sense amplifier circuit 1613', and a data input/output circuit 1614. The bit line sense amplifier 161' may include a sense amplifier circuit 1613' which is a differential sense amplifier circuit.

The precharge circuit 1611' may precharge a bit line BL and a complementary bit line BLB, which are a bit line pair connected to the bit line sense amplifier 161', to a precharge voltage Vpre in response to a precharge control signal. According to some embodiments, the voltage level of the precharge voltage Vpre may be half the voltage level of the internal power supply voltage VINTA.

The bit line BL may be one of the bit lines connected to the bit line sense amplifier 161'. The complementary bit line BLB may be a bit line different from the bit line BL connected to the bit line sense amplifier 161'.

According to an embodiment, the precharge circuit 1611' may include a precharge voltage source and a switch transistor. The above switch transistor is connected in series between a bit line pair BL, BLB and a precharge voltage source, and may provide a precharge voltage Vpre to the bit line pair BL, BLB based on a precharge control signal.

The first charge pump circuit 1612_1 is connected between the bit line BL and the sense amplifier circuit 1613', and the bit line BL may be connected to the sensing node SBLn, which is an input node of the sense amplifier circuit 1613', through the first charge pump circuit 1612_1. The second charge pump circuit 1612_2 is connected between the complementary bit line BLB and the sense amplifier circuit 1613', and the complementary bit line BLB may be connected to the complementary sensing node SBLBn, which is an input node of the sense amplifier circuit 1613', through the second charge pump circuit 1612_2.

The first charge pump circuit 1612_1 stores a certain amount of charge through a charge sharing operation between a bit line BL and a memory cell MC, and may pump the voltage of the sensing node SBLn in a charge pump manner based on the stored charge.

The first charge pump circuit 1612_1 may include a pump capacitor storing a certain amount of charge and a plurality of switch transistors. A pump capacitor may store a certain amount of charge through charge sharing between a bit line BL and a memory cell MC.

The amount of charge stored in the pump capacitor or the polarity of the electrode within the pump capacitor may be changed based on the charge sharing voltage applied to the bit line BL through the charge sharing operation. In some embodiments, the magnitude of the charge stored in the pump capacitor or the polarity of the electrodes within the pump capacitor may vary depending on the data stored in the memory cell MC. For example, when the data stored in the memory cell MC is '1', the polarity direction of the electrodes inside the pump capacitor charged through charge sharing may be opposite to each other, and when the data stored in the memory cell MC is '0', the polarity direction of the electrodes inside the pump capacitor charged through charge sharing may be opposite to each other.

A plurality of switch transistors may control the connection relationship between the bit line BL, the sense amplifier circuit 1613', and the pump capacitor. To illustrate, in an operation of pumping the voltage of the sensing node SBLn, the first charge pump circuit 1612_1 may connect a charged pump capacitor in series between the bit line BL and the sensing node SBLn of the sense amplifier circuit 1613' through a plurality of switch transistors.

The number of pump capacitors may vary depending on the embodiment. In some embodiments, in the read operation of the bit line sense amplifier 161', the first charge pump circuit 1612_1 may determine the number of pumping operations based on the number of pump capacitors. For example, if the first charge pump circuit 1612_1 includes two pump capacitors, the voltage of the sensing node SBLn may be pumped twice before the sensing operation of the sense amplifier circuit 1613'.

The second charge pump circuit 1612_2 may operate complementarily with the first charge pump circuit 1612_1 when the bit line sense amplifier 161' performs a read operation. While the first charge pump circuit 1612_1 stores charge and performs a pumping operation based on the stored charge, the second charge pump circuit 1612_2 may provide a precharge voltage Vpre to the complementary sensing node SBLBn.

The second charge pump circuit 1612_2 has a structure corresponding to the first charge pump circuit 1612_1 and may include a pump capacitor storing a certain amount of charge and a plurality of switch transistors. While the first charge pump circuit 1612_1 stores charges and performs a pumping operation based on the stored charges, a plurality of switch transistors within the second charge pump circuit 1612_2 may maintain an electrical connection between the pump capacitor and the complementary bit line BLB within the second charge pump circuit 1612_2.

The sense amplifier circuit 1613' is a differential sense amplifier circuit and may be electrically connected to a bit line BL through a sensing node SBLn and electrically connected to a complementary bit line BLB through a complementary sensing node SBLBn. The sense amplifier circuit 1613' may sense data by sensing and amplifying the voltage difference between the sensing node SBLn and the complementary sensing node SBLBn based on a pair of sensing control signals LA, LAB. According to some embodiments, the sense amplifier circuit 1613 may include a first sense amplifier circuit and a second sense amplifier circuit, each connected to a sensing node SBLn and a complementary sensing node SBLBn, respectively. The above first sense amplifier circuit is connected in series between the sensing node SBLn and the complementary sensing node SBLBn, and sense "low" level data at one node of the sensing node SBLn and the complementary sensing node SBLBn based on the sensing control signal LA and amplifies the other node to the level of the internal power supply voltage VINTA. The second sense amplifier circuit is connected in series between the sensing node SBLn and the complementary sensing node SBLBn, and sense "high" level data at one node of the sensing node SBLn and the complementary sensing node SBLBn based on the inverted sensing control signal LAB and amplifies the other node to the level of the ground voltage.

In some embodiments, the sense amplifier circuit 1613' performs a sensing operation based on the voltage pumped by the first charge pump circuit 1612_1, so that the bit line sense amplifier 161' may widen the sensing margin and improve the reliability of the sensing operation.

In some embodiments, the first charge pump circuit 1612_1 may pump the voltage at the sensing node SBLn in a charge pump manner using a pump capacitor, thereby pumping the voltage at the sensing node SBLn without using a transistor or the like. Through voltage pumping using the charge pump method as described above, the first charge pump circuit 1612_1 may pump the voltage at the sensing node SBLn without being affected by the offset due to process dispersion or the size of the common mode voltage.

In some embodiments, the bit line sense amplifier 161' may improve the operating speed of the sensing operation by widening the sensing margin so that no separate offset removal is required to perform the sensing operation.

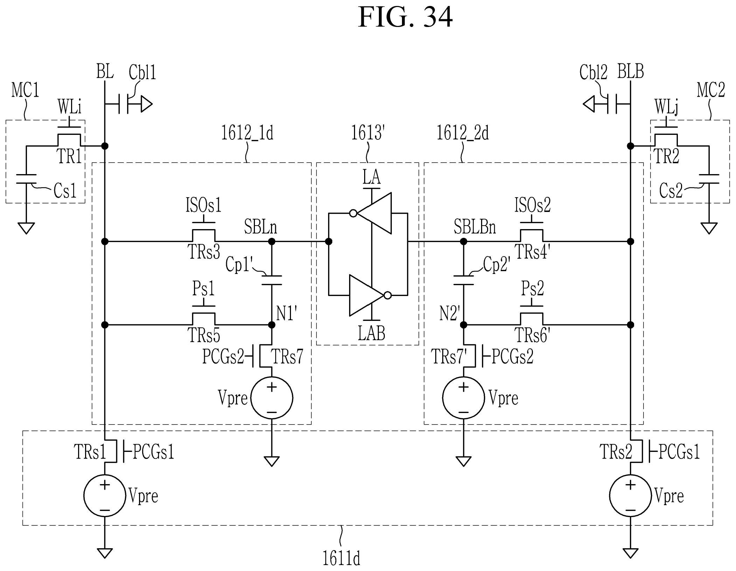

FIG. 34 is a circuit diagram illustrating a bit line sense amplifier according to some embodiments. Specifically, FIG. 34 illustrates a part of an example circuit of the bit line sense amplifier 161' of FIG. 33, and each of the precharge circuit 1611d and the first and second charge pump circuits 1612_1d, 1612_2d of FIG. 34 is an example of the precharge circuit 1611' and the first and second charge pump circuits 1612_1, 1612_2 of FIG. 33.

Referring to FIGS. 33 and 34, a first memory cell MC1 may be connected to a bit line BL and an i-th word line WLi, and a second memory cell MC2 may be connected to a complementary bit line BLB and a j-th word line WLj. In some embodiments, the first memory cell MC1 and the second memory cell MC2 may be included in different and adjacently arranged sub-memory arrays, but are not limited thereto, and in some embodiments, the first memory cell MC1 and the second memory cell MC2 may be included in the same sub-memory array. The above i and j are different natural numbers.

The first memory cell MC1 is a volatile memory cell, has a 1T1C structure, and may include a first transistor TR1 and a first storage capacitor Cs1. A first transistor TR1 is connected between a first bit line BL1 and a first storage capacitor Cs1 and may be controlled by an i-th word line WLi.

The second memory cell MC2 is a volatile memory cell, has a 1T1C structure, and may include a second transistor TR2 and a second storage capacitor Cs2. The second transistor TR2 is connected between the second bit line BL2 and the second storage capacitor Cs2 and may be controlled by the j-th word line WLj.

A first bit line capacitor Cbl1 is placed between a bit line BL and a ground terminal, and the voltage of the bit line BL may be held by the first bit line capacitor Cbl1. A second bit line capacitor Cbl2 is placed between the complementary bit line BLB and the ground terminal, and the voltage of the complementary bit line BLB may be held by the second bit line capacitor Cbl2. In some embodiments, the first bit line capacitor Cbl1 and the second bit line capacitor Cbl2 may be parasitic capacitors formed by the bit line and surrounding wiring or circuit elements.

The precharge circuit 1611d may provide a precharge voltage Vpre to the bit line BL and the complementary bit line BLB based on the first precharge control signal PCGs1. The precharge circuit 1611d may include first and second switch transistors TRs1, TRs2 and a precharge power source.

The first switch transistor TRs1 may connect the bit line BL and the precharge power source based on the first precharge control signal PCGs1. The second switch transistor TRs2 may connect a complementary bit line BLB and a precharge power source based on the first precharge control signal PCGs1.

The first charge pump circuit 1612_1d may store a certain amount of charge through a charge sharing operation between the bit line BL and the first memory cell MC1. The first charge pump circuit 1612_1d may pump the voltage of the sensing node SBLn based on the stored charge.

The first charge pump circuit 1612_1d may include a first pump capacitor Cp1', a third switch transistor TRs3, a fifth switch transistor TRs5, a seventh switch transistor TRs7, and a precharge power source.

The first pump capacitor Cp1' may include a first electrode electrically connected to a sensing node SBLn, which is an input node of the sense amplifier circuit 1613', and a second electrode electrically connected to a first node N1' different from the sensing node SBLn. According to some embodiments, the first pump capacitor Cp1' may include conductive wiring or circuit elements disposed in the peripheral circuit area PS of FIG. 3. The first pump capacitor Cp1' may include a MIM capacitor, a MOS capacitor, etc.

The third switch transistor TRs3 may connect the sensing node SBLn and the bit line BL based on the first isolation control signal ISOs1. The fifth switch transistor TRs5 may connect the first node N1' and the bit line BL based on the first pumping control signal Ps1. The seventh switch transistor TRs7 may connect the first node N1' and the precharge power source based on the second precharge control signal PCGs2, and may provide the precharge voltage Vpre to the first node N1' based on the second precharge control signal PCGs2.

The second charge pump circuit 1612_2d may include a second pump capacitor Cp2', a fourth switch transistor TRs4', a sixth switch transistor TRs6', a seventh switch transistor TRs7', and a precharge power source.

The second pump capacitor Cp2' may include a first electrode electrically connected to a complementary sensing node SBLBn, which is an input node of the sense amplifier circuit 1613', and a second electrode electrically connected to a second node N2' different from the complementary sensing node SBLBn. In some embodiments, the second pump capacitor Cp2' may include conductive wiring or circuit elements disposed in the peripheral circuit area PS of FIG. 3. The second pump capacitor Cp2' may include a MIM capacitor, a MOS capacitor, etc.

The fourth switch transistor TRs4' may connect the sensing node SBLn and the complementary bit line BLB based on the second isolation control signal ISOs2. The sixth switch transistor TRs6' may connect the second node N2' and the complementary bit line BLB based on the second pumping control signal Ps2. The seventh switch transistor TRs7' may connect the second node N2' and the precharge power source based on the second precharge control signal PCGs2, and may provide the precharge voltage Vpre to the second node N2' based on the second precharge control signal PCGs2.

The sense amplifier circuit 1613' may sense data stored in the first memory cell MC1 by performing a sensing and amplification operation based on the voltage difference between the sensing node SBLn and the complementary sensing node SBLBn. In some embodiments, the sense amplifier circuit 1613' may be a cross-coupled latch circuit and may include two inverters interconnected in a feedback structure.

The sense amplifier circuit 1613' performs a sensing operation based on the voltage pumped by the first charge pump circuit 1612_1d, so that the bit line sense amplifier 161' may widen the sensing margin and improve the reliability of the sensing operation. In some embodiments, the bit line sense amplifier 161' may improve the operating speed of the sensing operation by widening the sensing margin so that no separate offset removal is required to perform the sensing operation.

The bit line sense amplifier 161' receives the voltage of the bit line BL, which is a differential signal, and the voltage of the complementary bit line BLB, and performs a sensing operation based on the voltage difference between the sensing node SBLn and the complementary sensing node SBLBn, thereby enabling the sensing operation to be performed reliably and robustly against wiring coupling in a dense wiring environment.

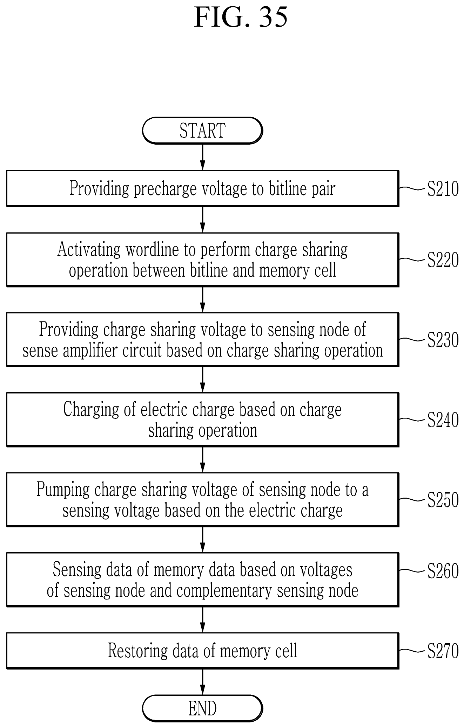

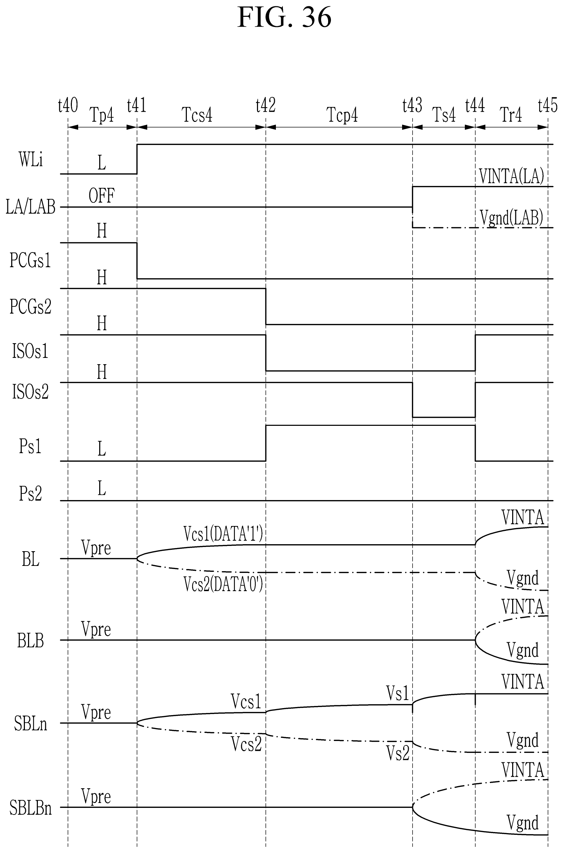

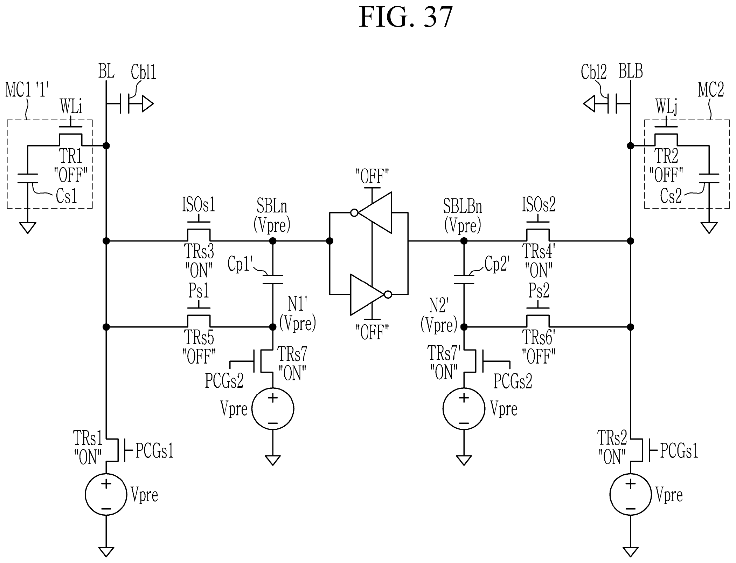

FIG. 35 is a flowchart illustrating a method of operating a memory device according to some embodiments. FIG. 36 is a timing diagram illustrating a method of operating a memory device according to some embodiments. FIGS. 37 to 41 are drawings for explaining a method of operating a memory device according to some embodiments.

Specifically, FIGS. 36 to 41 illustrate an operation method of a memory device centered on a process of reading data stored in the first memory cell MC1 of FIG. 34, and for ease of explanation, FIGS. 36 to 41 are used as examples to explain the operation method of the memory device below.

Referring to FIGS. 33 to 36, the precharge circuit 1611' provides a precharge voltage Vpre to the bit line pair BL, BLB(S210).

The precharge circuit 1611' may provide a precharge voltage Vpre to the bit line pair BL, BLB during the precharge period.

At time t40, the i-th word line WLi receives a signal at logic low L level and may be disabled. The sensing control signal pair LA, LAB may be an off voltage, the first precharge control signal PCGs1 may be at a logic high H level, the second precharge control signal PCGs2 may be at a logic high H level, the first isolation control signal ISOs1 may be at a logic high H level, the second isolation control signal ISOs2 may be at a logic high H level, the first pumping control signal Ps1 may be at a logic low L level, and the second pumping control signal Ps2 may be at a logic low L level.

Taking FIG. 37 as an example, the first transistor TR1 may be turned off and the sense amplifier circuit 1613' may be turned off. The first to fourth switch transistors TRs1 to TRs3, TRs4' may be turned on, the fifth and sixth switch transistors TRs5, TRs6' may be turned off, and the seventh switch transistor TRs7, TRs7' may be turned on. A precharge voltage Vpre may be applied to a bit line BL and a complementary bit line BLB, a precharge voltage Vpre may be applied to a sensing node SBLn, and a precharge voltage Vpre may be applied to the first and second nodes N1', N2'.

During the fourth precharge period Tp4 after the time point t40, a precharge voltage Vpre may be provided to the bit line pair BL, BLB, and a precharge voltage Vpre may be provided to the first and second nodes N1', N2'. During the fourth precharge period Tp4, a precharge voltage Vpre may be applied to the sensing node SBLn and the complementary sensing node SBLBn, and a precharge voltage Vpre may be applied to the first and second nodes N1', N2'.

The sub-word line driver activates the word line to perform a charge sharing operation between the bit line BL and the memory cell(S220).

The sub-word line driver activates the word line by applying a word line driving voltage to the word line, and a charge sharing operation between the memory cell and the bit line may be performed. During charge sharing operation, charge is shared between the storage capacitor and the bit line within the memory cell, and the voltage of the bit line may change from the precharge voltage Vpre to the charge sharing voltage.

At time t41, the i-th word line WLi may receive a signal at a logic high H level and be activated. The first precharge control signal PCGs1 may transition from a logic high H level to a logic low L level.

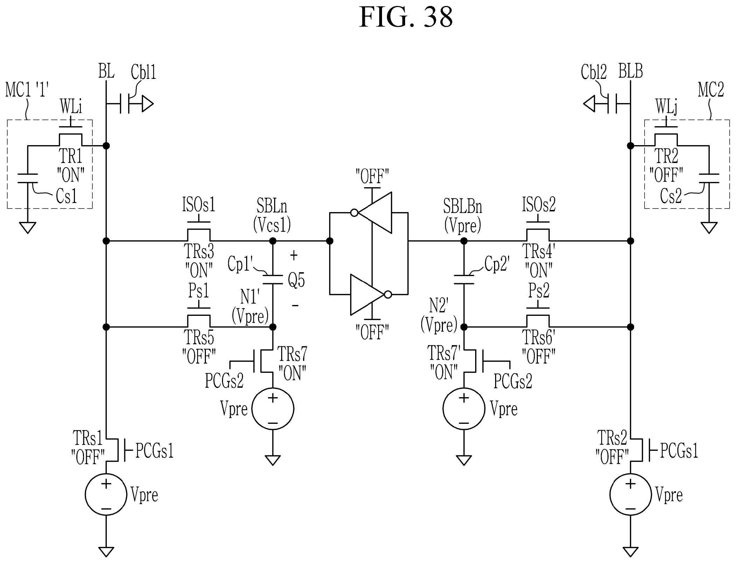

Taking FIG. 38 as an example, the first transistor TR1 is turned on, the first and second switch transistors TRs1, TRs2 are turned off, and a charge sharing operation between the first memory cell MC1 and the bit line BL may be performed. Through the turn-on operation of the first transistor TR1, charge may be shared between the first storage capacitor Cs1, the first bit line capacitor Cbl1, and the first pump capacitor Cp1'. Since the first memory cell MC1 stores '1', which is a "high" level data, charge may be shared from the first storage capacitor Cs1 toward the first bit line capacitor Cbl1 and the first pump capacitor Cp1'. Through the above charge sharing, the voltage of the bit line BL may be changed to a first charge sharing voltage Vcs1 greater than the precharge voltage Vpre.

During the fourth charge sharing period Tcs4 after time point t41, a charge sharing operation between the first memory cell MC1 and the bit line BL is performed, and the voltage of the bit line BL may change from the precharge voltage Vpre to the first charge sharing voltage Vcs1. While the voltage of the bit line BL is changing, the voltage of the complementary bit line BLB may be maintained at the precharge voltage Vpre. The first charge sharing voltage Vcs1 may be determined by the capacitance of the first storage capacitor Cs1, the capacitance of the first bit line capacitor Cbl1, and the capacitance of the first pump capacitor Cp1', and according to an embodiment, the lower the capacitance of the first bit line capacitor Cbl1, the larger the first charge sharing voltage Vcs1. When the first memory cell MC1 stores '1', which is a "high" level data, the voltage of the bit line BL may change from the precharge voltage Vpre to the first charge sharing voltage Vcs1 which is greater than the precharge voltage Vpre. When the first memory cell MC1 stores '0', which is a "low" level data, the voltage of the bit line BL may change from the precharge voltage Vpre to the second charge sharing voltage Vcs2 which is lower than the precharge voltage Vpre.

The first charge pump circuit 1612_1 provides the charge sharing voltage of the bit line BL to the sensing node SBLn of the sense amplifier circuit 1613' based on the charge sharing operation(S230).

The first charge pump circuit 1612_1 may provide the voltage of the bit line BL to the sensing node SBLn of the sense amplifier circuit 1613' during the charge sharing period. The charge sharing voltage applied to the bit line BL through the charge sharing operation may be provided to the sensing node SBLn through the first charge pump circuit 1612_1.

Taking FIG. 38 as an example, the bit line BL and the sensing node SBLn are electrically connected to each other through the turn-on operation of the third switch transistor TRs3, and a charge sharing voltage may be applied to the sensing node SBLn. Since the first memory cell MC1 stores '1', which is a "high" level data, the first charge sharing voltage Vcs1 may be provided to the sensing node SBLn.

During the fourth charge sharing period Tcs4 after time point t41, the first charge pump circuit 1612_1d provides the voltage of the bit line BL to the sensing node SBLn, and the voltage of the sensing node SBLn may vary depending on the voltage of the bit line BL. When the first memory cell MC1 stores '1', which is a "high" level data, the voltage of the sensing node SBLn may change from the precharge voltage Vpre to the first charge sharing voltage Vcs1 together with the voltage of the bit line BL. When the first memory cell MC1 stores '0', which is a "low" level data, the voltage of the sensing node SBLn may change from the precharge voltage Vpre to the second charge sharing voltage Vcs2 together with the voltage of the bit line BL.

The first charge pump circuit 1612_1 charges the charge based on charge sharing operation(S240).

The first charge pump circuit 1612_1 may provide a charge sharing voltage and a precharge voltage Vpre to both electrodes of the first pump capacitor Cp1' during the charge sharing period. By providing a charge sharing voltage and a precharge voltage Vpre, the pump capacitor Cp1' may be charged during the charge sharing period.

Taking FIG. 38 as an example, a charge sharing voltage is applied to the sensing node SBLn, a precharge voltage Vpre is provided to the first node N1', and the first pump capacitor Cp1' may store a fifth charge Q5. Since the first memory cell MC1 stores '1', which is a "high" level data, the first electrode of the first pump capacitor Cp1' that receives the first charge sharing voltage Vcs1 greater than the precharge voltage Vpre may become the positive electrode, and the second electrode of the first pump capacitor Cp1' that receives the precharge voltage Vpre may become the negative electrode.

During the fourth charge sharing period Tcs4 after time point t41, the voltage of the sensing node SBLn fluctuates, and the charge of the first pump capacitor Cp1' may be charged based on the charge sharing voltage of the sensing node SBLn. Therefore, the amount of charge stored in the first pump capacitor Cp1' and the polarity direction of the electrodes in the pump capacitor may be determined by the charge sharing voltage. The amount of charge stored in the pump capacitor Cp1' may be determined by the magnitude of the charge sharing voltage. When the first memory cell MC1 stores '1', which is a "high" level data, the voltage of the sensing node SBLn changes to the first charge sharing voltage Vcs1, and the first electrode of the first pump capacitor Cp1' connected to the sensing node SBLn becomes the positive electrode, and the second electrode of the first pump capacitor Cp1' that receives the precharge voltage Vpre becomes the negative electrode. When the first memory cell MC1 stores '0', which is a "low" level data, the voltage of the sensing node SBLn changes to the second charge sharing voltage Vcs2, and the first electrode of the first pump capacitor Cp1' connected to the sensing node SBLn becomes a negative electrode, and the second electrode of the first pump capacitor Cp1' that receives the precharge voltage Vpre becomes a positive electrode.

The first charge pump circuit 1612_1 pumps the charge sharing voltage of the sensing node SBLn to a sensing voltage based on the charged charge(S250).

The first charge pump circuit 1612_1 may pump the charge sharing voltage of the sensing node SBLn to a sensing voltage based on the charge pumped from the first pump capacitor Cp1' during the charge sharing period. The first charge pump circuit 1612_1 may pump the voltage of the sensing node SBLn in a charge pumping manner by controlling the electrical connection to the first pump capacitor Cp1' through the switch transistor in the first charge pump circuit 1612_1. While the first charge pump circuit 1612_1 performs a pumping operation, the second charge pump circuit 1612_2 may maintain an electrical connection between the complementary bit line BLB and the second pump capacitor Cp2'.

At time t42, the second precharge control signal PCGs2 may transition from a logic high H level to a logic low L level, the first isolation control signal ISOs1 may transition from a logic high H level to a logic low L level, and the first pumping control signal Ps1 may transition from a logic low L level to a logic high H level.

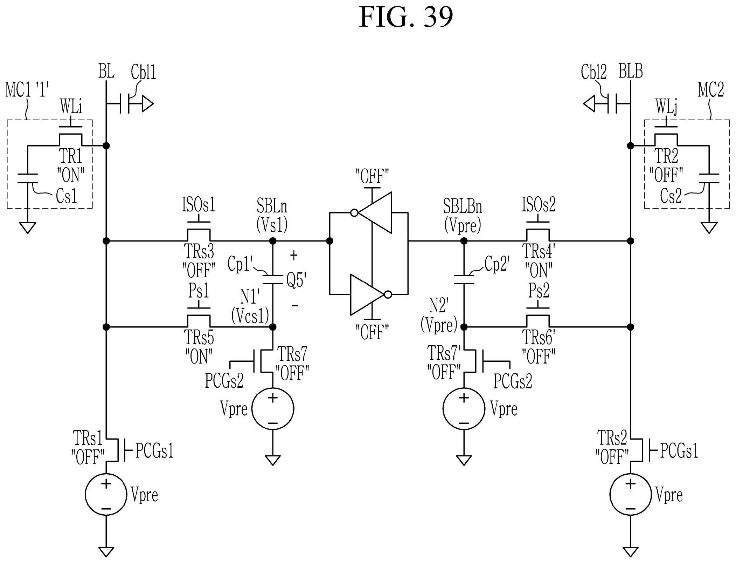

Taking FIG. 39 as an example, the third switch transistor TRs3 and the seventh switch transistor TRs7 are turned off, the fifth switch transistor TRs5 is turned on, and a voltage pumping operation by the first pump capacitor Cp1' may be performed. Through the turn-off operation of the third and seventh switch transistors TRs3, TRs7 and the turn-on operation of the fifth switch transistor TRs5, the charged first pump capacitor Cp1' is connected in series between the bit line BL and the sensing node SBLn, the first charge sharing voltage Vcs1 of the bit line BL is applied to the first node N1', and the voltage at the sensing node SBLn may be pumped from the first charge sharing voltage Vcs1 to the first sensing voltage Vs1. Through the above pumping operation, the charge charged in the first pump capacitor Cp1' may be changed from the fifth charge Q5 to the fifth changed charge Q5'.

During the fourth charge pump period Tcp4 after time point t42, voltage pumping at the sensing node SBLn may be performed using the first pump capacitor Cp1' in a charge pump manner, and the voltage at the sensing node SBLn may be changed from a charge sharing voltage to a sensing voltage. The sensing voltage may be determined by the charge charged in the first pump capacitor Cp1', and according to an embodiment, the voltage difference between the sensing voltage and the precharge voltage Vpre may be increased as the amount of charge charged in the first pump capacitor Cp1' increases. When the first memory cell MC1 stores '1', which is a "high" level data, the voltage of the sensing node SBLn may change from the first charge sharing voltage Vcs1 to the first sensing voltage Vs1. When the first memory cell MC1 stores '0', which is a "low" level data, the voltage of the sensing node SBLn may change from the second charge sharing voltage Vcs2 to the second sensing voltage Vs2.

The sense amplifier circuit 1613' senses data of a memory cell based on the voltage difference between the sensing node SBLn and the complementary sensing node SBLBn(S260).

The sense amplifier circuit 1613' may sense data of a memory cell based on the voltage difference between the sensing voltage at the sensing node SBLn pumped by the first charge pump circuit 1612_1 and the precharge voltage at the complementary sensing node SBLBn.

At time t43, the sensing control signal LA may change from the off voltage to the internal power supply voltage VINTA, the inverted sensing control signal LAB may change from the off voltage to the ground voltage Vgnd, and the second isolation control signal ISOs2 may transition from a logic high H level to a logic low L level.

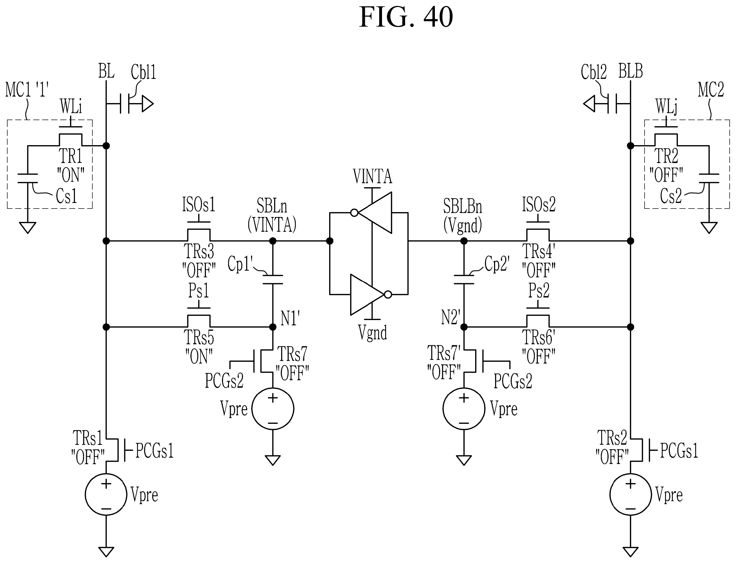

Taking FIG. 40 as an example, the sense amplifier circuit 1613' may be turned on and the fourth switch transistor TRs4' may be turned off. The sense amplifier circuit 1613' may sense '1', which is a "high" level data, based on the first sensing voltage Vs1 at the sensing node SBLn and the precharge voltage Vpre at the complementary sensing node SBLBn, amplify the complementary sensing node SBLBn to the level of the ground voltage Vgnd, and amplify the voltage at the sensing node SBLn to the internal power supply voltage VINTA based on the ground voltage Vgnd at the complementary sensing node SBLBn.

During the fourth sensing period Ts4 after the time point t43, the sense amplifier circuit 1613' may perform sensing and amplification operations based on the sensing voltage at the sensing node SBLn and the precharge voltage Vpre at the complementary sensing node SBLBn. The sense amplifier circuit 1613' may improve the reliability of the sensing operation by performing the sensing operation based on a sensing voltage with a wider sensing margin than the charge sharing voltage. When the first memory cell MC1 stores '1', which is a "high" level data, the sense amplifier circuit 1613' may sense the voltage difference between the first sensing voltage Vs1 and the precharge voltage Vpre, amplify the voltage at the complementary sensing node SBLBn to the ground voltage Vgnd, and amplify the voltage at the sensing node SBLn to the internal power supply voltage VINTA. When the first memory cell MC1 stores '0', which is a "low" level data, the sense amplifier circuit 1613' may sense the voltage difference between the second sensing voltage Vs2 and the precharge voltage Vpre, amplify the voltage at the complementary sensing node SBLBn to the internal power supply voltage VINTA, and amplify the voltage at the sensing node SBLn to the ground voltage Vgnd.

The sense amplifier circuit 1613' restores the data of the memory cell(S270).

The sense amplifier circuit 1613' may restore data by providing an amplified voltage to the memory cell.

At time t44, the first isolation control signal ISOs1 may transition from a logic low L level to a logic high H level, the second isolation control signal ISOs2 may transition from a logic low L level to a logic high H level, and the first pumping control signal Ps1 may transition from a logic high H level to a logic low L level.

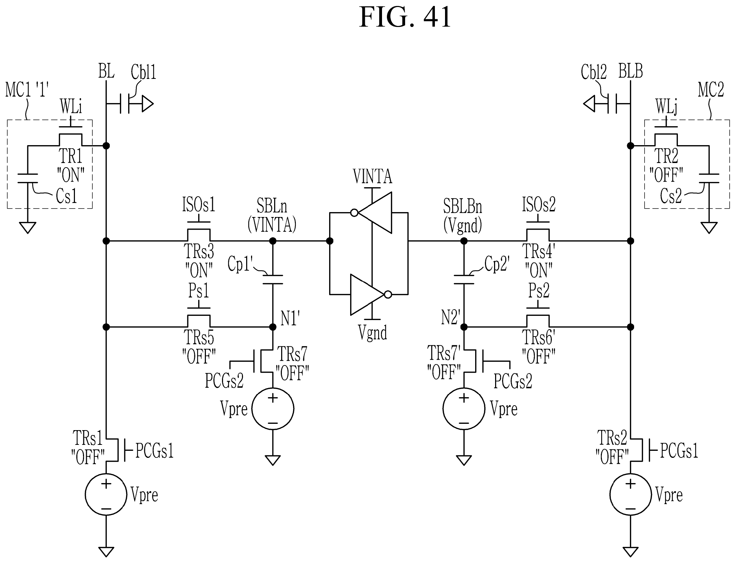

Taking FIG. 41 as an example, the bit line BL and the sensing node SBLn are electrically connected to each other through the turn-on operation of the third switch transistor TRs3, and the sense amplifier circuit 1613' may provide an internal power supply voltage VINTA to the first memory cell MC1 through the bit line BL. The first memory cell MC1 may restore '1', which is a high level data, based on the provided internal power supply voltage VINTA.

During the fourth restorage period Tr4 between time points t44 and t45, the sense amplifier circuit 1613' may provide the amplified voltage at the sensing node SBLn to the bit line BL through the first charge pump circuit 1612_1. When the first memory cell MC1 stores '1', which is a "high" level data, an internal power supply voltage VINTA is supplied to the first memory cell MC1 through the bit line BL, so that the first memory cell MC1 may re-store '1', which is a "high" level data. When the first memory cell MC1 stores '0', which is a "low" level data, a ground voltage Vgnd is provided to the first memory cell MC1 through the bit line BL, so that the first memory cell MC1 may re-store '0', which is a "low" level data.

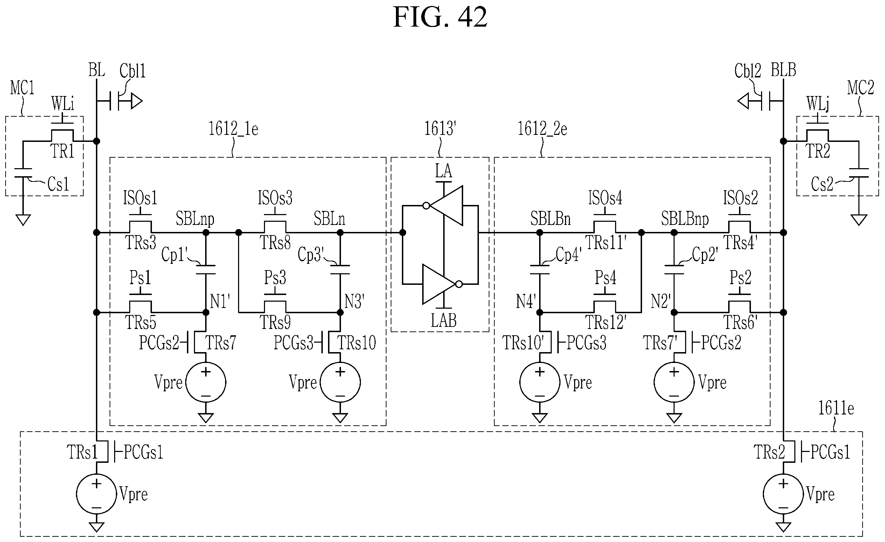

FIG. 42 is a circuit diagram illustrating a bit line sense amplifier according to some embodiments. Specifically, FIG. 42 illustrates a part of an example circuit of the bit line sense amplifier 161' of FIG. 33, and the precharge circuit 1611e and the first and second charge pump circuits 1612_1e, 1612_2e of FIG. 42 are examples of the precharge circuit 1611 and the first and second charge pump circuits 1612_1, 1612_2 of FIG. 33.

For ease of explanation below or to avoid redundancy, the precharge circuit 1611e and the first and second charge pump circuits 1612_1e, 1612_2e will be described focusing on the differences from the precharge circuit 1611d and the first and second charge pump circuits 1612_1d, 1612_2d of FIG. 34.

Referring to FIG. 33 and FIG. 42, compared to the first charge pump circuit 1612_1d of FIG. 34, the first charge pump circuit 1612_1e includes two pump capacitors Cp1', Cp3' and may perform two voltage pumping operations when performing a lead operation. Additionally, the first charge pump circuit 1612_1e may further include eighth to tenth switch transistors TRs8 to TRs10 compared to the first charge pump circuit 1612_1d of FIG. 34.

Similarly, compared to the second charge pump circuit 1612_2d of FIG. 34, the second charge pump circuit 1612_2e includes two pump capacitors Cp2', Cp4' and may perform two voltage pumping operations in performing a lead operation. Likewise, the second charge pump circuit 1612_2e may further include the tenth to twelfth switch transistors TRs10' to TRs12' compared to the second charge pump circuit 1612_2d of FIG. 34.

The first pump capacitor Cp1' may include a first electrode electrically connected to the preliminary sensing node SBLnp and a second electrode electrically connected to a first node N1' different from the preliminary sensing node SBLnp. The second pump capacitor Cp2' may include a first electrode electrically connected to the preliminary complementary sensing node SBLBnp and a second electrode electrically connected to a second node N2' different from the preliminary complementary sensing node SBLBnp. The third pump capacitor Cp3' may include a first electrode electrically connected to a sensing node SBLn, which is an input node of the sense amplifier circuit 1613', and a second electrode electrically connected to a third node N3' different from the sensing node SBLn. The fourth pump capacitor Cp4' may include a first electrode electrically connected to a complementary sensing node SBLBn, which is an input node of the sense amplifier circuit 1613', and a second electrode electrically connected to a fourth node N4' different from the complementary sensing node SBLBn. According to some embodiments, the first to fourth pump capacitors Cp1' to Cp4' may include at least a portion of the conductive wiring or at least a portion of the circuit elements disposed in the peripheral circuit area PS of FIG. 3. The first to fourth pump capacitors Cp1' to Cp4' may include a MIM capacitor, a MOS capacitor, etc.

The third switch transistor TRs3 may connect the preliminary sensing node SBLnp and the bit line BL based on the first isolation control signal ISOs1. The fourth switch transistor TRs4' may connect the preliminary complementary sensing node SBLBnp and the complementary bit line BLB based on the second isolation control signal ISOs2. The fifth switch transistor TRs5 may connect the first node N1' and the bit line BL based on the first pumping control signal Ps1. The sixth switch transistor TRs6' may connect the second node N2' and the complementary bit line BLB based on the second pumping control signal Ps2.

The eighth switch transistor TRs8 may connect the preliminary sensing node SBLnp and the sensing node SBLn based on the third isolation control signal ISOs3. The ninth switch transistor TRs9 may connect the preliminary sensing node SBLnp and the second node N2' based on the third pumping control signal Ps3. The tenth switch transistor TRs10 may connect the second node N2' and the precharge power source based on the third precharge control signal PCGs3, and may provide the precharge voltage Vpre to the second node N2' based on the third precharge control signal PCGs3. The eleventh switch transistor TRs11' may connect the preliminary complementary sensing node SBLBnp and the complementary sensing node SBLBn based on the fourth isolation control signal ISOs4. The twelfth switch transistor TRs12' may connect the preliminary complementary sensing node SBLBnp and the fourth node N4' based on the fourth pumping control signal Ps4. The tenth switch transistor TRs10' may connect the fourth node N4' and the precharge power source based on the third precharge control signal PCGs3, and provide the precharge voltage Vpre to the fourth node N4' based on the third precharge control signal PCGs3.

In some embodiments, the eighth to tenth switch transistors TRs8 to TRs10 and the tenth to twelfth switch transistors TRs10' to TRs12' may be NMOS transistors.

Although each of the first and second charge pump circuits 1612_1e, 1612_2e is illustrated as including two pump capacitors, the present disclosure is not limited thereto. According to some embodiments, each of the first and second charge pump circuits 1612_1e, 1612_2e may further include three or more pump capacitors, and each of the first and second charge pump circuits 1612_1e, 1612_2e may perform the plurality of voltage pumping operations corresponding to the number of pump capacitors.

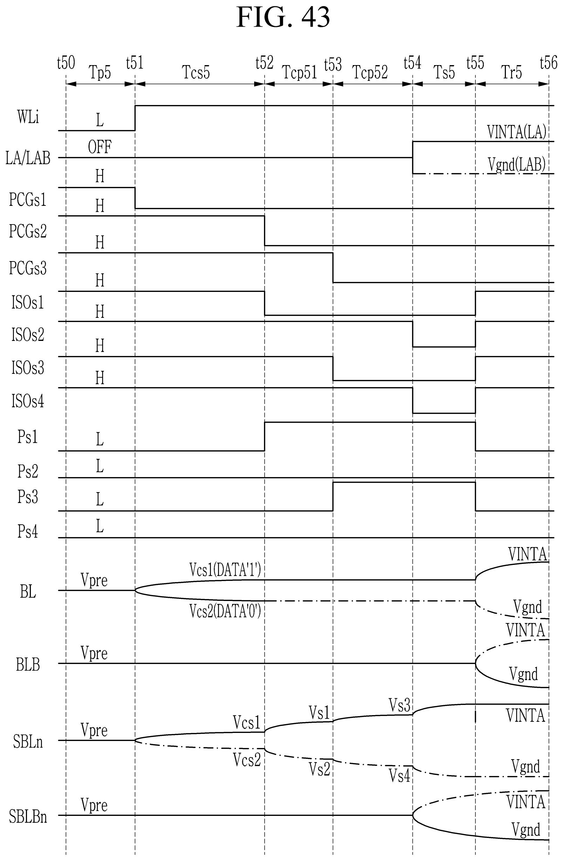

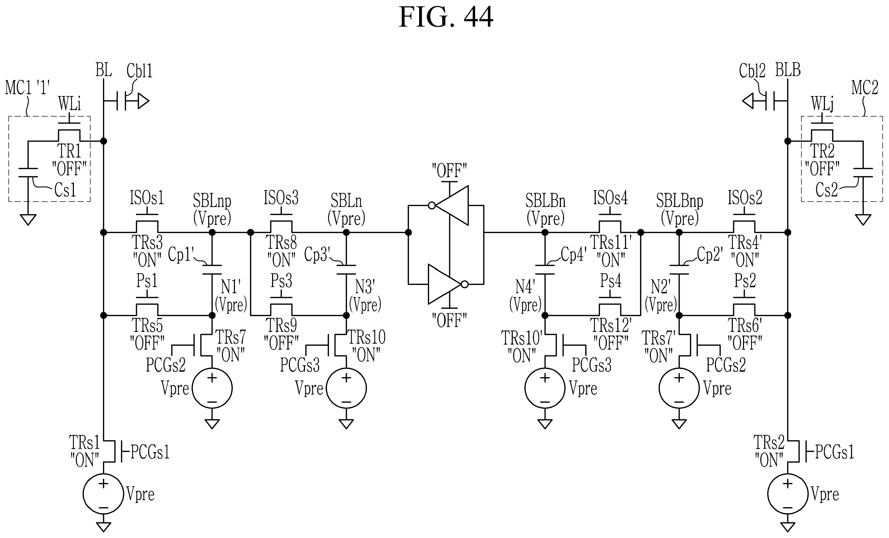

FIG. 43 is a timing diagram illustrating a method of operating a memory device according to some embodiments. FIGS. 44 to 49 are drawings for explaining a method of operating a memory device according to some embodiments.

Specifically, FIGS. 43 to 49 illustrate an operation method of a memory device centered on a process of reading data stored in the first memory cell MC1 of FIG. 42, and for ease of explanation, FIGS. 43 to 49 are used as examples to explain the operation method of the memory device below.

Referring to FIG. 33, FIG. 42, and FIG. 43, at time t50, the i-th word line WLi may receive a signal at a logic low L level and be disabled. The sensing control signal pair LA, LAB is an off voltage, the first precharge control signal PCGs1 is a logic high H level, the second precharge control signal PCGs2 is a logic high H level, the third precharge control signal PCGs3 is a logic high H level, the first isolation control signal ISOs1 is a logic high H level, the second isolation control signal ISOs2 is a logic high H level, the third isolation control signal ISOs3 is a logic high H level, the fourth isolation control signal ISOs4 is a logic high H level, the first pumping control signal Ps1 is a logic low L level, the second pumping control signal Ps2 is a logic low L level, the third pumping control signal Ps3 is a logic low L level, and the fourth pumping control signal Ps4 is a logic low L It could be a level.

Taking FIG. 44 as an example, the first transistor TR1 may be turned off and the sense amplifier circuit 1613 may be turned off. The first to fourth switch transistors TRs1 to TRs3, TRs4' may be turned on, and the fifth and sixth switch transistors TRs5, TRs6' may be turned off. The eighth switch transistor TRs8 and the eleventh switch transistor TRs11' may be turned on, and the ninth switch transistor TRs9 and the twelfth switch transistor TRs12' may be turned off. The seventh switch transistor TRs7, TRs7' and the tenth switch transistor TRs10, TRs10' may be turned on. A precharge voltage Vpre for a read operation may be applied to a bit line pair BL, BLB, a precharge voltage Vpre may be applied to a sensing node SBLn and a preliminary sensing node SBLnp, and a precharge voltage Vpre may be applied to the first to fourth nodes N1' to N4'.

During the fifth precharge period Tp5 after the time point t50, a precharge voltage Vpre may be provided to the bit line pair BL, BLB, and a precharge voltage Vpre may be provided to the first to fourth nodes N1' to N4'. During the fifth precharge period Tp5, a precharge voltage Vpre may be applied to the sensing node SBLn, the preliminary sensing node SBLnp, the complementary sensing node SBLBn, and the preliminary complementary sensing node SBLBnp. The fifth precharge period Tp5 may correspond to step S210 of FIG. 35.

At time t51, the i-th word line WLi may receive a logic high H level signal and be activated. The first precharge control signal PCGs1 may transition from a logic high H level to a logic low L level.

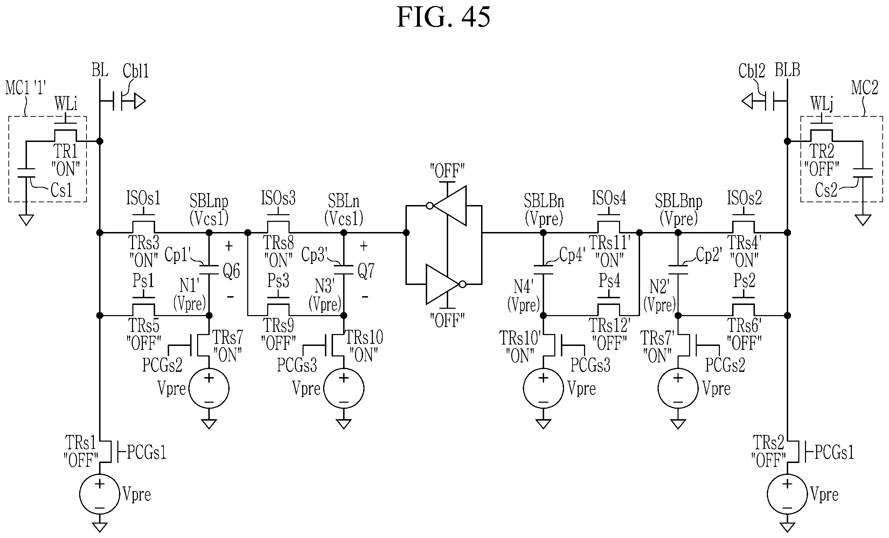

Taking FIG. 45 as an example, the first transistor TR1 is turned on, the first and second switch transistors TRs1, TRs2 are turned off, and a charge sharing operation between the first memory cell MC1 and the bit line BL may be performed. Through the turn-on operations of the first transistor TR1, the third switch transistor TRs3, and the eighth switch transistor TRs8, charge may be shared between the first storage capacitor Cs1, the first bit line capacitor Cbl1, and the first and third pump capacitors Cp1', Cp3'. Since the first memory cell MC1 stores '1', which is a "high" level data, charges may be shared from the first storage capacitor Cs1 toward the first bit line capacitor Cbl1 and the first and third pump capacitors Cp1', Cp3'. Through the above charge sharing, the voltages of the first bit line BL, the preliminary sensing node SBLnp, and the sensing node SBLn may be changed to the first charge sharing voltage Vcs1. Since the first charge sharing voltage Vcs1 is applied to the preliminary sensing node SBLnp and the precharge voltage Vpre is provided to the first node N1', the first pump capacitor Cp1' may store the sixth charge Q6. Since the first charge sharing voltage Vcs1 is applied to the sensing node SBLn and the precharge voltage Vpre is provided to the third node N3', the third pump capacitor Cp3' may store the seventh charge Q7. Since the first memory cell MC1 stores '1', which is a "high" level data, the first electrode of the first and third pump capacitors Cp1', Cp3' that receive the first charge sharing voltage Vcs1 greater than the precharge voltage Vpre may become the positive electrode, and the second electrode of the first and third pump capacitors Cp1', Cp3' that receive the precharge voltage Vpre may become the negative electrode.

During the fifth charge sharing period Tcs5 after time point t51, a charge sharing operation between the first memory cell MC1 and the bit line BL is performed, and the voltage of the bit line BL may change from the precharge voltage Vpre to the charge sharing voltage. During the charge sharing operation between the first memory cell MC1 and the bit line BL, the voltage of the preliminary complementary sensing node SBLBnp and the complementary sensing node SBLBn may be maintained at the precharge voltage Vpre. The charge sharing voltage may be determined by the data of the first memory cell MC1, the capacitance of the first storage capacitor Cs1, the capacitance of the first bit line capacitor Cbl1, and the capacitances of the first and third pump capacitors Cp1', Cp3'. According to an embodiment, even if the data of the first memory cell MC1 is the same, the charge sharing voltage may increase as the capacitance of the first bit line capacitor Cbl1 decreases.

When the first memory cell MC1 stores '1', which is a "high" level data, during the fifth charge sharing period Tcs5, the voltage of the bit line BL may change from the precharge voltage Vpre to the first charge sharing voltage Vcs1 which is greater than the precharge voltage Vpre. A first charge sharing voltage Vcs1 is provided to the sensing node SBLn and the auxiliary sensing node SBLnp, and the charges of the first and third pump capacitors Cp1', Cp3' may be charged based on the first charge sharing voltage Vcs1. When the first memory cell MC1 stores '0', which is a "low" level data, during the fifth charge sharing period Tcs5, the voltage of the bit line BL may change from the precharge voltage Vpre to the second charge sharing voltage Vcs lower than the precharge voltage Vpre. A second charge sharing voltage Vcs2 is provided to the sensing node SBLn and the auxiliary sensing node SBLnp, and the charges of the first and third pump capacitors Cp1', Cp3' may be charged based on the second charge sharing voltage Vcs2. During the fifth charge sharing period Tcs5, the voltage of the preliminary complementary sensing node SBLBnp and the complementary sensing node SBLBn may be maintained at the precharge voltage Vpre. The fifth charge sharing period Tcs5 may correspond to steps S220 to S240 of FIG. 35.

At time t52, the second precharge control signal PCGs2 may transition from a logic high H level to a logic low L level, the first isolation control signal ISOs1 may transition from a logic high H level to a logic low L level, and the first pumping control signal Ps1 may transition from a logic low L level to a logic high H level.

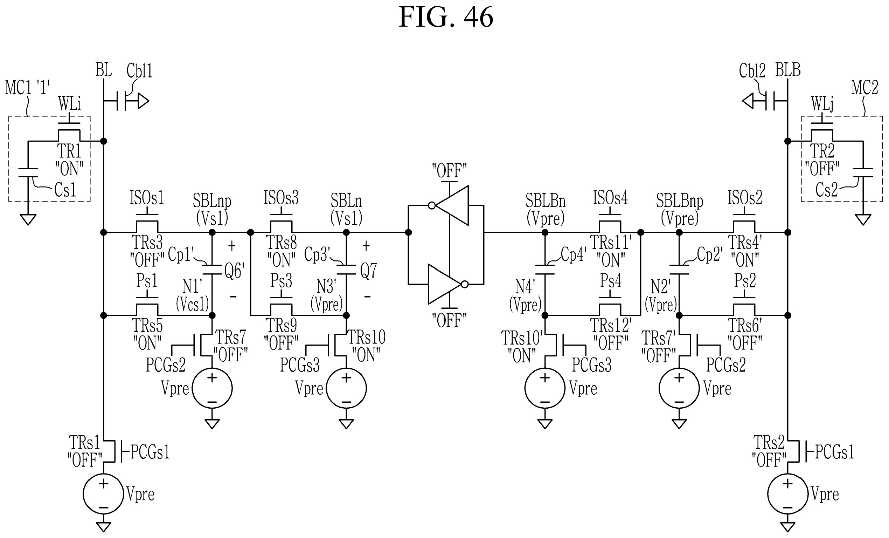

Taking FIG. 46 as an example, the third switch transistor TRs3 and the seventh switch transistor TRs7 are turned off, the fifth switch transistor TRs5 is turned on, and a voltage pumping operation by the first pump capacitor Cp1' may be performed. Through the turn-off operation of the third and seventh switch transistors TRs3, TRs7 and the turn-on operation of the fifth switch transistor TRs5, the charged first pump capacitor Cp1' is connected in series between the bit line BL and the preliminary sensing node SBLnp, the first charge sharing voltage Vcs1 of the bit line BL is applied to the first node N1', and the voltage at the preliminary sensing node SBLnp and the sensing node SBLn may be pumped from the first charge sharing voltage Vcs1 to the first sensing voltage Vs1. Through the above pumping operation, the charge charged in the first pump capacitor Cp1' may be changed from the sixth charge Q6 to the sixth changed charge Q6'.

During the 5_1 charge pump period Tcp51 after time point t52, voltage pumping at the preliminary sensing node SBLnp and the sensing node SBLn may be performed using the first pump capacitor Cp1' in a charge pump manner, and the voltages at the preliminary sensing node SBLnp and the sensing node SBLn may be changed from the charge sharing voltage to the preliminary sensing voltage. The preliminary sensing voltage may be determined by the charge charged in the first pump capacitor Cp1', and according to an embodiment, the larger the charge charged in the first pump capacitor Cp1', the larger the preliminary sensing voltage may be. When the first memory cell MC1 stores '1', which is a "high" level data, the voltage of the preliminary sensing node SBLnp and the sensing node SBLn may change from the first charge sharing voltage Vcs1 to the first sensing voltage Vs1. When the first memory cell MC1 stores '0', which is a "low" level data, the voltage of the preliminary sensing node SBLnp and the sensing node SBLn may change from the second charge sharing voltage Vcs2 to the second sensing voltage Vs2. The 5_1 charge pump period Tcp51 may correspond to step S250 of FIG. 35.

At time t53, the third precharge control signal PCGs3 may transition from a logic high H level to a logic low L level, the third isolation control signal ISOs3 may transition from a logic high H level to a logic low L level, and the third pumping control signal Ps3 may transition from a logic low L level to a logic high H level.

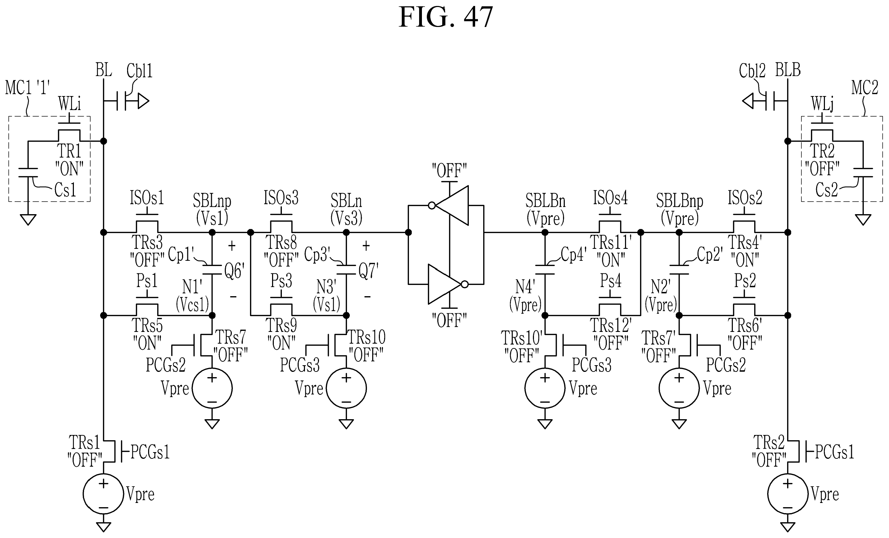

Taking FIG. 47 as an example, the eighth switch transistor TRs8 and the tenth switch transistor TRs10 are turned off, the ninth switch transistor TRs9 is turned on, and a voltage pumping operation by the third pump capacitor Cp3' may be performed. Through the turn-off operation of the eighth and tenth switch transistors TRs8, TRs10 and the turn-on operation of the ninth switch transistor TRs9, the charged third pump capacitor Cp3' is connected in series between the preliminary sensing node SBLnp and the sensing node SBLn, and the first sensing voltage Vs1 of the preliminary sensing node SBLnp is applied to the third node N3', and the voltage at the sensing node SBLn may be pumped from the first sensing voltage Vs1 to the third sensing voltage Vs3. Through the above pumping operation, the charge charged in the third pump capacitor Cp3' may be changed from the seventh charge Q7 to the seventh changed charge Q7'.

During the 5_2 charge pump period Tcp52 after time point t53, voltage pumping at the sensing node SBLn may be performed using the third pump capacitor Cp3' in a charge pump manner, and the voltage at the sensing node SBLn may be changed from a preliminary sensing voltage to a sensing voltage. The sensing voltage may be determined by the charge charged in the first and third pump capacitors Cp1', Cp3', and according to an embodiment, the sensing voltage may increase as the amount of charge charged in the first and third pump capacitors Cp1', Cp3' increases. When the first memory cell MC1 stores '1', which is a "high" level data, the voltage of the sensing node SBLn may change from the first sensing voltage Vs1 to the third sensing voltage Vs3. When the first memory cell MC1 stores '0', which is a "low" level data, the voltage of the sensing node SBLn may change from the second sensing voltage Vs2 to the fourth sensing voltage Vs4. The 3_2 charge pump period Tcp32 may correspond to step S150 of FIG. 11.

In some embodiments, during the 5_1 and 5_2 charge pump periods Tcp51, Tcp52, the voltage of the preliminary complementary sensing node SBLBnp and the complementary sensing node SBLBn may be maintained at the precharge voltage Vpre.

In some embodiments, the voltage difference between the third and fourth sensing voltages Vs3, Vs4 and the precharge voltage Vpre may be greater than the voltage difference between the first and second charge sharing voltages Vcs1, Vcs2 and the precharge voltage Vpre. Through the plurality of voltage pumping of the first and second charge sharing voltages Vcs1, Vcs2 as described above, third and fourth sensing voltages Vs3, Vs4 having a wide sensing margin may be applied to the sensing node SBLn of the sense amplifier circuit 1613'.

At time t54, the sensing control signal LA may change from the off voltage to the internal power supply voltage VINTA, the inverted sensing control signal LAB may change from the off voltage to the ground voltage Vgnd, and the second and fourth isolation control signal signals ISOs2, ISOs4 may transition from a logic high H level to a logic low L level.

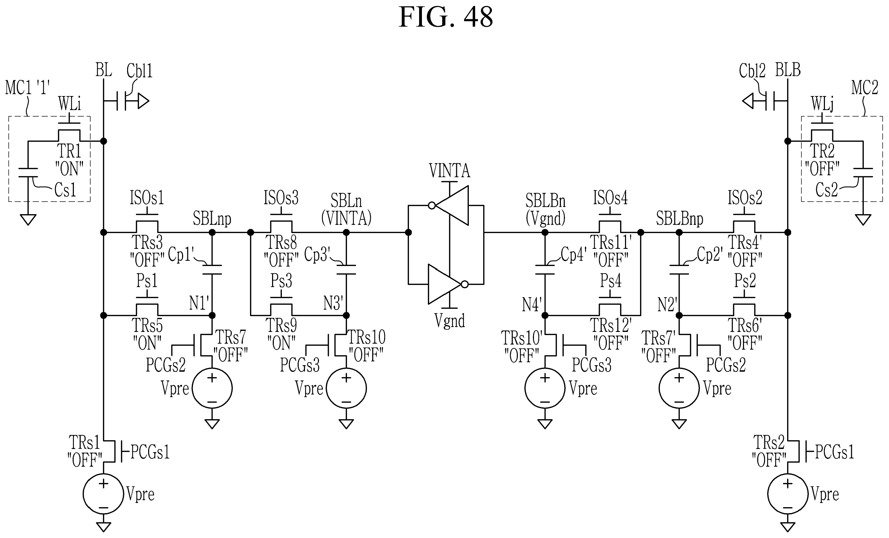

Taking FIG. 48 as an example, the sense amplifier circuit 1613' may be turned on and the fourth and eleventh switch transistors TRs4', TRs11' may be turned off. In response to the third sensing voltage Vs3 being greater than the precharge voltage Vpre, the sense amplifier circuit 1613' may sense '1', which is a "high" level data, and amplify the complementary sensing node SBLBn to the level of the ground voltage Vgnd, and amplify the voltage at the sensing node SBLn to the internal power supply voltage VINTA based on the ground voltage Vgnd at the complementary sensing node SBLBn.

During the fifth sensing period Ts5 after the time point t54, the sense amplifier circuit 1613' may perform sensing and amplification operations based on a comparison of the sensing voltage at the sensing node SBLn and the precharge voltage Vpre at the complementary sensing node SBLBn. The sense amplifier circuit 1613' may improve the reliability of the sensing operation by performing the sensing operation based on a sensing voltage with a wider sensing margin than the charge sharing voltage. When the first memory cell MC1 stores '1', which is a "high" level data, the sense amplifier circuit 1613' may sense a third sensing voltage Vs3 greater than the precharge voltage Vpre and amplify the voltage at the sensing node SBLn to an internal power supply voltage VINTA. When the first memory cell MC1 stores '0', which is a "low" level data, the sense amplifier circuit 1613' may sense a fourth sensing voltage Vs4 that is lower than the precharge voltage Vpre and amplify the voltage at the sensing node SBLn to the ground voltage Vgnd. The fifth sensing period Ts5 may correspond to step S260 of FIG. 35.

At time t55, the first to fourth isolation control signals ISOs1 to ISOs4 may transition from a logic low L level to a logic high H level, and the first and third pumping control signals Ps1, Ps3 may transition from a logic high H level to a logic low L level.

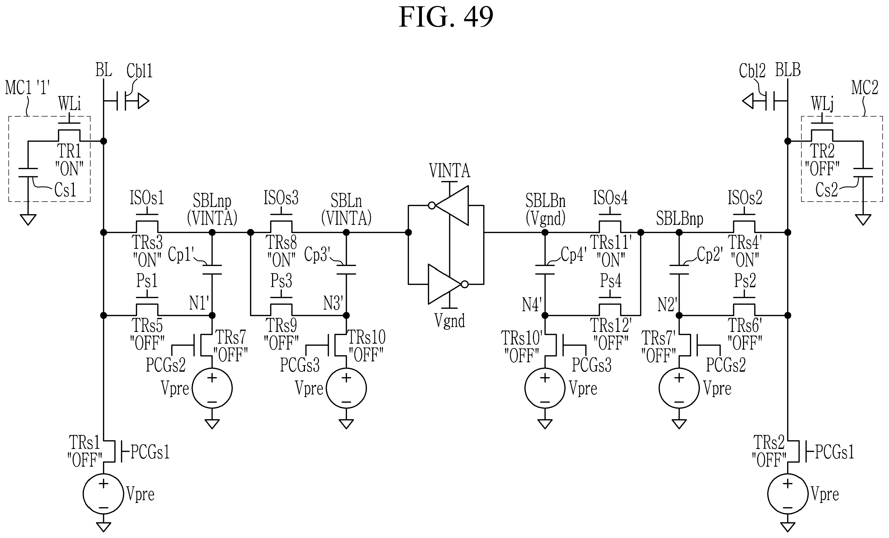

Taking FIG. 49 as an example, the bit line BL and the sensing node SBLn are electrically connected to each other through the turn-on operation of the third switch transistor TRs3 and the eighth switch transistor TRs8, and the sense amplifier circuit 1613 may provide an internal power supply voltage VINTA to the first memory cell MC1 through the bit line BL. The first memory cell MC1 may restore '1', which is a "high" level data, based on the provided internal power supply voltage VINTA.

During the fifth restorage period Tr5 between time points t55 and t56, the sense amplifier circuit 1613' may provide the amplified voltage at the sensing node SBLn to the bit line BL through the first charge pump circuit 1612_1e. When the first memory cell MC1 stores '1', which is a "high" level data, an internal power supply voltage VINTA is supplied to the first memory cell MC1 through the first bit line BL1, so that the first memory cell MC1 may re-store '1', which is a "high" level data. When the first memory cell MC1 stores '0', which is a "low" level data, a ground voltage Vgnd is provided to the first memory cell MC1 through the first bit line BL1, so that the first memory cell MC1 may re-store '0', which is a "low" level data. The fifth restorage period Tr5 may correspond to step S270 of FIG. 35.

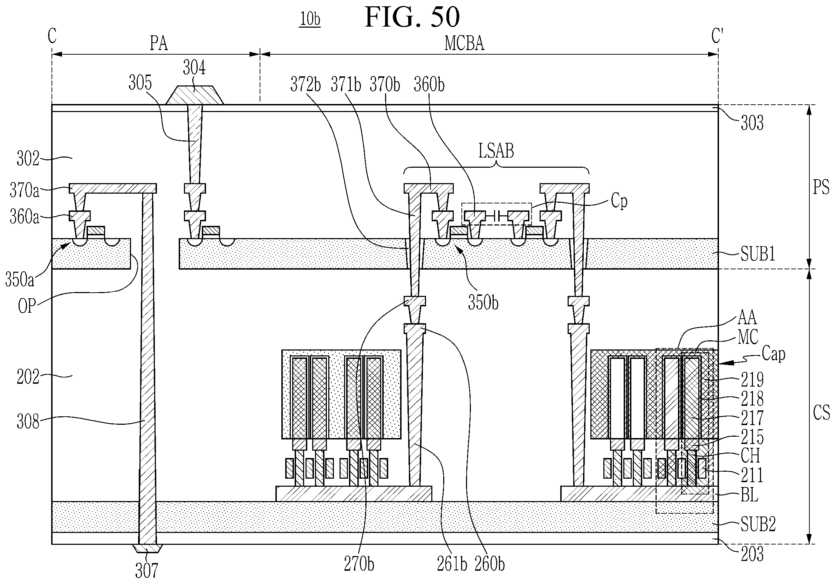

FIG. 50 is a cross-sectional view taken along line C-C' of an example of the memory device of FIG. 3. The memory device 10b of FIG. 50 may correspond to the memory device 10a of FIG. 9. For ease of explanation below or to avoid redundancy, the memory device 10b will be described focusing on the differences from the memory device 10a of FIG. 9.

Referring to FIG. 50, a memory device 10b according to some embodiments may have a POC structure, in which a peripheral circuit area PS may be positioned above a memory cell area CS in the third direction D3.

Compared to the memory device 10a of FIG. 9, the lower bonding metals 381a, 382a, 381b, 382b and the upper bonding metals 282a, 281b, 282b are not arranged in the memory device 10b.

Additionally, a first substrate SUB1 may be placed between the second metal layer 370a, 370b of the peripheral circuit area PS and the second metal layer 270b of the memory cell area CS in the memory device 10b. Accordingly, a plurality of circuit elements 350a, 350b of the peripheral circuit area PS may be arranged above the second metal layer 270b of the memory cell area CS with respect to the third direction D3. A plurality of circuit elements 350a, 350b of the peripheral circuit area PS and a lower insulating film 303 covering the first interlayer insulating layer 302 may be placed on the upper portion of the first substrate SUB1.

According to an embodiment, the first substrate SUB1 may include an opening OP in the outer pad bonding area PA. In some embodiments, the first interlayer insulating layer 302 and the second interlayer insulating layer 202 may be in contact through an opening OP. The second external contact plug 305 extends along the third direction D3 through the opening OP and penetrates the second interlayer insulating layer 202 and a portion of the first interlayer insulating layer 302 to be electrically connected to the second metal layer 370a of the external pad bonding area PA. According to an embodiment, the second external contact plug 305 may be electrically connected to circuit elements 350a within the external pad bonding area PA.

According to an embodiment, a through via 371b extending along the third direction D3 in the memory cell bonding area MCBA and penetrating through a portion of the first and second interlayer insulating layers 202, 302 and the first substrate SUB1 may be disposed. A side insulating film 372b may be interposed between the first substrate SUB1 and the through via 371b.

In the memory cell bonding area MCBA, the through via 371b may extend in the third direction D3 to contact and electrically connect the second metal layer 270b of the memory cell area CS and the second metal layer 370b of the peripheral circuit area PS. Through the through via 371b, the circuit elements 350b included in the local sense amplifier circuit region LSAB and the plurality of bit line contacts 261b may be electrically connected.

The through via 371b may contain a conductive material. For example, the conductive material may be any one of a doped semiconductor material(doped silicon, doped germanium, etc.), a conductive metal nitride(titanium nitride, tantalum nitride, etc.), a metal(tungsten, titanium, tantalum, etc.), and a metal-semiconductor compound (tungsten silicide, cobalt silicide, titanium silicide, etc.).

The side insulating film 372b may be selected from the group consisting of a silicon oxide film, a silicon nitride film, a silicon oxynitride film, a carbon-containing silicon oxide film, a carbon-containing silicon nitride film, and a carbon-containing silicon oxynitride film.

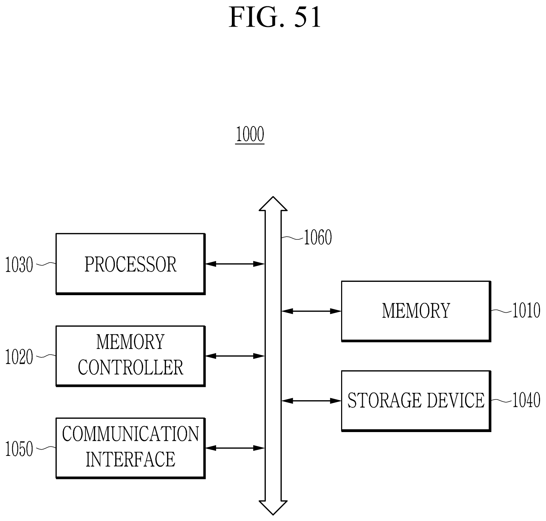

FIG. 51 is a block diagram illustrating a computer device according to some embodiments.

Referring to FIG. 51, a computing device 1000 includes a processor 1030, memory 1010, memory controller 1020, storage device 1040, communication interface 1050, and bus 1060. Although not illustrated, the computing device 1000 may further include other general-purpose components.

The processor 1030 controls the overall operation of each component of the computing device 1000. The processor 1030 may be implemented as at least one of various processing units such as a central processing unit(CPU), an application processor(AP), and a graphic processing unit(GPU).

Memory 1010 stores various data and commands. The memory 1010 may be implemented as a memory device described with reference to FIGS. 1 to 50. According to an embodiment, the memory 1010 may be a three-dimensional volatile memory device of a COP structure or a POC structure. The memory 1010 may be a memory device that pumps the voltage at the input node for the sense amplifier circuit in a charge pump manner to widen the sensing margin of data and improve the reliability of the sensing operation.

The memory controller 1020 may control the input/output of data or commands in the memory 1010. In an embodiment, the memory controller 1020 may be provided as a separate chip from the processor 1030. In an embodiment, the memory controller 1020 may be provided as an internal component of the processor 1030.

The storage device 1040 non-volatilely stores programs and data. In some embodiments, the storage device 1040 may be implemented as non-volatile memory. The communication interface 1050 supports wired and wireless Internet communication of the computing device 1000. Additionally, the communication interface 1050 may support various communication methods other than Internet communication. The bus 1060 provides communication capabilities between components of the computing device 1000. The bus 1060 may include at least one type of bus depending on the communication protocol between the components.

Embodiments are set out in the following clauses:
Clause 1. A memory device comprising: a first sub-memory array including a first memory cell connected to a first bit line and a first word line and configured to store data; and a bit line sense amplifier including a sense amplifier circuit electrically connected to the first bit line through a sensing node and configured to sense the data based on a voltage at the sensing node, and a first charge pump circuit configured to charge a first charge through charge sharing between the first bit line and the first memory cell and pump a voltage at the sensing node based on the first charge.
Clause 2. The memory device of Clause 1, wherein: the first charge pump circuit includes a first pump capacitor in which the first charge is charged through the charge sharing, wherein the first pump capacitor includes a first electrode electrically connected to the sensing node and a second electrode electrically connected to the first bit line through a first node different from the sensing node.
Clause 3. The memory device of Clause 2, wherein: the first charge pump circuit is configured to selectively connect one of the sensing node and the first node to the first bit line.
Clause 4. The memory device of Clause 2 or 3, wherein: the first charge pump circuit further includes a first switch transistor configured to connect the first bit line and the sensing node and a second switch transistor configured to connect the first bit line and the first node.
Clause 5. The memory device of Clause 4, wherein: in response to the charge sharing, the first switch transistor is configured to connect the first bit line and the sensing node, wherein, in response to the first bit line being connected to the first node, the first switch transistor is configured to be turned off and the voltage at the sensing node is pumped.
Clause 6. The memory device of Clause 4 or 5, wherein: the first switch transistor and the second switch transistor are disposed on a substrate, wherein the first pump capacitor includes at least a portion of a metal layer connected to the first switch transistor or at least a portion of a transistor disposed on the substrate.
Clause 7. The memory device of any one of Clauses 2 to 6, wherein: in response to the charge sharing, a precharge voltage of the first bit line is provided to the second electrode, and a polarity of the first electrode and the second electrode is determined based on the data.
Clause 8. The memory device of Clause 7, wherein: in response to the voltage at the sensing node being greater than the precharge voltage through the charge sharing, the first electrode is a positive electrode and the second electrode is a negative electrode.
Clause 9. The memory device of any one of Clauses 2 to 8, wherein: the first charge pump circuit further includes a second pump capacitor in which a second charge is charged through the charge sharing, in response to the second pump capacitor being connected between the first node and the first bit line, a voltage at the sensing node is pumped based on the first charge and the second charge.
Clause 10. The memory device of ant preceding Clause, wherein: the sense amplifier circuit is a single-ended sense amplifier circuit configured to perform a sensing operation based on the voltage of the sensing node.
Clause 11. The memory device of Clause 10, wherein: the bit line sense amplifier further includes a precharge circuit configured to provide a ground voltage to the first bit line before the charge sharing.
Clause 12. The memory device of Clause 11, wherein: the sense amplifier circuit is configured to receive a reference voltage from a complementary sensing node different from the sensing node and sense the data based on a comparison between the reference voltage and the voltage at the sensing node.
Clause 13. The memory device of Clause 10, 11 or 12, wherein: the bit line sense amplifier further includes a precharge circuit configured to provide a precharge voltage to the first bit line before the charge sharing, the precharge voltage is substantially equal to half of a power supply voltage in the sense amplifier circuit.
Clause 14. The memory device of any preceding Clause, further comprising: a second sub-memory array including a second memory cell connected to a second bit line and a second word line, wherein the sense amplifier circuit is electrically connected to the second bit line through a complementary sensing node, and configured to sense the data based on a voltage at the sensing node and a voltage at the complementary sensing node.
Clause 15. The memory device of Clause 14, wherein: the bit line sense amplifier further includes a second charge pump circuit configured to charge a second charge through charge sharing between the second bit line and the second memory cell and pump a voltage at the complementary sensing node based on the second charge.
Clause 16. A memory device comprising: a first sub-memory array including a first memory cell connected to a first bit line and a first word line and configured to store data; and a bit line sense amplifier including a sense amplifier circuit electrically connected to a sensing node through the first bit line and configured to sense the data based on a voltage at the sensing node, and a pump capacitor including a first electrode electrically connected to the sensing node and a second electrode electrically connected to the first bit line through a first node different from the sensing node.
Clause 17. The memory device of Clause 16, wherein: the bit line sense amplifier further comprises a first switch transistor configured to connect the first bit line and the sensing node, a second switch transistor configured to connect the first bit line and the first node, and a third switch transistor configured to provide a precharge voltage of the first bit line to the first node.
Clause 18. The memory device of Clause 17, wherein: in response to charge sharing between the first bit line and the first memory cell, the first switch transistor is configured to connect the first bit line and the sensing node, the second switch transistor is configured to be turned off, and the third switch transistor is configured to provide the precharge voltage to the first node.
Clause 19. A method of operating a memory device comprising: activating a word line included in a sub-memory array to perform a charge sharing operation between a bit line of the sub-memory array and a memory cell; providing a charge sharing voltage to a sensing node of a sense amplifier circuit based on the above charge sharing operation; charging a charge based on the charge sharing operation; pumping the charge sharing voltage to a sensing voltage based on the charge; and sensing data of the memory cell based on the sensing voltage.
Clause 20. The method of operating a memory device of Clause 19, wherein: the charging of the charge includes connecting the bit line to a first electrode of a pump capacitor to which the charge is charged, wherein the pumping of the charge sharing voltage to the sensing voltage includes changing the connection of the bit line from the first electrode to a second electrode of the pump capacitor.
Clause 21. A memory device comprising: a memory cell region including first and second sub-memory arrays arranged sequentially in a first direction; and a local sense amplifier circuit region, which is disposed between the first sub-memory array and the second sub-memory array and at least a portion of which overlaps in a plane with the first and second sub-memory arrays, including a sense amplifier circuit connected to a first bit line of the first sub-memory array through a sensing node and a pump capacitor including a first electrode electrically connected to the sensing node and a second electrode electrically connected to the first bit line through a first node different from the sensing node.
Clause 22. The memory device of Clause 21, further comprising: the local sense amplifier circuit region further includes a first switch transistor configured to connect the first bit line and the sensing node and a second switch transistor configured to connect the first bit line and the first node, wherein the first switch transistor and the second switch transistor are disposed on a substrate, wherein the pump capacitor includes at least a portion of a metal layer connected to the first switch transistor or at least a portion of a transistor disposed on the substrate.
Clause 23. A memory device comprising: a first sub-memory array including a first memory cell connected to a first bit line and a first word line and configured to store data; a second sub-memory array including a second memory cell connected to a second bit line and a second word line; and a bit line sense amplifier including a sense amplifier circuit connected to the first bit line through a sensing node, connected to the second bit line through a complementary sensing node different from the sensing node, and configured to sense the data based on voltages at the sensing node and the complementary sensing node, and a first charge pump circuit configured to charge a first charge through a first charge sharing operation between the first bit line and the first memory cell and pump a voltage at the sensing node based on the first charge.
Clause 24. The memory device of Clause 23, wherein: the first charge pump circuit includes a first pump capacitor in which the first charge is charged through the first charge sharing operation, the first pump capacitor includes a first electrode electrically connected to the sensing node and a second electrode electrically connected to the first bit line through a first node different from the sensing node.
Clause 25. The memory device of Clause 24, wherein: the first charge pump circuit is configured to selectively connect one of the sensing node and the first node to the first bit line.
Clause 26. The memory device of Clause 24 or 25, wherein: the first charge pump circuit further includes a first switch transistor configured to connect the first bit line and the sensing node and a second switch transistor configured to connect the first bit line and the first node.
Clause 27. The memory device of Clause 26, wherein: in response to the first charge sharing operation, the first switch transistor is configured to connect the first bit line and the sensing node, in response to the first bit line being connected to the first node, the first switch transistor is configured to be turned off and the voltage at the sensing node is pumped.
Clause 28. The memory device of Clause 26 or 27, wherein: the first switch transistor and the second switch transistor are disposed on a substrate, the first pump capacitor comprises at least a portion of a metal layer connected to the first switch transistor or at least a portion of a transistor disposed on the substrate.
Clause 29. The memory device of any one of Clauses 24 to 28, wherein: in response to the first charge sharing operation, a precharge voltage of the first bit line is provided to the second electrode, and a polarity of the first electrode and the second electrode is determined based on the data.
Clause 30. The memory device of Clause 29, wherein: in response to the voltage at the sensing node being greater than the precharge voltage through the first charge sharing operation, the first electrode is a positive electrode and the second electrode is a negative electrode.
Clause 31. The memory device of any one of Clauses 24 to 30, wherein: the first charge pump circuit further includes a second pump capacitor in which a second charge is charged through the first charge sharing operation, in response to the second pump capacitor being connected between the first node and the first bit line, a voltage at the sensing node is pumped based on the first charge and the second charge.
Clause 32. The memory device of any one of Clauses 23 to 31, wherein: the voltage at the complementary sensing node is substantially maintained while the voltage at the sensing node is pumped.
Clause 33. The memory device of any one of Clauses 23 to 32, wherein: the bit line sense amplifier further includes a second charge pump circuit configured to charge a second charge through a second charge sharing operation between the second bit line and the second memory cell and pump a voltage at the complementary sensing node based on the second charge.
Clause 34. The memory device of Clause 33, wherein: the second charge pump circuit includes a second pump capacitor in which the second charge is charged through the second charge sharing operation, and a plurality of switch transistors configured to control an electrical connection between the second pump capacitor and the second bit line, a control operation of the plurality of switch transistors is maintained while the voltage at the sensing node is pumped.
Clause 35. A memory device comprising: a first sub-memory array including a first memory cell connected to a first bit line and a first word line and configured to store data; a second sub-memory array including a second memory cell connected to a second bit line and a second word line; and a bit line sense amplifier including a sense amplifier circuit connected to the first bit line through a sensing node, connected to the second bit line through a complementary sensing node different from the sensing node, and configured to sense the data based on voltages at the sensing node and the complementary sensing node, and a first pump capacitor including a first electrode electrically connected to the sensing node and a second electrode electrically connected to the first bit line through a first node different from the sensing node and the complementary sensing node.
Clause 36. The memory device of Clause 35, wherein: the bit line sense amplifier further comprises a first switch transistor configured to connect the first bit line and the sensing node, a second switch transistor configured to connect the first bit line and the first node, and a third switch transistor configured to provide a precharge voltage of the first bit line to the first node.
Clause 37. The memory device of Clause 36, wherein: in response to charge sharing between the first bit line and the first memory cell, the first switch transistor is configured to connect the first bit line and the sensing node, the third switch transistor is configured to provide the precharge voltage to the first node, and the second switch transistor is configured to be turned off.
Clause 38. The memory device of Clause 37, wherein: the first switch transistor and the third switch transistor are configured to be turned off, and the second switch transistor is configured to connect the first bit line and the first node, after the first pump capacitor is charged based on the charge sharing.
Clause 39. The memory device of any one of Clauses 35 to 38, wherein: the bit line sense amplifier further comprises a second pump capacitor including a third electrode electrically connected to the complementary sensing node and a fourth electrode electrically connected to the second bit line through a second node different from the sensing node and the complementary sensing node.
Clause 40. A method of operating a memory device comprising: providing a precharge voltage to a first bit line included in a first sub-memory array and a second bit line included in a second sub-memory array; activating a word line included in the first sub-memory array to perform a charge sharing operation between the first bit line and a memory cell connected to the word line; providing a charge sharing voltage to a sensing node of a sense amplifier circuit based on the charge sharing operation; charging a charge based on the charge sharing operation; pumping the charge sharing voltage to a sensing voltage based on the charge; and sensing data of the memory cell based on the sensing voltage and the precharge voltage.
Clause 41. The method of operating a memory device of Clause 40, wherein: the charging of the charge includes connecting the first bit line to a first electrode of a pump capacitor to which the charge is charged, the pumping of the charge sharing voltage to the sensing voltage includes changing the connection of the first bit line from the first electrode to a second electrode of the pump capacitor.
Clause 42. The method of operating a memory device of Clause 41, wherein: the charging of the charge includes providing the charge sharing voltage to the first electrode of the pump capacitor and providing the precharge voltage to the second electrode of the pump capacitor.

## Claims

1. A memory device comprising:
a first sub-memory array (SMA11) including a first memory cell (MC) connected to a first bit line (BL) and a first word line (WL) and configured to store data; and
a bit line sense amplifier (161) including a sense amplifier circuit (1613) electrically connected to the first bit line (BL) through a sensing node (SBLn) and configured to sense the data based on a voltage at the sensing node (SBLn), and a first charge pump circuit (1612) configured to charge a first charge through charge sharing between the first bit line (BL) and the first memory cell (MC) and pump a voltage at the sensing node (SBLn) based on the first charge.

2. The memory device of claim 1, wherein:
the first charge pump circuit (1612) includes a first pump capacitor (Cp) in which the first charge is charged through the charge sharing,
wherein the first pump capacitor (Cp) includes a first electrode electrically connected to the sensing node (SBLn) and a second electrode electrically connected to the first bit line (BL) through a first node (N1) different from the sensing node.

3. The memory device of claim 2, wherein:
the first charge pump circuit (1612) is configured to selectively connect one of the sensing node (SBLn) and the first node (N1) to the first bit line (BL).

4. The memory device of claim 2 or 3, wherein:
the first charge pump circuit (1612) further includes a first switch transistor (TRs1) configured to connect the first bit line (BL) and the sensing node (SBLn) and a second switch transistor (TRs2) configured to connect the first bit line (BL) and the first node (N1).

5. The memory device of claim 4, wherein:
when the charge sharing occurs, the first switch transistor (TRs1) is configured to connect the first bit line (BL) and the sensing node (SBLn),
wherein, when the first bit line (BL) is connected to the first node (N1), the first switch transistor (TRs1) is configured to be turned off and the voltage at the sensing node (SBLn) is pumped.

6. The memory device of claim 4 or 5, wherein:
the first switch transistor (TRs1) and the second switch transistor (TRs2) are disposed on a substrate (SUB1),
wherein the first pump capacitor (Cp) includes at least a portion of a metal layer connected to the first switch transistor (TRs1) or at least a portion of a transistor disposed on the substrate (SUB1).

7. The memory device of any one of claims 2 and 6, wherein:
in response to the charge sharing, a precharge voltage (Vpre) of the first bit line (BL) is provided to the second electrode, and a polarity of the first electrode and the second electrode is determined based on the data.

8. The memory device of claim 7, wherein:
in response to the voltage at the sensing node (SBLn) being greater than the precharge voltage (Vpre) through the charge sharing, the first electrode is a positive electrode and the second electrode is a negative electrode.

9. The memory device of any one of claims 2 to 8, wherein:
the first charge pump circuit (1612) further includes a second pump capacitor (Cp2) in which a second charge is charged through the charge sharing,
in response to the second pump capacitor (Cp2) being connected between the first node (N1) and the first bit line (BL), a voltage at the sensing node (SBLn) is pumped based on the first charge and the second charge.

10. The memory device of any preceding claim, wherein:
the sense amplifier circuit (1613) is a single-ended sense amplifier circuit configured to perform a sensing operation based on the voltage of the sensing node (SBLn).

11. The memory device of claim 10, wherein:
the bit line sense amplifier (161) further includes a precharge circuit (1611) configured to provide a ground voltage (Vgnd) to the first bit line (BL) before the charge sharing.

12. The memory device of claim 11, wherein:
the sense amplifier circuit (1613) is configured to receive a reference voltage (Vref) from a complementary sensing node (SBLBn) different from the sensing node (SBLn) and sense the data based on a comparison between the reference voltage (Vref) and the voltage at the sensing node (SBLn).

13. The memory device of claim 10, 11 or 12, wherein:
the bit line sense amplifier (161) further includes a precharge circuit (1611) configured to provide a precharge voltage (Vpre) to the first bit line (BL) before the charge sharing,
the precharge voltage (Vpre) is substantially equal to half of a power supply voltage (VINTA) in the sense amplifier circuit (1613).

14. The memory device of any preceding claim, further comprising:
a second sub-memory array (SMA21) including a second memory cell (MC2) connected to a second bit line (BL2) and a second word line (WL2),
wherein the sense amplifier circuit (1613) is electrically connected to the second bit line (BL2) through a complementary sensing node (SBLBn), and configured to sense the data based on a voltage at the sensing node (SBLn) and a voltage at the complementary sensing node (SBLBn).

15. The memory device of claim 14, wherein:
the bit line sense amplifier (161) further includes a second charge pump circuit (Cp2) configured to charge a second charge through charge sharing between the second bit line (BL2) and the second memory cell (MC2) and pump a voltage at the complementary sensing node (SBLBn) based on the second charge.
